# EUROPEAN PATENT APPLICATION

(11) **EP 4 756 718 A1**
(43) Date of publication of application: **10.06.2026**
(21) Application number: 24848663.1
(22) Date of filing: 31.05.2024
(51) Int. Cl.: G06T 7/70, H01L 21/304

(54) **SUBSTRATE PROCESSING DEVICE AND INFORMATION PROCESSING METHOD FOR SUBSTRATE PROCESSING DEVICE**

(30) Priority: 31.07.2023 JP 2023124548
(71) Applicant: SCREEN Holdings Co., Ltd., Kyoto-shi, Kyoto 602-8585 (JP)
(72) Inventor: SHIMIZU, Shinji, Kyoto-shi, Kyoto 602-8585 (JP)
(74) Representative: Kilian Kilian & Partner mbB
(86) International application number: PCT/JP2024/020077
(87) International publication number: WO 2025/028002

(57) **Abstract**

In order to efficiently recognize a posture of a component, reference shape information on a two-dimensional shape of a three-dimensional model in a virtual image that can be acquired by imaging the three-dimensional model of a component to be searched is acquired for each of a plurality of first virtual camera positions located along a plurality of virtual spherical surfaces surrounding the three-dimensional model of the component to be searched and corresponding to one or more initial setting ranges for the component to be searched defined by setting range information, based on three-dimensional design information regarding the component to be searched among one or more target components and the setting range information defining the one or more initial setting ranges related to a virtual camera position with respect to a target component set in advance. For each first virtual camera position, a numerical value indicating a matching degree between real shape information on the two-dimensional shape of an object in a real image obtained by capturing the component to be searched and the reference shape information is calculated. Among the plurality of first virtual camera positions, a virtual camera position having the highest matching degree between the real shape information and the reference shape information is detected.

## Description

### TECHNICAL FIELD

The present invention relates to a technique for recognizing a posture of a component in a substrate processing apparatus that processes a substrate. Substrates to be processed in the substrate processing apparatus include, for example, a semiconductor substrate, a substrate for a flat panel display (FPD) such as a liquid crystal display apparatus or an organic electroluminescence (EL) display apparatus, a glass substrate for a photomask, a substrate for an optical disk, a substrate for a magnetic disk, or a substrate for a solar cell.

### BACKGROUND ART

There is a substrate processing apparatus including a processing chamber, a substrate holding unit, a nozzle, a camera, an image processing unit, and a monitoring unit (see, for example, Patent Document 1).

In this substrate processing apparatus, the substrate holding unit, the nozzle, and the camera are arranged in the processing chamber. The substrate holding unit holds a substrate in a horizontal posture. The substrate holding unit rotates the substrate in a horizontal plane. The nozzle moves between a standby position deviated to a side of the substrate and a discharge position above the substrate by turning of a drive arm to which the nozzle is fixed. The nozzle is arranged at the standby position when the substrate is attached to and detached from the substrate holding unit, and is arranged at the discharge position when a processing liquid is discharged from the nozzle toward the substrate. The camera is attached to a predetermined position in the processing chamber and captures an image of a predetermined region including the nozzle moved to the discharge position. The image processing unit acquires second nozzle position information indicating a position of the nozzle based on the image from the camera and outputs the second nozzle position information to the monitoring unit. The monitoring unit determines whether or not there is an abnormality in the position of the nozzle based on correspondence between first nozzle position information as information directly or indirectly indicating the arrangement position of the nozzle from a control unit and the second nozzle position information from the image processing unit.

### PRIOR ART DOCUMENT

### PATENT DOCUMENT

Patent Document 1: WO 2019/146456 A

### SUMMARY

### PROBLEM TO BE SOLVED BY THE INVENTION

By the way, with respect to a substrate processing apparatus, there is room for improvement in terms of efficiently recognizing a posture of a component.

### MEANS TO SOLVE THE PROBLEM

A substrate processing apparatus according to a first aspect is a substrate processing apparatus that processes a substrate, the substrate processing apparatus including: one or more target components; one or more imaging units that obtain, by imaging, a real image capturing a component to be searched that is one of the one or more target components; a search processing unit that executes search processing of searching for a virtual camera position with a maximum matching degree having a highest matching degree between reference shape information and real shape information among a plurality of virtual camera positions, based on the reference shape information regarding a two-dimensional shape of a three-dimensional model in each of a plurality of virtual images that can be acquired by imaging the three-dimensional model of the component to be searched from the plurality of virtual camera positions, and the real shape information regarding a two-dimensional shape of an object in the real image, the reference shape information being generated based on three-dimensional design information regarding the component to be searched; and a storage unit that stores setting range information defining one or more initial setting ranges related to a virtual camera position set in advance for each of at least one target component among the one or more target components, in which the search processing unit includes: a first shape information acquisition unit that acquires the reference shape information generated, based on the three-dimensional design information and the setting range information, for each of a plurality of first virtual camera positions assuming a case where the three-dimensional model is imaged from each of the plurality of first virtual camera positions located along a plurality of virtual spherical surfaces surrounding the three-dimensional model centered around a reference point of the three-dimensional model and corresponding to at least one initial setting range of the one or more initial setting ranges for the component to be searched defined by the setting range information; a first calculation unit that calculates, for each of the plurality of first virtual camera positions, a numerical value indicating a matching degree between the real shape information and the reference shape information; and a first detection unit that detects a virtual camera position with high matching degree having a highest matching degree between the real shape information and the reference shape information among the plurality of first virtual camera positions based on a calculation result by the first calculation unit, and the search processing unit searches for the virtual camera position with the maximum matching degree based on the virtual camera position with high matching degree detected by the first detection unit, or the virtual camera position with high matching degree is the virtual camera position with the maximum matching degree.

A substrate processing apparatus according to a second aspect is the substrate processing apparatus according to the first aspect, in which each of the one or more initial setting ranges includes a first numerical range that is a range of a distance from the reference point, a second numerical range that is a range of a latitude of a virtual spherical surface surrounding the three-dimensional model centered around the reference point, and a third numerical range that is a range of a longitude of the virtual spherical surface.

A substrate processing apparatus according to a third aspect is the substrate processing apparatus according to the second aspect, in which the first shape information acquisition unit, assuming a case where the three-dimensional model is imaged from each of M1×T1 first virtual camera positions that are the plurality of first virtual camera positions set by virtually setting T1 (T1 is a natural number equal to or greater than 2) surface aggregations each including a plurality of virtual surfaces located along a virtual spherical surface surrounding the three-dimensional model centered around the reference point and having mutually different distances from the reference point according to the first numerical range in the at least one initial setting range and virtually setting one virtual camera position for each of M1 (M1 is a natural number equal to or greater than 2) virtual surfaces in each of the T1 surface aggregations corresponding to both of the second numerical range and the third numerical range in the at least one initial setting range, acquires the reference shape information generated for each of the M1×T1 first virtual camera positions based on the three-dimensional design information and the setting range information, the first calculation unit calculates a numerical value indicating a matching degree between the real shape information and the reference shape information for each of the M1×T1 first virtual camera positions, the first detection unit detects the virtual camera position with high matching degree that is a first virtual camera position having the highest matching degree between the real shape information and the reference shape information among the M1×T1 first virtual camera positions based on a calculation result by the first calculation unit, the search processing unit includes: a divided surface generation unit that divides, according to a same rule, each of T2 (T2 is a natural number equal to or greater than 2) virtual surfaces including a virtual surface with high matching degree which is a virtual surface in which the virtual camera position with high matching degree is virtually set and intersecting a line passing through the reference point and the virtual camera position with high matching degree on a side of the virtual camera position with high matching degree with respect to the reference point and having mutually different distances from the reference point among the M1 virtual surfaces in each of the T1 surface aggregations to generate M2 (M2 is a natural number equal to or greater than 2) virtual divided surfaces for each of the T2 virtual surfaces, thereby generating M2×T2 virtual divided surfaces; a second shape information generation unit that generates the reference shape information for each of M2×T2 second virtual camera positions assuming a case where the three-dimensional model is imaged from each of the M2×T2 second virtual camera positions that are M2×T2 virtual camera positions set by virtually setting one virtual camera position for each of the M2×T2 virtual divided surfaces based on the three-dimensional design information; a second calculation unit that calculates a numerical value indicating a matching degree between the real shape information and the reference shape information for each of the M2×T2 second virtual camera positions; and a second detection unit that detects a virtual camera position having a highest matching degree between the real shape information and the reference shape information among the virtual camera position with high matching degree and the M2×T2 second virtual camera positions, and the search processing unit searches for the virtual camera position with the maximum matching degree based on the virtual camera position detected by the second detection unit, or the virtual camera position detected by the second detection unit is the virtual camera position with the maximum matching degree.

A substrate processing apparatus according to a fourth aspect is the substrate processing apparatus according to the third aspect, in which the search processing unit executes one or more times of n-th unit processing (n is a natural number equal to or greater than 2) after executing first unit processing for the component to be searched, the search processing unit sequentially performs first A processing, first B processing, first C processing, and first D processing in the first unit processing, the first A processing is processing in which the divided surface generation unit dividing, according to a same rule, each of first T3 virtual divided surfaces which are a plurality of virtual divided surfaces generated by dividing each of the T2 virtual surfaces, and which are T3 (T3 is a natural number equal to or greater than 2) virtual divided surfaces including a virtual divided surface including a first reference virtual camera position which is a virtual camera position detected first by the second detection unit, intersecting a line passing through the reference point and the first reference virtual camera position on a side of the first reference virtual camera position with respect to the reference point, and having mutually different distances from the reference point to generate first M3 virtual divided surfaces which are M3 (M3 is a natural number equal to or greater than 2) virtual divided surfaces for each of the first T3 virtual divided surfaces, thereby generating first M3×T3 virtual divided surfaces which are M3×T3 virtual divided surfaces, the first B processing is processing in which the second shape information generation unit generates the reference shape information for each of first M3×T3 third virtual camera positions assuming a case where the three-dimensional model is imaged from each of the first M3×T3 third virtual camera positions that are M3×T3 virtual camera positions set by virtually setting one virtual camera position for each of the first M3×T3 virtual divided surfaces based on the three-dimensional design information, the first C processing is processing in which the second calculation unit calculates a numerical value indicating a matching degree between the real shape information and the reference shape information for each of the first M3×T3 third virtual camera positions, the first D processing is processing in which the second detection unit detects a second reference virtual camera position that is a virtual camera position having a highest matching degree between the real shape information and the reference shape information among the first reference virtual camera position and the first M3×T3 third virtual camera positions, the search processing unit sequentially performs n-th A processing, n-th B processing, n-th C processing, and n-th D processing in each of the one or mor times of the n-th unit processing, the n-th A processing is processing in which the divided surface generation unit divides, according to a same rule, each of n-th T3 virtual divided surfaces which are a plurality of virtual divided surfaces generated by dividing each of (n-l)-th T3 virtual divided surfaces and which are T3 virtual divided surfaces including a virtual divided surface including an n-th reference virtual camera position which is a virtual camera position detected n-th by the second detection unit, intersecting a line passing through the reference point and the n-th reference virtual camera position on a side of the n-th reference virtual camera position with respect to the reference point, and having mutually different distances from the reference point to generate n-th M3 virtual divided surfaces which are M3 virtual divided surfaces for each of the n-th T3 virtual divided surfaces, thereby generating n-th M3×T3 virtual divided surfaces which are M3×T3 virtual divided surfaces, the n-th B processing is processing in which the second shape information generation unit generates the reference shape information for each of n-th M3×T3 third virtual camera positions assuming a case where the three-dimensional model is imaged from each of the n-th M3×T3 third virtual camera positions which are M3×T3 virtual camera positions set by virtually setting one virtual camera position for each of the n-th M3×T3 virtual divided surfaces based on the three-dimensional design information, the n-th C processing is processing in which the second calculation unit calculates a numerical value indicating a matching degree between the real shape information and the reference shape information for each of the n-th M3×T3 third virtual camera positions, the n-th D processing is processing in which the second detection unit detects a virtual camera position having the highest matching degree between the real shape information and the reference shape information among the n-th reference virtual camera position and the n-th M3×T3 third virtual camera positions, and a virtual camera position detected by the second detection unit in the last n-th D processing in the one or more times of the n-th unit processing is the virtual camera position with the maximum matching degree.

A substrate processing apparatus according to a fifth aspect is the substrate processing apparatus according to the fourth aspect, in which the search processing unit ends execution of the one or more times of the n-th unit processing in response to the second detection unit continuously detecting one reference virtual camera position among the first reference virtual camera position to the n-th reference virtual camera position a first predetermined number of times set in advance.

A substrate processing apparatus according to a sixth aspect is the substrate processing apparatus according to the fourth aspect, in which the search processing unit ends execution of the one or more times of the n-th unit processing in response to the n-th unit processing in the one or more times of the n-th unit processing being executed a second predetermined number of times set in advance.

A substrate processing apparatus according to a seventh aspect is the substrate processing apparatus according to any one of the third to sixth aspects, in which the same rule includes a rule of dividing a division target surface into a plurality of surfaces by a plurality of line segments respectively connecting a center point of the division target surface to be divided and all vertices of the division target surface.

A substrate processing apparatus according to an eighth aspect is the substrate processing apparatus according to any one of the third to seventh aspects, in which each of the plurality of virtual surfaces is a triangular surface, and each of the T1 surface aggregations is a polyhedron constituted with a plurality of triangular surfaces.

A substrate processing apparatus according to a ninth aspect is the substrate processing apparatus according to the eighth aspect, in which the divided surface generation unit divides the virtual surface with high matching degree into three virtual divided surfaces as the M2 virtual divided surfaces by three line segments connecting each of three vertices in the virtual surface with high matching degree and the virtual camera position with high matching degree.

A substrate processing apparatus according to a tenth aspect is the substrate processing apparatus according to any one of the first to ninth aspects, the substrate processing apparatus including a moving mechanism that moves the component to be searched between a first position and a second position, in which the one or more initial setting ranges include a first initial setting range for the first position, and the search processing unit, at a timing when the component to be searched is located at the first position by the moving mechanism, acquires, by the first shape information acquisition unit, the reference shape information generated for each of the plurality of first virtual camera positions corresponding to the first initial setting range assuming a case where the three-dimensional model is imaged from each of the plurality of first virtual camera positions corresponding to the first initial setting range that is the at least one initial setting range based on the three-dimensional design information and the setting range information, calculates, by the first calculation unit, for each of the plurality of first virtual camera positions corresponding to the first initial setting range, a numerical value indicating a matching degree between the reference shape information and the real shape information related to the real image obtained by imaging by the one or more imaging units at a timing when the component to be searched is located at the first position by the moving mechanism, and detects, by the first detection unit, the virtual camera position with high matching degree having the highest matching degree between the real shape information and the reference shape information among the plurality of first virtual camera positions corresponding to the first initial setting range based on a calculation result by the first calculation unit.

A substrate processing apparatus according to an eleventh aspect is the substrate processing apparatus according to the tenth aspect, in which the one or more initial setting ranges further include a second initial setting range for the second position, and the search processing unit, at a timing when the component to be searched is located at the second position by the moving mechanism, acquires, by the first shape information acquisition unit, the reference shape information generated for each of the plurality of first virtual camera positions corresponding to the second initial setting range assuming a case where the three-dimensional model is imaged from each of the plurality of first virtual camera positions corresponding to the second initial setting range that is the at least one initial setting range based on the three-dimensional design information and the setting range information, calculates, by the first calculation unit, for each of the plurality of first virtual camera positions corresponding to the second initial setting range, a numerical value indicating a matching degree between the reference shape information and the real shape information related to the real image obtained by imaging by the one or more imaging units at a timing when the component to be searched is located at the second position by the moving mechanism, and detects, by the first detection unit, the virtual camera position with high matching degree having the highest matching degree between the real shape information and the reference shape information among the plurality of first virtual camera positions corresponding to the second initial setting range based on a calculation result by the first calculation unit.

A substrate processing apparatus according to a twelfth aspect is the substrate processing apparatus according to the tenth or eleventh aspect, further including an abnormality detection unit that detects an abnormality of the component to be searched if a matching degree between the reference shape information and the real shape information for the virtual camera position with the maximum matching degree detected by the search processing unit is lower than a predetermined matching degree set in advance.

A substrate processing apparatus according to a thirteenth aspect is the substrate processing apparatus according to the tenth aspect, in which the one or more initial setting ranges further include a second initial setting range for the second position, the search processing unit, at a timing when the component to be searched is located at the first position by the moving mechanism, acquires, by the first shape information acquisition unit, the reference shape information generated for each of the plurality of first virtual camera positions corresponding to both the first initial setting range and the second initial setting range assuming a case where the three-dimensional model is imaged from each of the plurality of first virtual camera positions corresponding to both the first initial setting range and the second initial setting range that are the at least one initial setting range based on the three-dimensional design information and the setting range information, calculates, by the first calculation unit, for each of the plurality of first virtual camera positions corresponding to both the first initial setting range and the second initial setting range, a numerical value indicating a matching degree between the reference shape information and the real shape information related to the real image obtained by imaging by the one or more imaging units at a timing when the component to be searched is located at the first position by the moving mechanism, and detects, by the first detection unit, the virtual camera position with high matching degree having the highest matching degree between the real shape information and the reference shape information among the plurality of first virtual camera positions corresponding to both the first initial setting range and the second initial setting range based on a calculation result by the first calculation unit, and the substrate processing apparatus further includes an abnormality detection unit that detects an abnormality of the component to be searched if the virtual camera position with the maximum matching degree is a position belonging to the second initial setting range at a timing when the component to be searched is located at the first position by the moving mechanism.

A substrate processing apparatus according to a fourteenth aspect is the substrate processing apparatus according to any one of the first to eleventh aspects, further including an abnormality detection unit that detects an abnormality of the component to be searched by comparing reality information related to a posture of the component to be searched recognized based on the virtual camera position with the maximum matching degree and normal information related to a posture of the component to be searched based on the three-dimensional design information in a case where a state of the component to be searched is normal.

A substrate processing apparatus according to a fifteenth aspect is the substrate processing apparatus according to any one of the first to fourteenth aspects, in which the one or more target components include two or more target components, and the at least one target component includes the two or more target components.

An information processing method in a substrate processing apparatus according to a sixteenth aspect is an information processing method in a substrate processing apparatus including one or more target components, the information processing method including: a storage step of storing setting range information defining one or more initial setting ranges related to a virtual camera position set in advance for each of at least one target component among the one or more target components in a storage unit; an imaging step of obtaining a real image capturing a component to be searched that is any one target component among the one or more target components by imaging by an imaging unit; and a search step of executing search processing of, based on reference shape information regarding a two-dimensional shape of a three-dimensional model in each of a plurality of virtual images that can be acquired by imaging the three-dimensional model of the component to be searched from a plurality of virtual camera positions, and real shape information regarding a two-dimensional shape of an object in the real image obtained in the imaging step, the reference shape information being generated based on three-dimensional design information regarding the component to be searched, searching for a virtual camera position with a maximum matching degree having a highest matching degree between the reference shape information and the real shape information among the plurality of virtual camera positions by an arithmetic unit, in which the search step includes: a first shape information acquisition step of acquiring the reference shape information generated for each of a plurality of first virtual camera positions assuming a case where the three-dimensional model is imaged from each of the plurality of first virtual camera positions located along a plurality of virtual spherical surfaces surrounding the three-dimensional model centered around a reference point of the three-dimensional model and corresponding to at least one initial setting range among the one or more initial setting ranges for the component to be searched defined by the setting range information based on the three-dimensional design information and the setting range information; a first calculation step of calculating a numerical value indicating a matching degree between the real shape information and the reference shape information acquired for each of the plurality of first virtual camera positions in the first shape information acquisition step; and a first detection step of detecting a virtual camera position with high matching degree having a highest matching degree between the real shape information and the reference shape information among the plurality of first virtual camera positions based on a calculation result in the first calculation step, and in the search step, the virtual camera position with the maximum matching degree is searched for based on the virtual camera position with high matching degree detected in the first detection step, or the virtual camera position with high matching degree is the virtual camera position with the maximum matching degree.

### EFFECTS OF THE INVENTION

According to the substrate processing apparatus according to the first aspect, in a case where a range of the position and the posture of the component to be searched is limited, the range in which the plurality of first virtual camera positions is set is limited, so that an amount of calculation in the search processing can be reduced. As a result, the amount of calculation for recognizing the posture of the component to be searched captured in the real image can be reduced. Thus, in the substrate processing apparatus, the posture of the component can be efficiently recognized.

According to the substrate processing apparatus according to the second aspect, in a case where a range in which each of an angular relationship and a distance between the imaging unit and the component to be searched changes is limited, the range in which the plurality of first virtual camera positions is set can be limited. As a result, the amount of calculation in the search processing can be reduced. As a result, the amount of calculation for recognizing the posture of the component to be searched captured in the real image can be reduced. Thus, in the substrate processing apparatus, the posture of the component can be efficiently recognized.

According to the substrate processing apparatus according to the third aspect, the second virtual camera position is set to each of the plurality of virtual divided surfaces generated by dividing each of the plurality of virtual surfaces including the virtual surface with high matching degree in which the virtual camera position with high matching degree detected by the first detection unit is set, and a numerical value indicating the matching degree between the real shape information and the reference shape information is calculated for each second virtual camera position. Thus, the plurality of virtual surfaces including the virtual surface with high matching degree and the plurality of virtual divided surfaces are not irrelevant, and increase in at least one of the number or the area can be reduced for the plurality of virtual divided surfaces. As a result, the amount of calculation for recognizing the posture of the component to be searched captured in the real image can be reduced. As a result, in the substrate processing apparatus, the posture of the component can be efficiently recognized.

According to the substrate processing apparatus according to the fourth aspect, when the unit processing is repeatedly executed, a plurality of virtual divided surfaces including a virtual camera position having the highest matching degree between the real shape information and the reference shape information and having mutually different distances from the three-dimensional model of the component to be searched are divided according to the same rule to generate a plurality of virtual divided surfaces in which a next virtual camera position is to be set. As a result, the virtual divided surfaces before the division and the virtual divided surfaces after the division are not irrelevant, and increase in at least one of the number or the area can be reduced for the virtual divided surfaces after the division. As a result, the amount of calculation for recognizing the posture of the component to be searched captured in the real image can be reduced. Thus, in the substrate processing apparatus, the posture of the component can be efficiently recognized.

According to the substrate processing apparatus according to the fifth aspect, the amount of calculation for recognizing the posture of the component to be searched captured in the real image can be reduced. Thus, in the substrate processing apparatus, the posture of the component can be efficiently recognized.

According to the substrate processing apparatus according to the sixth aspect, the amount of calculation for recognizing the posture of the component to be searched captured in the real image can be reduced. Thus, in the substrate processing apparatus, the posture of the component can be efficiently recognized.

According to the substrate processing apparatus according to the seventh aspect, the surface can be easily divided.

According to the substrate processing apparatus according to the eighth aspect, it is possible to easily set the surface aggregations including a plurality of virtual surfaces.

According to the substrate processing apparatus according to the ninth aspect, the virtual surface can be easily divided.

According to the substrate processing apparatus according to the tenth aspect, in a case where the component to be searched moves between the first position and the second position, the range in which the plurality of first virtual camera positions is set can be limited for the first position in which the range in which the posture of the component to be searched changes is more limited. As a result, the amount of calculation for recognizing the posture of the component to be searched captured in the real image can be reduced. As a result, in the substrate processing apparatus, the posture of the component can be efficiently recognized.

According to the substrate processing apparatus according to the eleventh aspect, in a case where the component to be searched moves between the first position and the second position, the range in which the plurality of first virtual camera positions is set can be limited for the second position in which the range in which the posture of the component to be searched changes is more limited. As a result, the amount of calculation for recognizing the posture of the component to be searched captured in the real image can be reduced. As a result, in the substrate processing apparatus, the posture of the component can be efficiently recognized.

According to the substrate processing apparatus according to the twelfth aspect, the amount of calculation of the search processing is reduced, and thus, the abnormality of the component to be searched can be easily detected.

According to the substrate processing apparatus according to the thirteenth aspect, in a case where the component to be searched moves between the first position and the second position, the abnormality of the component to be searched in which the component to be searched is located at the second position can be easily detected at the timing when the component to be searched is located at the first position.

According to the substrate processing apparatus according to the fourteenth aspect, the amount of calculation of the search processing is reduced, and thus, the reality information related to the posture of the component to be searched captured in the real image can be efficiently recognized, and the abnormality of the component to be searched can be efficiently detected.

According to the substrate processing apparatus according to the fifteenth aspect, the information defining the one or more initial setting ranges related to the virtual camera position is stored for each target component, and thus, the range in which the plurality of first virtual camera positions is set is limited for each component to be searched. As a result, the amount of calculation in the search processing can be reduced. As a result, the amount of calculation for recognizing the posture of the component to be searched captured in the real image can be reduced. Thus, in the substrate processing apparatus, the posture of the component can be efficiently recognized.

According to the information processing method in the substrate processing apparatus according to the sixteenth aspect, in a case where the range of the position and the posture of the component to be searched is limited, the range in which the plurality of first virtual camera positions is set is limited, so that the amount of calculation in the search processing can be reduced. As a result, the amount of calculation for recognizing the posture of the component to be searched captured in the real image can be reduced. Thus, in the substrate processing apparatus, the posture of the component can be efficiently recognized.

### BRIEF DESCRIPTION OF DRAWINGS

[FIG. 1] FIG. 1 is a side view schematically illustrating an example of a schematic configuration of a substrate processing apparatus according to a first embodiment.
[FIG. 2] FIG. 2 is a plan view schematically illustrating an example of a schematic configuration of the substrate processing apparatus according to the first embodiment.
[FIG. 3] FIG. 3 is a block diagram illustrating an example of a functional configuration of the substrate processing apparatus according to the first embodiment.
[FIG. 4] FIG. 4 is a view schematically illustrating a specific example of setting range information.
[FIG. 5] FIG. 5 is a block diagram illustrating a specific example of a functional configuration related to search processing in a control unit.
[FIG. 6] FIG. 6 is a view illustrating a specific example of a real image obtained by imaging by a camera.
[FIG. 7] FIG. 7 is a view illustrating a specific example of a processing target region in the real image.
[FIG. 8] FIG. 8 is a view illustrating a specific example of a processing target real image.
[FIG. 9] FIG. 9 is a view illustrating a specific example of an edge image.
[FIG. 10] FIG. 10 is a view for describing basic concept of the search processing.
[FIG. 11] FIG. 11 is a view for describing basic concept of the search processing.
[FIG. 12] FIG. 12 is a view for describing basic concept of the search processing.
[FIG. 13] FIG. 13 is a view for describing basic concept of the search processing.
[FIG. 14] FIG. 14 is a view for describing basic concept of the search processing.
[FIG. 15] FIG. 15 is a view for describing basic concept of the search processing.
[FIG. 16] FIG. 16 is a view for describing basic concept of the search processing.
[FIG. 17] FIG. 17 is a view for describing basic concept of the search processing.
[FIG. 18] FIG. 18 is a view for describing an example of a mode in which T1 surface aggregations having mutually different distances from a reference point of a 3D model of a component to be searched are virtually set.
[FIG. 19] FIG. 19 is a view illustrating an example of a setting aspect of one surface aggregation.
[FIG. 20] FIG. 20 is a view illustrating an example of a setting aspect of a first virtual camera position in one virtual surface.
[FIG. 21] FIG. 21 is a view for describing a specific example of calculation processing of a numerical value indicating a matching degree between real shape information and reference shape information for one virtual camera position.
[FIG. 22] FIG. 22 is a view for describing a specific example of the calculation processing of the numerical value indicating the matching degree between the real shape information and the reference shape information for one virtual camera position.
[FIG. 23] FIG. 23 is a view for describing a specific example of the calculation processing of the numerical value indicating the matching degree between the real shape information and the reference shape information for one virtual camera position.
[FIG. 24] FIG. 24 is a view for describing a specific example of the calculation processing of the numerical value indicating the matching degree between the real shape information and the reference shape information for one virtual camera position.
[FIG. 25] FIG. 25 is a view for describing a specific example of the calculation processing of the numerical value indicating the matching degree between the real shape information and the reference shape information for one virtual camera position.
[FIG. 26] FIG. 26 is a view illustrating a specific example in which a collation target region is set in an edge image as the real shape information.
[FIG. 27] FIG. 27 is an image diagram schematically illustrating an example of T2 virtual surfaces.
[FIG. 28] FIG. 28 is a view schematically illustrating a specific example in which a virtual surface with high matching degree is divided into a plurality of virtual divided surfaces.
[FIG. 29] FIG. 29 is an image diagram schematically illustrating an example of first T3 virtual divided surfaces.
[FIG. 30] FIG. 30 is a view schematically illustrating a specific example in which a first reference virtual divided surface is divided into a plurality of virtual divided surfaces in a first first case.
[FIG. 31] FIG. 31 is a view schematically illustrating a specific example in which the first reference virtual divided surface is set in a first second case.
[FIG. 32] FIG. 32 is a view schematically illustrating a specific example in which the first reference virtual divided surface is divided into a plurality of virtual divided surfaces in the first second case.
[FIG. 33] FIG. 33 is an image diagram schematically illustrating an example of second T3 virtual divided surfaces as a specific example of n-th T3 virtual divided surfaces.
[FIG. 34] FIG. 34 is a view schematically illustrating a specific example in which a second reference virtual divided surface is divided into a plurality of virtual divided surfaces in a second first case.
[FIG. 35] FIG. 35 is a view schematically illustrating a specific example in which the second reference virtual divided surface is set in a second second case.
[FIG. 36] FIG. 36 is a view schematically illustrating a specific example in which the second reference virtual divided surface among second T3 virtual divided surfaces is divided into a plurality of virtual divided surfaces in the second second case.
[FIG. 37] FIG. 37 is a flowchart indicating a specific example of schematic flow of operation related to processing of one or more substrates in the substrate processing apparatus.
[FIG. 38] FIG. 38 is a flowchart indicating a specific example of schematic flow of operation related to processing of detecting an abnormality in the substrate processing apparatus.
[FIG. 39] FIG. 39 is a flowchart indicating a specific example of flow of image processing in step S14 in FIG. 38.
[FIG. 40] FIG. 40 is a flowchart indicating a specific example of flow of search processing in step S15 in FIG. 38.
[FIG. 41] FIG. 41 is a flowchart indicating a specific example of processing flow in primary search processing of step Sb1 in FIG. 40.
[FIG. 42] FIG. 42 is a flowchart indicating a specific example of processing flow in secondary search processing in step Sb2 in FIG. 40.
[FIG. 43] FIG. 43 is a flowchart indicating a specific example of processing flow in the secondary search processing in step Sb2 in FIG. 40.
[FIG. 44] FIG. 44 is a flowchart indicating a specific example of processing flow in the secondary search processing in step Sb2 in FIG. 40.
[FIG. 45] FIG. 45 is a view schematically illustrating an example of a state in which each chuck is located at an open position, a guard is located at a lowered position, and a nozzle is located at a standby position.
[FIG. 46] FIG. 46 is a view schematically illustrating an example of a state in which each chuck is located at a closed position.
[FIG. 47] FIG. 47 is a view schematically illustrating an example of a state in which the nozzle is located at a discharge position and the guard is located at a raised position.
[FIG. 48] FIG. 48 is a view schematically illustrating another specific example of the setting range information.
[FIG. 49] FIG. 49 is a view schematically illustrating still another specific example of the setting range information.
[FIG. 50] FIG. 50 is a view schematically illustrating yet another specific example of the setting range information.
[FIG. 51] FIG. 51 is a view schematically illustrating an example of a schematic configuration of a substrate processing system.

### DESCRIPTION OF EMBODIMENTS

There is a substrate processing apparatus including a processing chamber, a substrate holding unit, a nozzle, a camera, an image processing unit, and a monitoring unit.

In this substrate processing apparatus, the substrate holding unit, the nozzle, and the camera are arranged in the processing chamber. The substrate holding unit rotates a substrate in a horizontal plane while holding the substrate in a horizontal posture. The nozzle moves between a standby position deviated to a side of the substrate and a discharge position above the substrate by turning of a drive arm to which the nozzle is fixed. The nozzle is arranged at the standby position when the substrate is attached to and detached from the substrate holding unit, and is arranged at the discharge position when a processing liquid is discharged from the nozzle toward the substrate. The camera is arranged at a predetermined position in the processing chamber and captures an image of a predetermined region including the nozzle that has moved to the discharge position. The image processing unit acquires second nozzle position information indicating a position of the nozzle based on the image from the camera, and outputs the second nozzle position information to the monitoring unit. The monitoring unit determines whether or not there is an abnormality in the position of the nozzle based on correspondence between first nozzle position information as information directly or indirectly indicating the position of the nozzle from the control unit and the second nozzle position information from the image processing unit.

By the way, in the substrate processing apparatus, for example, there is a case where it is desired to recognize a posture of one or more components, which are captured by the camera, among various components such as the nozzle, a chuck that holds a peripheral edge of the substrate in the substrate holding unit, and a guard that moves up and down in a region surrounding a side of the substrate holding unit in order to detect an abnormality, an operation state of the component, and the like.

In this case, it is conceivable to cause the substrate processing apparatus to recognize the posture of the component by, for example, a method of sequentially performing the following [processing A] to [processing E].

### [Processing A]

A virtual polyhedron constituted with a plurality of virtual surfaces along a spherical surface centered around a three-dimensional design shape (also referred to as a three-dimensional component model) of a component represented by three-dimensional computer aided design (CAD) data of the component, or the like, is set. Each virtual surface is constituted with, for example, a triangular surface.

### [Processing B]

A camera (also referred to as a virtual camera) is virtually installed at a predetermined position (also referred to as a virtual camera position) on each virtual surface constituting the virtual polyhedron set in the processing A. As a result, a plurality of virtual cameras is virtually installed so as to surround the three-dimensional component model.

### [Processing C]

A plurality of images (also referred to as virtual images) acquired by virtual imaging of the three-dimensional component model by the plurality of virtual cameras installed at the plurality of virtual camera positions by the processing B is generated. The virtual image can be generated, for example, by projecting the three-dimensional component model on a virtual plane by processing such as rendering.

### [Processing D]

Matching (collation) processing using template matching, or the like, is performed between each of the plurality of virtual images generated in the processing C and an image (also referred to as a real image) obtained by actually imaging the component with a camera (also referred to as a real camera). As a result, the virtual camera position at which a degree of matching (also referred to as a matching degree) between the real image and the virtual image is the highest with respect to a shape, a direction, a size, and the like, of the captured component among the plurality of virtual camera positions is detected. The degree of matching (matching degree) is also referred to as a degree of similarity (similarity).

### [Processing E]

By recognizing the posture of the component with respect to the position of the real camera based on the detection result in the processing D, the posture of the component captured in the real image is recognized.

In the above method, for example, in a case where a distance between the real camera and the component changes, a plurality of virtual polyhedrons having mutually different distances from the center of the three-dimensional component model is set in the processing A.

Here, for example, a method is conceivable in which accuracy of recognizing the posture of the component captured in the real image is improved by making a plurality of virtual surfaces constituting the virtual polyhedron in the processing A into a very fine large number of virtual surfaces and increasing the number of virtual camera positions virtually installed in the processing B. However, according to this method, time required for calculation increases due to increase in the amount of calculation.

Thus, for example, a method in which the processing E is executed after the processing A to the processing D are sequentially repeatedly executed a predetermined number of times can be considered. In this method, in the first time of the processing A, a virtual polyhedron is constituted with a plurality of relatively large virtual surfaces, in the second and subsequent times of the processing A, a virtual polyhedron is constituted with a large number of virtual surfaces relatively finer than the previous processing A, and in the second and subsequent times of the processing B, a virtual camera is virtually installed at a predetermined virtual camera position on each of some of a plurality of virtual surfaces close to the virtual camera position detected in the most recent time of the processing D among the polyhedrons set in the previous processing A. With this method, time required for calculation can be shortened by reducing the amount of calculation while improving the accuracy of recognizing the posture of the component captured in the real image.

However, in this method, it is necessary to set a fine virtual polyhedron stepwise in a plurality of times of the processing A, and the virtual polyhedron set in the second and subsequent times of the processing A is irrelevant to the virtual polyhedron set in the previous processing A. Thus, in order to maintain the accuracy of recognizing the posture of the component captured in the real image, some of the plurality of virtual surfaces in which the virtual camera position is virtually set in the second and subsequent times of the processing B cover a somewhat wide area located near the virtual camera position detected in the most recent processing D. As a result, at least one of the number or the area of some of the plurality of virtual surfaces in which the virtual camera position is set in the second and subsequent times of the processing B increases to some extent, and the number of virtual camera positions set in the second and subsequent times of processing B may increase, so that it is not easy to sufficiently reduce the amount of calculation.

Thus, there is room for improvement in the substrate processing apparatus to efficiently recognize the posture of the component.

Hereinafter, embodiments will be described with reference to the accompanying drawings. Note that the drawings are schematically illustrated, and omission of components or simplification of a configuration is appropriately made for convenience of description. In addition, the mutual relationship between the sizes and positions of the components illustrated in the drawings is not necessarily accurately described, and can be appropriately changed.

Furthermore, in the following description, similar components are denoted by the same reference numerals, and the names and functions thereof are also similar. Thus, detailed description thereof may be omitted to avoid duplication.

In addition, in the following description, even if ordinal numbers such as "first" or "second" are used, these terms are used for convenience to facilitate understanding of the content of the embodiments, and are not limited to the order that can occur by these ordinal numbers.

In a case where expressions indicating a relative or absolute positional relationship (such as, for example, "in one direction", "along one direction", "parallel", "orthogonal", "center", "concentric", and "coaxial") are used, the expressions shall not only strictly represent the positional relationship, but also represent a state of being displaced relative to an angle or distance to the extent that a tolerance or comparable function is obtained, unless otherwise specified. In a case where expressions indicating equal states (such as, for example, "identical", "equal", and "homogeneous") are used, they shall not only represent quantitatively strictly equal states, but also represent states in which there are differences that result in tolerances or comparable functionality, unless otherwise specified. In a case where an expression indicating a shape (such as, for example, "quadrangular" or "cylindrical") is used, unless otherwise specified, the expression not only represents the shape geometrically and strictly, but also represents a shape having, for example, any one of unevenness, chamfering, and the like within a range in which a similar effect can be obtained. In a case where an expression "comprising", "comprising", "comprising", "including" or "having" one component is used, the expression is not an exclusive expression excluding the presence of other components. In a case where an expression "at least one of A, B or C" is used, it includes A only, B only, C only, any two of A, B and C, and all of A, B and C.

### <1. Overall Configuration of Substrate Processing Apparatus>

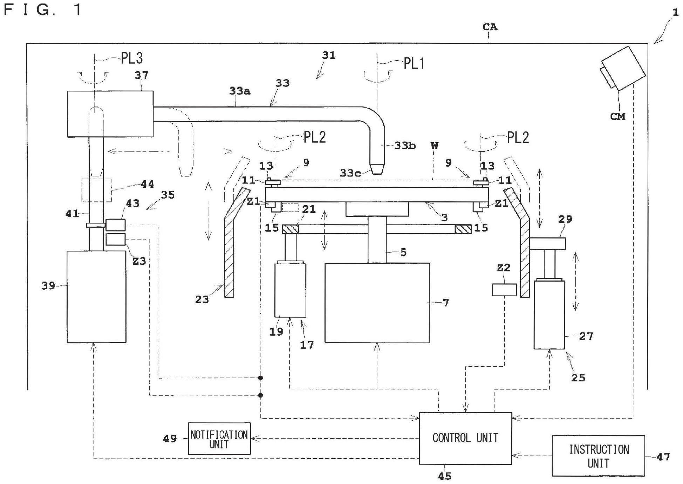

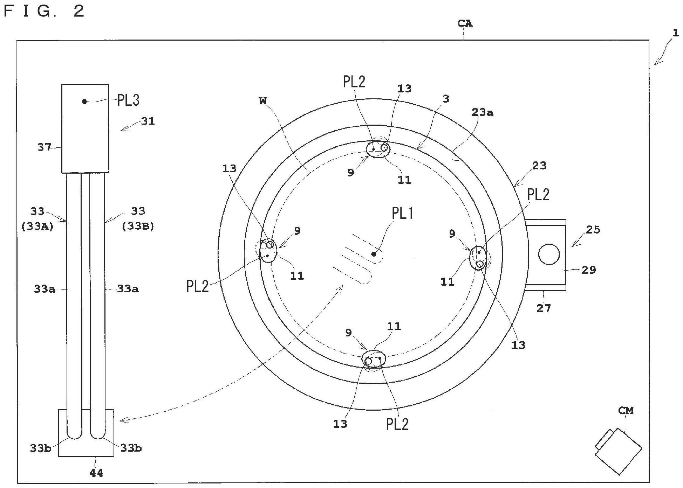

FIG. 1 is a side view schematically illustrating an example of a schematic configuration of a substrate processing apparatus 1 according to a first embodiment. FIG. 2 is a plan view schematically illustrating an example of the schematic configuration of the substrate processing apparatus 1 according to the first embodiment.

The substrate processing apparatus 1 is an apparatus that processes a substrate (for example, a semiconductor wafer) W. In the first embodiment, the substrate processing apparatus 1 is a single wafer type apparatus that processes the substrates W one by one. A substantially disk-shaped thin flat plate is adopted as the substrate W. In other words, the substrate W has a circular shape in plan view. The plan view means a plan view in which each part is viewed from an upper side to a lower side when no condition is particularly described. The substrate processing apparatus 1 supplies a processing liquid to the substrate W while rotating the substrate W to perform predetermined processing on the substrate W. As the substrate processing apparatus 1, for example, a substrate cleaning apparatus that cleans the substrate W using the processing liquid is adopted.

The substrate processing apparatus 1 includes a casing CA. The casing CA shields the inside of the casing CA from the atmosphere around the casing CA.

The substrate processing apparatus 1 includes a spin chuck 3. The spin chuck 3 has a circular structure having a diameter larger than that of the substrate W in plan view. An upper end of a rotating shaft 5 is connected to a lower surface of the spin chuck 3. A lower end of the rotating shaft 5 is connected to a motor 7. The spin chuck 3 rotates about a rotation center PL1 by being driven by the motor 7. The rotation center PL1 extends in a vertical direction.

The spin chuck 3 includes a plurality of chucks 9. In other words, the substrate processing apparatus 1 includes the plurality of chucks 9. More specifically, the spin chuck 3 includes the plurality of chucks 9 at a peripheral edge portion of an upper surface of a disk-shaped main body portion of the spin chuck 3. In the first embodiment, the spin chuck 3 includes four chucks 9. The number of chucks 9 included in the spin chuck 3 is not limited to four as long as the spin chuck 3 can stably rotate about the rotation center PL1 while supporting the substrate W in a horizontal posture.

The chuck 9 includes, for example, a lower surface support portion 11, a peripheral edge support portion 13, and a rotating magnet 15. The lower surface support portion 11 is a portion for supporting the substrate W by abutting on the lower surface of the substrate W from below. For example, if a contact area of the lower surface support portion 11 with the lower surface of the substrate W is configured to be small, a degree of mutual contamination between the substrate W and the chuck 9 can be reduced. The lower surface support portion 11 is rotatably attached to an upper surface side of the main body portion of the spin chuck 3 at the rotation center PL2. The rotation center PL2 extends in the vertical direction. The peripheral edge support portion 13 is erected on the upper surface of the lower surface support portion 11. For example, if a height of the peripheral edge support portion 13 from the upper surface of the lower surface support portion 11 is higher than a thickness of the substrate W, the peripheral edge support portion 13 can stably hold the peripheral edge of the substrate W. The peripheral edge support portion 13 is provided at a position away from the rotation center PL2 toward an outer edge of the lower surface support portion 11 in plan view. In other words, the peripheral edge support portion 13 is eccentric from the rotation center PL2. The rotating magnet 15 is attached at a position corresponding to the rotation center PL2 on the lower surface side of the spin chuck 3. The rotating magnet 15 is connected to the lower surface support portion 11. The rotating magnet 15 is provided so as to be rotatable about the rotation center PL2.

The substrate processing apparatus 1 includes a moving mechanism (also referred to as a chuck moving mechanism) 17 that moves the chuck 9 between an open position as a first position (also referred to as a first A position) and a closed position as a second position (also referred to as a second A position). In the first embodiment, the chuck moving mechanism 17 is arranged below the rotating magnet 15. The chuck moving mechanism 17 is arranged closer to the rotating shaft 5 than the chuck 9. The chuck moving mechanism 17 includes, for example, an air cylinder 19 and a driving magnet 21. The driving magnet 21 has an annular shape in plan view. The air cylinder 19 includes a piston rod (also referred to as a rod or an operation shaft) located along the vertical direction. The driving magnet 21 is attached to an upper end of the rod of the air cylinder 19. The chuck moving mechanism 17 is operated in response to a chuck operation command from the control unit 45. The chuck moving mechanism 17 can bring the driving magnet 21 close to the chuck 9 by raising the driving magnet 21 by the air cylinder 19, and can move the driving magnet 21 in a direction away from the chuck 9 by lowering the driving magnet 21 by the air cylinder 19. The chuck moving mechanism 17 can move the driving magnet 21 between a raised position (also referred to as an upper position) and a lowered position (also referred to as a lower position).

The chuck 9 includes a biasing mechanism (not illustrated). If the driving magnet 21 descends and moves from the upper position to the lower position, the chuck 9 moves from the open position to the closed position. If the driving magnet 21 ascends and moves upward from the lower position to the upper position, the chuck 9 moves from the closed position to the open position. If the chuck 9 moves from the open position to the closed position, the peripheral edge support portion 13 rotates about the rotation center PL2, and the peripheral edge support portion 13 moves in a direction approaching the rotation center PL1 and abuts on the peripheral edge of the substrate W supported by the lower surface support portion 11. As a result, the plurality of chucks 9 can clamp the substrate W at the closed position. When the chuck 9 moves from the closed position to the open position, the peripheral edge support portion 13 rotates about the rotation center PL2, and the peripheral edge support portion 13 moves in a direction away from the rotation center PL1. As a result, the plurality of chucks 9 is in a state of not holding the substrate W at the open position. In this state, the substrate W can be carried into the spin chuck 3 from the outside of the casing CA, and the substrate W can be carried out from the spin chuck 3 to the outside of the casing CA.

The substrate processing apparatus 1 includes a first sensor Z1 arranged near the rotating magnet 15 of the chuck 9. If the chuck 9 moves to the closed position or the open position, the first sensor Z1 changes a signal (also referred to as an output signal) to be output from the first sensor Z1. For example, the first sensor Z1 turns on the output signal if the chuck 9 moves to the closed position or the open position.

The substrate processing apparatus 1 includes a guard 23. The guard 23 is arranged around the spin chuck 3. In other words, the guard 23 surrounds the side of the spin chuck 3. The guard 23 is a portion for preventing scattering of the processing liquid from the substrate W supported and rotated by the spin chuck 3 to the surroundings. The guard 23 has a tubular form. The guard 23 includes an opening 23a formed in an upper portion. An inner diameter of the opening 23a is larger than an outer diameter of the spin chuck 3.

The substrate processing apparatus 1 includes a moving mechanism (also referred to as a card moving mechanism) 25 that moves the guard 23 between a lowered position as a first position (also referred to as a first B position) and a raised position as a second position (also referred to as a second B position). More specifically, the guard moving mechanism 25 can raise and lower the guard 23 between the lowered position and the raised position. The guard moving mechanism 25 includes, for example, an air cylinder 27 and a locking piece 29. The guard moving mechanism 25 is arranged, for example, on an outer peripheral side of the guard 23. The guard moving mechanism 25 may be arranged on an inner peripheral side of the guard 23 as long as the guard 23 can be raised and lowered. The air cylinder 27 includes a piston rod (also referred to as a rod or an operation shaft) located along the vertical direction. The locking piece 29 is attached to an upper end of the rod of the air cylinder 27. The locking piece 29 is fixed to an outer peripheral surface of the guard 23. The guard moving mechanism 25 is not limited to the above configuration as long as the guard 23 can be raised and lowered.

The guard moving mechanism 25 moves the guard 23 between the lowered position and the raised position in response to a guard operation command from the control unit 45. The lowered position of the guard 23 is the position of the guard 23 when the guard 23 is lowered by the guard moving mechanism 25. In other words, the lowered position is a position where an upper end of the guard 23 is low. The raised position of the guard 23 is the position of the guard 23 when the guard 23 is raised by the guard moving mechanism 25. In other words, the lowered position is a position lower than the raised position, and the raised position is a position higher than the lowered position. In a state where the guard 23 is located at the lowered position, a position of an upper edge of the guard 23 is lower than the position of the substrate W supported by the spin chuck 3. In a state where the guard 23 is located at the raised position, the position of the upper edge of the guard 23 is higher than the position of the substrate W supported by the spin chuck 3. Thus, in a state where the guard 23 is located at the raised position, the guard 23 can receive the processing liquid scattered from the substrate W supported and rotated by the spin chuck 3 to the surroundings by an inner peripheral surface of the guard 23. The substrate processing apparatus 1 includes, for example, a second sensor Z2 arranged on the inner peripheral side of the guard 23. If the guard 23 moves to the lowered position, the second sensor Z2 changes a signal (output signal) to be output from the second sensor Z2. For example, the second sensor Z2 turns on the output signal if the guard 23 moves to the lowered position.

The substrate processing apparatus 1 includes a waste liquid port (not illustrated) located on the inner peripheral side of the guard 23. The waste liquid port is a portion for collecting the processing liquid which is scattered to the periphery from the substrate W supported and rotated by the spin chuck 3, and received on the inner peripheral surface of the guard 23. The number of the guards 23 is not limited to one, and a plurality of the guards 23 may be provided. The number of the waste liquid ports is not limited to one, and a plurality of waste liquid ports may be provided. In a case where a plurality of the guards 23 is provided, the waste liquid port may be arranged for each of the guards 23. In this case, the plurality of the guards 23 and the plurality of waste liquid ports may be configured such that a combination of the guard 23 that receives the processing liquid scattered from the substrate W and the waste liquid port that collects the processing liquid received on the inner peripheral surface of the guard 23 is switched by raising and lowering each guard 23 by the guard moving mechanism 25. For example, it is conceivable that the combination of the guard 23 that receives the processing liquid scattered from the substrate W and the waste liquid port that collects the processing liquid received on the inner peripheral surface of the guard 23 is switched by raising and lowering each guard 23 by the guard moving mechanism 25 according to a type of the processing liquid.

The substrate processing apparatus 1 includes a processing liquid supply mechanism 31. The processing liquid supply mechanism 31 may be arranged on the outer peripheral side of the guard 23. The processing liquid supply mechanism 31 includes, for example, a nozzle 33, a base portion 37, and a moving mechanism (also referred to as a nozzle moving mechanism) 35. In other words, the substrate processing apparatus 1 includes the nozzle 33. In the first embodiment, the processing liquid supply mechanism 31 includes, for example, two nozzles 33. In the following description, in a case where it is necessary to distinguish the two nozzles 33, the nozzle 33 on the left side in FIG. 2 will be referred to as a nozzle 33A, and the nozzle 33 on the right side will be referred to as a nozzle 33B as appropriate. The number of the nozzles 33 in the processing liquid supply mechanism 31 may be one or three or more. In the first embodiment, the two nozzles 33 have the same configuration.

The nozzle 33 includes, for example, an extending portion 33a, a hanging portion 33b, and a distal end portion 33c. One end of the extending portion 33a of the nozzle 33 is attached to the base portion 37. The extending portion 33a extends in the horizontal direction from the base portion 37. The other end of the extending portion 33a is connected to the hanging portion 33b. The hanging portion 33b extends downward in the vertical direction from the extending portion 33a. The distal end portion 33c is located on a lower end side of the hanging portion 33b. The distal end portion 33c discharges the processing liquid from a lower surface side. Examples of the processing liquid include a photoresist liquid, a spin-on-glass (SOG) liquid, a developer, a rinse liquid, pure water, a cleaning liquid, and the like.

The nozzle moving mechanism 35 can move the nozzle 33 between a standby position as a first position (also referred to as a first C position) and a discharge position as a second position (also referred to as a second C position). The nozzle moving mechanism 35 includes, for example, a motor 39, a rotation shaft 41, and a position detection unit 43. The motor 39 is arranged in a vertical posture. The rotation shaft 41 is rotated about the rotation center PL3 by the motor 39. The rotation shaft 41 is connected to the base portion 37. The base portion 37 is rotated by being driven by the motor 39. The nozzle 33 is swung about the rotation center PL3 together with the base portion 37 by the nozzle moving mechanism 35. The position detection unit 43 detects a position (also referred to as a rotation position) of the rotation shaft 41 in a rotation direction around the rotation center PL3 of the rotation shaft 41. The position detection unit 43 detects an angle of the rotation shaft 41 about the rotation center PL3 in plan view. The position detection unit 43 outputs, for example, a pulse signal according to the rotation position of the rotation shaft 41.

The substrate processing apparatus 1 includes a standby cup 44 arranged at a position laterally away from the guard 23 in plan view. The standby cup 44 is arranged such that the distal end portion 33c of the nozzle 33 can be located above the standby cup 44 in plan view. From another point of view, the standby cup 44 is located below the standby position of the nozzle 33. The standby cup 44 is a portion for preventing the distal end portion 33c of the nozzle 33 from being dried. The standby cup 44 is used for idle discharge of the processing liquid from the nozzle 33. The nozzle moving mechanism 35 drives the motor 39 to swing the nozzle 33. The nozzle moving mechanism 35 moves the distal end portion 33c of the nozzle 33 between the standby position and the discharge position on the rotation center PL1 of the spin chuck 3 in response to a nozzle operation command from the control unit 45. The discharge position of the nozzle 33 is a position where the nozzle 33 is arranged when the processing liquid is discharged from the distal end portion 33c of the nozzle 33 toward the substrate W.

The substrate processing apparatus 1 includes, for example, a third sensor Z3 arranged on an outer peripheral side of the rotation shaft 41. If the nozzle 33 is located at the standby position, the third sensor Z3 changes a signal (output signal) to be output from the third sensor Z3. For example, the third sensor Z3 turns on the output signal if the nozzle 33 moves to the standby position. The third sensor Z3 may be omitted to simplify the configuration. In this case, a projection (also referred to as a rotation-side projection) may be provided on a portion of the rotation shaft 41, and a projection (also referred to as a fixed-side projection) that is arranged on the outer peripheral side of the rotation shaft 41 and fixed to the casing CA may be provided. For example, the position detection unit 43 may detect that the nozzle 33 is located at the standby position by detecting that the rotation-side projection of the rotation shaft 41 abuts on the fixed-side projection due to rotation of the rotation shaft 41 about the rotation center PL3, and rotation of the rotation shaft 41 about the rotation center PL3 becomes impossible. Here, the position of the nozzle 33 at the time point when the pulse signal of the position detection unit 43 becomes unchanged may be treated as the standby position.

The substrate processing apparatus 1 includes a camera CM as an imaging unit. The camera CM obtains an image (also referred to as a real image) capturing a component to be searched that is any one target component among one or more target components by imaging. Here, the one or more target components are components included in the substrate processing apparatus 1. The target component is a component that can be subjected to specific processing. The specific processing may include, for example, processing of detecting an abnormality. In the first embodiment, the one or more target components include two or more target components. The two or more target components as the one or more target components include a plurality of (specifically, four) chucks 9, guards 23, and nozzles 33. In other words, the substrate processing apparatus 1 includes, for example, a plurality of chucks 9, guards 23, and nozzles 33 as one or more target components. The component to be searched is a component subjected to search processing described later among one or more target components. The target component of any one of the one or more target components may be any one of the one or more target components. The camera CM is attached to a portion of the casing CA, for example. The position of the camera CM may be any position as long as the component to be searched falls within the field of view. The camera CM has, for example, a viewing angle (angle of view) at which all of one or more target components fall within the field of view.

The substrate processing apparatus 1 includes a control unit 45, an instruction unit 47, and a notification unit 49. Details of the control unit 45 will be described later. The instruction unit 47 is operated by an operator of the substrate processing apparatus 1. The instruction unit 47 is, for example, a keyboard or a touch panel. For example, the instruction unit 47 outputs a signal according to operation of the operator to the control unit 45. The instruction unit 47 gives an instruction of one or more target components, confirmation required timing, a recipe, start of processing, and the like. In a case where the control unit 45 detects an abnormality, the notification unit 49 notifies the operator of the abnormality. Examples of the notification unit 49 include a display, a lamp, a speaker, and the like. For example, the notification unit 49 operates in response to a signal from the control unit 45.

### <2. Configuration of Control System in Substrate Processing Apparatus>

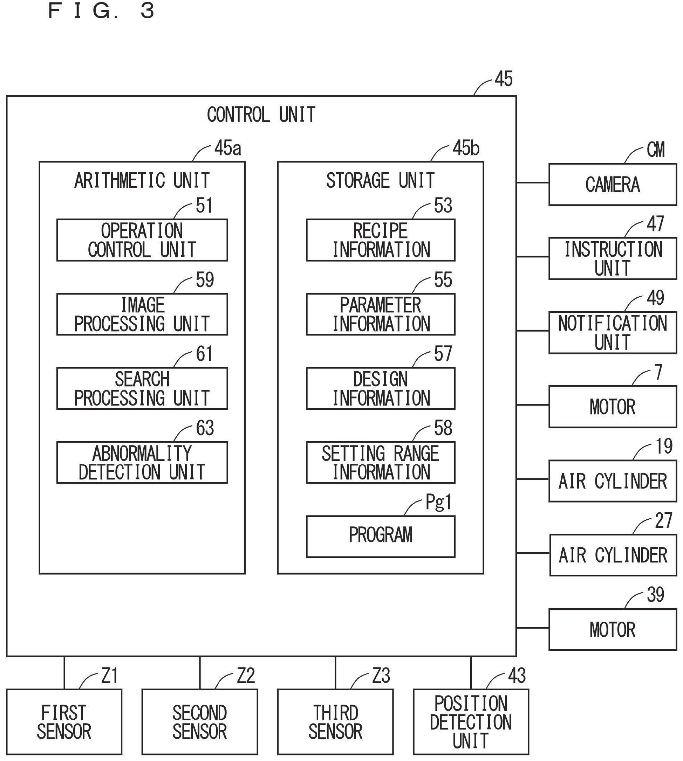

FIG. 3 is a block diagram illustrating an example of a functional configuration of the substrate processing apparatus 1 according to the first embodiment.

The control unit 45 includes, for example, an arithmetic unit 45a, a storage unit 45b, and the like. The arithmetic unit 45a includes, for example, an electronic circuit that functions as a processor such as a central processing unit (CPU) and an electronic circuit that functions as a memory such as a random access memory (RAM) that temporarily stores data for the processor to execute processing. The storage unit 45b includes a portion that functions as a non-volatile storage medium such as a hard disk or a flash memory. For example, the storage unit 45b may have a portion that functions as one non-volatile storage medium, or may have a portion that functions as two or more non-volatile storage media.

The arithmetic unit 45a includes, for example, an operation control unit 51, an image processing unit 59, a search processing unit 61, and an abnormality detection unit 63 as a plurality of functional components. The storage unit 45b stores, for example, recipe information 53, parameter information 55, design information 57, setting range information 58, a program Pg1, and the like. In the arithmetic unit 45a, for example, the operation control unit 51, the image processing unit 59, the search processing unit 61, and the abnormality detection unit 63 may be functional processing units (also referred to as functional processing units) implemented by the CPU reading and executing the program Pg1, and the like, in the storage unit 45b.

The operation control unit 51 controls operation of the motors 7, 39, the air cylinders 19, 27, and the camera CM described above. Signals from the first sensor Z1, the second sensor Z2, the third sensor Z3, and the position detection unit 43 are given to the operation control unit 51. The operation of each unit such as the motors 7, 39, the air cylinders 19, 27, and the camera CM by the operation control unit 51 is controlled according to, for example, the recipe in the recipe information 53 stored in the storage unit 45b. For example, after start of the operation of each unit based on the recipe is instructed by the operator, the operation control unit 51 outputs various operation commands to each unit based on the recipe to operate each unit such as the motor 7 at a predetermined timing.

The recipe information 53 is information indicating various recipes stored in advance in the storage unit 45b. The recipe defines various kinds of procedure for processing the substrate W. The operator can give an instruction to execute a desired recipe by operating the instruction unit 47.

The parameter information 55 is information such as a confirmation required timing for each of one or more target components, stored in advance in the storage unit 45b. The confirmation required timing may be, for example, a timing for confirming an operation state of the target component. The one or more target components and the confirmation required timing can be arbitrarily set by the operator operating the instruction unit 47. The operator can give an instruction, from the instruction unit 47, as to which component is set as the target component, which timing is set as the confirmation required timing, and the like.

The confirmation required timing can include, for example, a timing at which the chuck 9 is located at the open position that is the first position (more specifically, the first A position) by the chuck moving mechanism 17, a timing at which the chuck 9 is located at the closed position that is the second position (more specifically, the second A position) by the chuck moving mechanism 17, a timing at which the guard 23 is located at the lowered position that is the first position (more specifically, the first B position) by the guard moving mechanism 25, a timing at which the guard 23 is located at the raised position that is the second position (more specifically, the second B position) by the guard moving mechanism 25, a timing at which the nozzle 33 is located at the standby position that is the first position (more specifically, the first C position) by the nozzle moving mechanism 35, a timing at which the nozzle 33 is located at the discharge position that is the second position (more specifically, the second C position) by the nozzle moving mechanism 35, and the like.

Here, for example, the confirmation required timing may include a timing at which the chuck moving mechanism 17 moves the chuck 9 in response to the chuck operation command and the movement of the chuck 9 is completed, a timing at which the nozzle moving mechanism 35 moves the nozzle 33 in response to the nozzle operation command and the movement of the nozzle 33 is completed, a timing at which the guard moving mechanism 25 moves the guard 23 up and down in response to the guard operation command and the movement of the guard 23 is completed, and the like. The confirmation required timing may include, for example, a timing at which the chuck 9 is set to be located at the open position by the chuck operation command, a timing at which the chuck 9 is set to be located at the closed position by the chuck operation command, a timing at which the guard 23 is set to be located at the lowered position by the guard operation command, a timing at which the guard 23 is set to be located at the raised position by the guard operation command, a timing at which the nozzle 33 is set to be located at the standby position by the nozzle operation command, a timing at which the nozzle 33 is set to be located at the discharge position by the nozzle operation command, and the like.

Here, in the first embodiment, among the one or more target components, the target component at the confirmation required timing is a component to be searched that is to be subjected to search processing described later.

For example, based on a signal from the first sensor Z1, control of the operation of the chuck moving mechanism 17 (for example, the air cylinder 19), and the like, the operation control unit 51 notifies the search processing unit 61 of information specifying the chuck 9 as the target component (component to be searched) at the confirmation required timing and information indicating a position (such as, for example, the open position or the closed position) where the chuck 9 as the target component (component to be searched) at the confirmation required timing should originally exist at the confirmation required timing if the chuck 9 as the target component is at the confirmation required timing. For example, in a case where there are four chucks 9, as information for specifying the chuck 9, for example, a first chuck as a name for specifying the first chuck 9, a second chuck as a name for specifying the second chuck 9, a third chuck as a name for specifying the third chuck 9, and a fourth chuck as a name for specifying the fourth chuck 9 are each adopted.

For example, based on a signal from the second sensor Z2, control of the operation of the guard moving mechanism 25 (for example, the air cylinder 27) and the like, if the guard 23 as the target component is at the confirmation required timing, the operation control unit 51 notifies the search processing unit 61 of information specifying the guard 23 as the target component (component to be searched) at the confirmation required timing and information indicating the position (for example, the lowered position or the raised position) where the guard 23 as the target component (component to be searched) at the confirmation required timing should originally exist at the confirmation required timing.

Based on, for example, a signal from the third sensor Z3, a pulse signal from the position detection unit 43, control of the operation of the nozzle moving mechanism 35 (for example, the motor 39), and the like, the operation control unit 51 notifies the search processing unit 61 of information specifying the nozzle 33 as a target component (component to be searched) at the confirmation required timing and information indicating a position (such as, for example, the standby position or the discharge position) where the nozzle 33 as a target component (component to be searched) at the confirmation required timing should originally exist at the confirmation required timing if the nozzle 33 as the target component is at the confirmation required timing.

Here, for example, if there is only one target component, the operation control unit 51 does not have to notify the search processing unit 61 of information specifying the component to be searched as the target component at the confirmation required timing. The operation control unit 51 may notify the search processing unit 61 that the operation command has been output to each unit according to the recipe.

The design information 57 includes, for example, three-dimensional design information related to components constituting the substrate processing apparatus 1. The design information 57 includes, for example, three-dimensional computer aided design (3D-CAD) data related to components constituting the substrate processing apparatus 1. The 3D-CAD data is expressed by, for example, three axes whose coordinate axes are orthogonal to each other, and in a case where a component is arranged in a three-dimensional space, the 3D-CAD data is expressed by position and angle information (also collectively referred to as position information) related to the component. The design information 57 includes design information related to one or more target components transferred from a host computer (not illustrated). In other words, the storage unit 45b stores three-dimensional design information regarding each of the one or more target components. For example, the host computer (not illustrated) may store 3D-CAD data on all the components of the substrate processing apparatus 1 as the three-dimensional design information. Here, if the design information 57 stored in the storage unit 45b is limited to design information on one or more target components instead of design information on all components of the substrate processing apparatus 1, storage capacity of the storage unit 45b can be saved.

The image processing unit 59 processes a real image capturing the component to be searched obtained by imaging by the camera CM. The image processing unit 59 performs image processing on the real image and extracts information (also referred to as real shape information) on a two-dimensional shape of an object captured in the real image. For example, the image processing unit 59 extracts the real shape information by performing processing of extracting contour for all components captured in all regions or some preset regions in the real image. The contour here may include not only the contour of the outer shape of the component but also an edge portion located inside the outer shape of the component. Here, it can be said that the real shape information is information indicating the two-dimensional shape of the object in the real image. The real shape information extracted by the image processing unit 59 is given to the search processing unit 61.

The search processing unit 61 performs processing (also referred to as search processing) of searching for a virtual camera position (also referred to as a virtual camera position with a maximum matching degree) having the highest matching degree (also referred to as similarity) between the reference shape information and the real shape information among a plurality of virtual camera positions (also referred to as virtual camera positions) based on a plurality of pieces of reference shape information and the real shape information. Here, the plurality of pieces of reference shape information is information generated based on the three-dimensional design information regarding the component to be searched stored in the storage unit 45b, or the like. More specifically, the plurality of pieces of reference shape information is information about the two-dimensional shape of the 3D model of the component to be searched in each of a plurality of virtual images (also referred to as virtual images) that can be acquired by imaging the three-dimensional model (also referred to as 3D model) of the component to be searched from the plurality of virtual camera positions. For example, one piece of reference shape information is information generated based on three-dimensional design information regarding one component to be searched, and is information regarding a two-dimensional shape of a 3D model of the component to be searched in a virtual image that can be acquired by imaging the 3D model of the component to be searched from one virtual camera position. The 3D model of the component to be searched is a three-dimensional model of the component to be searched virtually generated based on the three-dimensional design information regarding the component to be searched. The virtual image can be generated, for example, by projecting the 3D model on a virtual plane by processing such as rendering. The matching degree between the reference shape information and the real shape information refers to, for example, a degree to which the reference shape information is approximate to the real shape information. The reference shape information is closer to the real shape information as the matching degree is larger, and the reference shape information is different from the real shape information as the matching degree is smaller. The matching degree between the reference shape information and the real shape information is represented by, for example, a numerical value indicating the matching degree between the reference shape information and the real shape information. The matching degree and the numerical value indicating the matching degree will be further described later. The information about the two-dimensional shape of the 3D model may be, for example, a figure.

The search processing unit 61 performs search processing for the component to be searched as the target component that has reached the confirmation required timing. In the search processing, it is possible to search among the plurality of virtual camera positions, for a virtual camera position that, by imaging the 3D model of the component to be searched from that position, can acquire a virtual image in which the two-dimensional shape of the 3D model of the component to be searched has the highest matching degree with the component to be searched captured in the real image obtained by imaging by the camera CM. In other words, in the search processing, it is possible to search among the plurality of virtual camera positions, for a virtual camera position that, by imaging the 3D model of the component to be searched from that position, can acquire a virtual image in which the two-dimensional shape of the 3D model of the component to be searched most closely matches the two-dimensional shape of the component to be searched captured in the real image obtained by imaging by the camera CM. Thus, according to the result of the search processing, the posture of the component to be searched based on the position of the camera CM can be recognized. In other words, according to the result of the search processing, the posture of the component to be searched captured in the real image can be recognized. In other words, the search processing unit 61 can recognize the posture of the component to be searched as the target component at the confirmation required timing based on the result of the search processing.

The setting range information 58 is information that defines one or more initial setting ranges related to a virtual camera position set in advance for each of at least one target component among one or more target components. The one or more initial setting ranges related to the virtual camera position define a range in which the virtual camera position is set in an initial stage of the search processing by the search processing unit 61. The setting range information 58 is provided to limit the range in which the virtual camera position is set in the initial stage of the search processing by the search processing unit 61, focusing on a point that a movement range of the target component in the substrate processing apparatus 1 is limited.

According to the setting range information 58, the number of virtual camera positions set in the initial stage of the search processing by the search processing unit 61 can be reduced. Here, in a case where the range of the position and the posture of the component to be searched is limited, the amount of calculation of the search processing for searching for the virtual camera position with the maximum matching degree can be reduced by limiting the range in which the plurality of virtual camera positions is set. As a result, the amount of calculation for recognizing the posture of the component to be searched captured in the real image can be reduced. Thus, the substrate processing apparatus 1 can efficiently recognize the posture of the component to be searched.

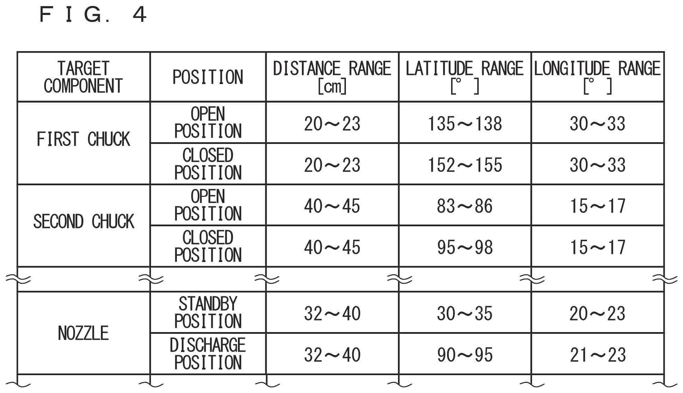

FIG. 4 is a view schematically illustrating a specific example of the setting range information 58. As illustrated in FIG. 4, the setting range information 58 is, for example, information that defines one or more initial setting ranges related to the virtual camera position for each of two or more target components as at least one target component among two or more target components as the one or more target components. In other words, the setting range information 58 includes, for example, information defining one or more initial setting ranges related to the virtual camera position for each target component. Here, the one or more target components include two or more target components, and the at least one target component includes two or more target components. In the example of the setting range information 58 of FIG. 4, as the two or more target components, "first chuck" as a name for specifying the first chuck 9, "second chuck" as a name for specifying the second chuck 9, and "nozzle" as a name for specifying the nozzle 33 are exemplified. In FIG. 4, illustration of one or more initial setting ranges related to the virtual camera position with respect to other target components is omitted.

In the first embodiment, in the setting range information 58, one or more initial setting ranges related to the virtual camera position for each target component include an initial setting range (also referred to as a first initial setting range) for the first position and an initial setting range (also referred to as a second initial setting range) for the second position. In other words, the setting range information 58 defines an initial setting range for each position for each target component. For example, the first initial setting range for the target component may be an initial setting range corresponding to a position that should originally exist at the timing when the target component is located at the first position. For example, the second initial setting range for the target component may be an initial setting range corresponding to a position that should originally exist at the timing when the target component is located at the second position.

More specifically, for example, in the setting range information 58, one or more initial setting ranges related to the virtual camera position for each chuck 9 include a first initial setting range (also referred to as a first A initial setting range) for the "open position" as the first position (first A position) and include a second initial setting range (also referred to as a second A initial setting range) for the "closed position" as the second position (second A position). For example, in the setting range information 58, one or more initial setting ranges related to the virtual camera position for the guard 23 include a first initial setting range (also referred to as a first B initial setting range) for the "lowered position" as the first position (first B position) and include a second initial setting range (also referred to as a second B initial setting range) for the "raised position" as the second position (second B position). For example, in the setting range information 58, one or more initial setting ranges related to the virtual camera position for the nozzle 33 include a first initial setting range (also referred to as a first C initial setting range) for the "standby position" as the first position (first C position) and include a second initial setting range (also referred to as a second C initial setting range) for the "discharge position" as the second position (second C position).

In the setting range information 58 exemplified in FIG. 4, one or more initial setting ranges related to the virtual camera position with respect to each of the first chuck as the first chuck 9 and the second chuck as the second chuck 9 include an initial setting range (a first A initial setting range) for the open position and an initial setting range (a second A initial setting range) for the closed position. In the setting range information 58 exemplified in FIG. 4, one or more initial setting ranges related to the virtual camera position for the nozzle 33 include an initial setting range (first C initial setting range) for the standby position and an initial setting range (second C initial setting range) for the discharge position.

In the first embodiment, each of the one or more initial setting ranges in the setting range information 58 includes a numerical range (also referred to as a first numerical range) that is a range of a distance, a numerical range (also referred to as a second numerical range) that is a range of a latitude, and a numerical range (also referred to as a third numerical range) that is a range of a longitude. Here, as the distance, for example, a distance from a reference point of the 3D model of the component to be searched as the target component at the confirmation required timing is applied. For example, the center of the 3D model is adopted as the reference point. For example, the center of gravity of the 3D model is adopted as the center of the 3D model. As the latitude, for example, the latitude of a virtual spherical surface (also referred to as a virtual spherical surface) surrounding the 3D model around the reference point of the 3D model is adopted. As the longitude, for example, the longitude of a virtual spherical surface surrounding the 3D model around the reference point of the 3D model is adopted.

In this case, in a case where the range in which each of the angular relationship and the distance between the camera CM and the component to be searched changes is limited, the range in which the plurality of virtual camera positions is set can be limited. As a result, the amount of calculation in the search processing for searching for the virtual camera position with the maximum matching degree can be reduced. As a result, the amount of calculation for recognizing the posture of the component to be searched captured in the real image can be reduced. Thus, in the substrate processing apparatus 1, the posture of the component can be efficiently recognized.

Each initial setting range defined by the setting range information 58 can be set in advance based on, for example, three-dimensional design information related to components constituting the substrate processing apparatus 1 included in the design information 57. Each initial setting range may be arbitrarily set, for example, by the operator operating the instruction unit 47. The setting range information 58 may be stored in the storage unit 45b, for example, by the operator operating the instruction unit 47. When each initial setting range is set in advance, each target component is not at the confirmation required timing, and thus, the reference point of the 3D model may be a reference point of a three-dimensional model (3D model) of the target component based on three-dimensional design information of the target component. Each initial setting range can be set based on, for example, a relationship such as a relative position and a posture between the 3D model of the target component and the camera CM in the design information 57. Each initial setting range is, for example, a range having a certain width according to an error in the attachment position and the posture of the target component and the camera CM in the substrate processing apparatus 1. In other words, each initial setting range includes a range in which the camera CM can be located in a case where the reference point of the 3D model of the target component is set as a reference in the virtual space based on the three-dimensional design information related to the components constituting the substrate processing apparatus 1 included in the design information 57.

The abnormality detection unit 63 detects an abnormality of the component to be searched as the target component at the confirmation required timing according to the information from the search processing unit 61. For example, the abnormality detection unit 63 may detect the abnormality of the component to be searched if the matching degree between the reference shape information and the real shape information for the virtual camera position with the maximum matching degree detected by the search processing unit 61 is smaller than a predetermined matching degree set in advance. In the first embodiment, as described above, the amount of calculation of the search processing of searching for the virtual camera position with the maximum matching degree can be reduced, so that the abnormality of the component to be searched can be easily detected. The predetermined matching degree may be stored in the storage unit 45b, for example, by the operator operating the instruction unit 47. The predetermined matching degree may be defined by a numerical value indicating the matching degree.

The abnormality detection unit 63 causes the notification unit 49 to perform notification operation according to the detection result of the abnormality. Specifically, the abnormality detection unit 63 causes the notification unit 49 to perform notification operation in response to the detection of the abnormality of the component to be searched. The notification operation may be, for example, operation of notifying the operator, or the like, of occurrence of the abnormality. Along with the occurrence of the abnormality, the notification unit 49 may also notify the operator of information for specifying the component to be searched in which the abnormality has been detected, for example. Here, examples of the information for specifying the component to be searched in which the abnormality has been detected include a character string or a speech indicating a name or a symbol for specifying each of the plurality of chucks 9, a name or a symbol for specifying each of the one or more guards 23, a name or a symbol for specifying each of the one or more nozzles 33, or the like.

### <3. Specific Example of Functional Configurations Related to Search Processing>

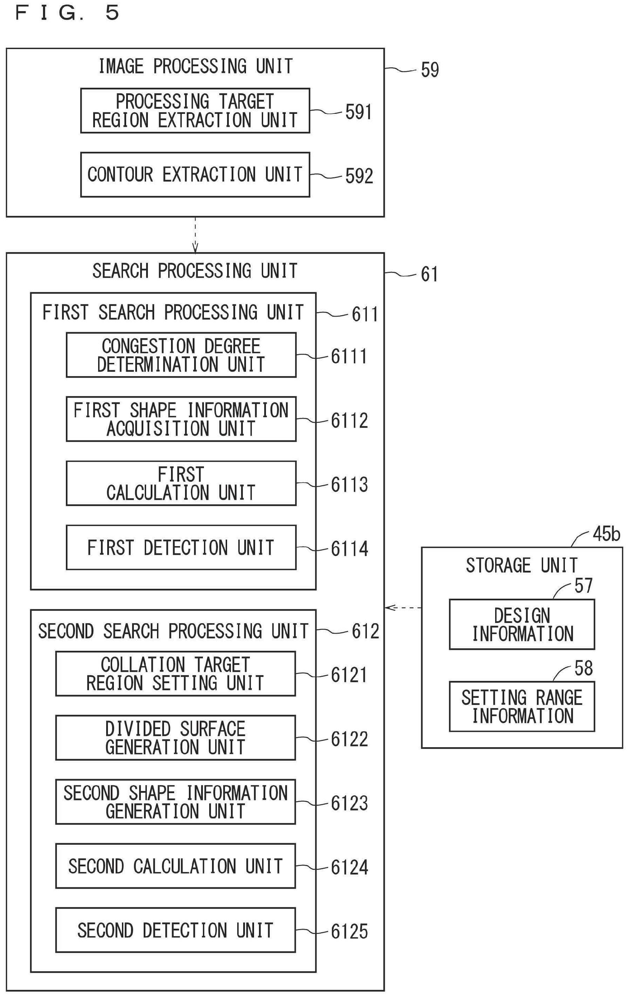

FIG. 5 is a block diagram illustrating a specific example of functional configurations related to the search processing in the control unit 45. FIG. 5 illustrates functional configurations of the storage unit 45b, the image processing unit 59, and the search processing unit 61 among a plurality of functional configurations in the control unit 45.

### <3-1. Image Processing Unit>

The image processing unit 59 includes, for example, a processing target region extraction unit 591 and a contour extraction unit 592 as a plurality of functional processing units. The processing target region extraction unit 591 and the contour extraction unit 592 are implemented, for example, by the CPU reading and executing the program Pg1 stored in the storage unit 45b in the arithmetic unit 45a.

The processing target region extraction unit 591 acquires a real image capturing the component to be searched obtained by imaging by the camera CM, and extracts a portion related to a region to be processed (also referred to as a processing target region) from the real image as an image (also referred to as a processing target real image). As a result, for example, a processing amount of calculation in the processing in the contour extraction unit 592 and the search processing in the search processing unit 61 can be reduced. As a result, the posture of the component to be searched captured in the real image can be efficiently recognized.

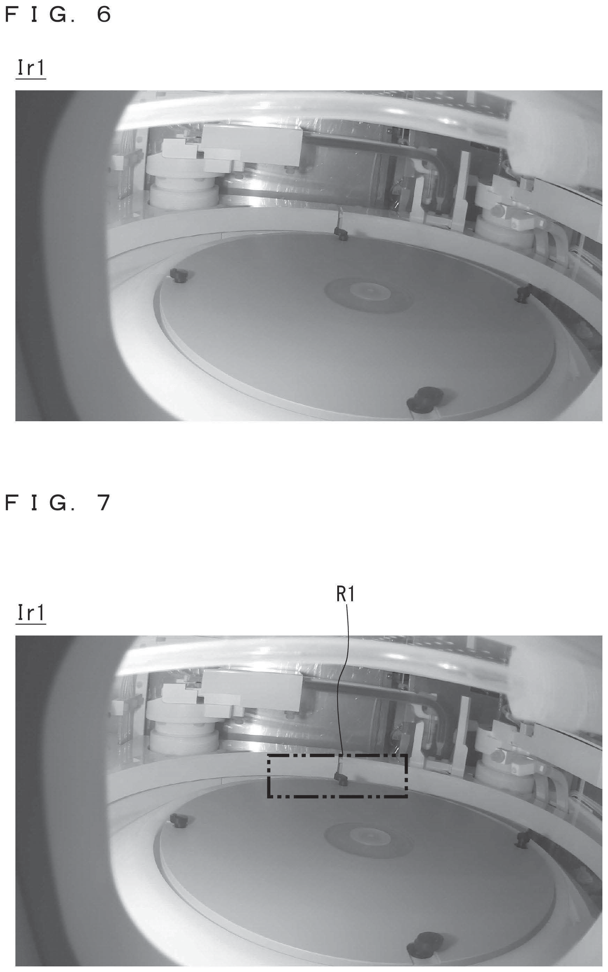

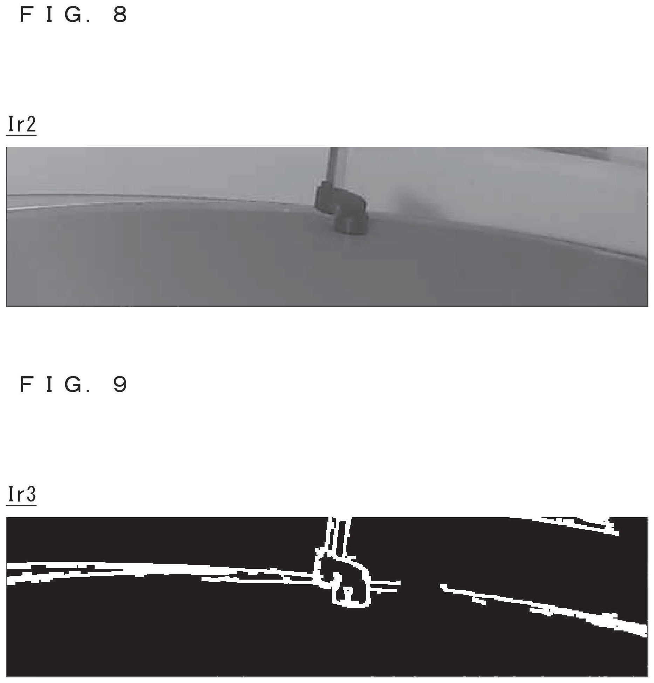

FIGS. 6 to 8 are views for describing processing of extracting a portion related to the processing target region from the real image. FIG. 6 illustrates a specific example of a real image Ir1 capturing the component to be searched obtained by imaging by the camera CM. FIG. 7 illustrates a specific example of the processing target region R1 in the real image Ir1. FIG. 8 illustrates a specific example of the processing target real image Ir2 extracted from the real image Ir1.

For example, in a case where the real image Ir1 illustrated in FIG. 6 is acquired, the processing target region extraction unit 591 extracts a portion related to the processing target region R1 surrounded by a thick two-dot chain line in the real image Ir1 as illustrated in FIG. 7, thereby obtaining the processing target real image Ir2 as illustrated in FIG. 8.

For example, the processing target region R1 may be set in advance for each target component that is to be the component to be searched so as to include a region in which the component to be searched as the target component can exist at the confirmation required timing on the real image. Further, the processing target region R1 may be set in advance, for example, for each position of the target component that is to be the component to be searched so as to include a region in which the component to be searched as the target component can exist at the confirmation required timing on the real image. For example, the processing target region R1 may be set by referring to a real image obtained in advance by imaging by the camera CM, or may be set based on the three-dimensional design information related to components constituting the substrate processing apparatus 1 and an imaging direction and an angle of view of the camera CM.

For example, the contour extraction unit 592 extracts information (real shape information) about the two-dimensional shape of the object captured in the real image by performing processing of extracting the contour for all the components captured in the processing target real image Ir2 obtained by the processing target region extraction unit 591. As a result, the image processing unit 59 can acquire the real shape information on the two-dimensional shape of the object captured in the real image. The real shape information acquired by the image processing unit 59 is given to the search processing unit 61.

Here, the processing target real image Ir2 obtained by the processing target region extraction unit 591 may be regarded as the real image capturing the component to be searched. As described above, the contour may include not only the contour of an outer shape of the component, but also an edge portion located inside the outer shape of the component. The processing of extracting the contour can be implemented using, for example, a method of detecting an edge such as a Canny method, or the like. Here, the contour may be extracted for all the components captured in the processing target real image Ir2 by further performing processing of expanding a line such as morphology transformations on the detected edge. The real shape information may be, for example, an edge image indicating contour of the object captured in the real image. As the edge image, for example, a binary image in which the contour of the object and the other portion can be distinguished is adopted. Here, it can be said that the edge image as the real shape information is information indicating the two-dimensional shape of the object in the real image. In other words, the real shape information may be, for example, information indicating the two-dimensional shape of the object in the real image.

FIG. 9 is a view illustrating a specific example of an edge image Ir3 as the real shape information acquired by the contour extraction unit 592. The edge image Ir3 illustrated in FIG. 9 is an example of an edge image obtained by performing processing of extracting contour for all components captured in the processing target real image Ir2 illustrated in FIG. 8. The edge image Ir3 illustrated in FIG. 9 is a binary image in which the contour of the component extracted by the contour extraction unit 592 is indicated in white and the other portions are indicated in black.

### <3-2. Search Processing Unit>

### <3-2-1. Example of Basic Concept of Search Processing>

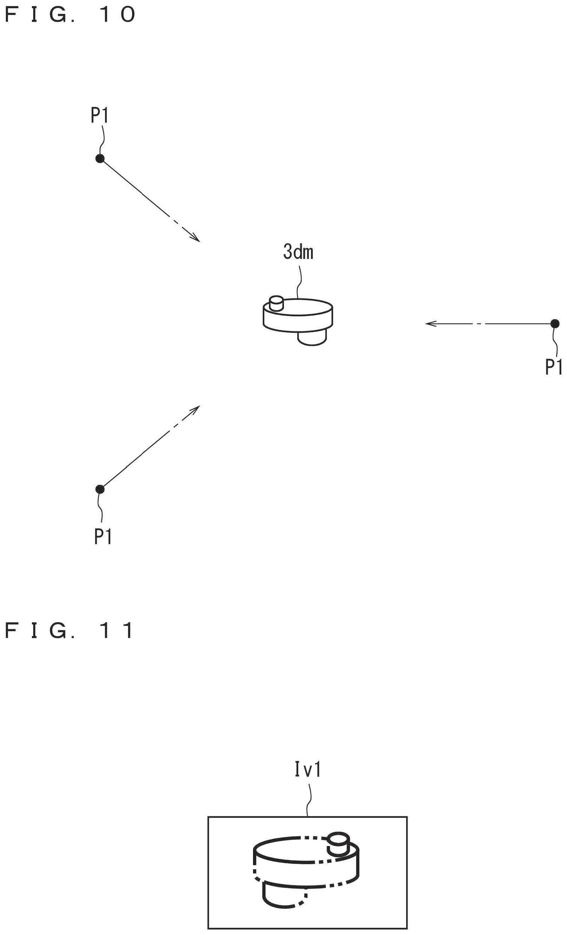

FIGS. 10 to 17 are views for describing an example of basic concept of the search processing to be performed by the search processing unit 61.

For example, as illustrated in FIG. 10, information (reference shape information) about a two-dimensional shape of a 3D model 3dm in a virtual image (virtual image) that can be acquired by imaging the 3D model 3dm from each virtual camera position P1 is generated while the 3D model 3dm of the component to be searched that is a three-dimensional model of the component to be searched virtually generated based on three-dimensional design information regarding the component to be searched (for example, the chuck 9) is set as the center, and the positions (virtual camera positions) P1 of the plurality of virtual cameras are appropriately set. In other words, the reference shape information is generated for each virtual camera position P1. As illustrated in FIG. 11, for example, an image (also referred to as a reference image) Iv1 indicating contour as a two-dimensional shape of the 3D model 3dm in a virtual image that can be acquired by imaging the 3D model 3dm from each virtual camera position P1 can be adopted as the reference shape information. Here, it can be said that the reference image as the reference shape information is information indicating the two-dimensional shape of the 3D model 3dm in the virtual image. In other words, the reference shape information may be, for example, information indicating the two-dimensional shape of the 3D model 3dm in the virtual image. FIG. 11 illustrates an example of the reference image Iv1 in which the contour of the 3D model 3dm is indicated by a thick two-dot chain line for convenience. The reference image Iv1 illustrated in FIG. 11 is a binary image in which the contour as the two-dimensional shape of the 3D model 3dm is indicated in black and the other portions are indicated in white.

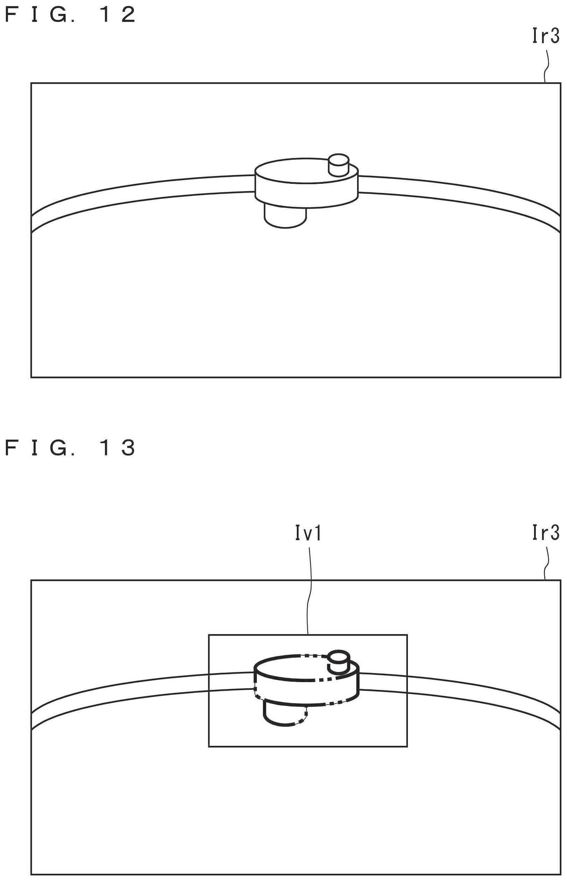

Then, for example, a numerical value indicating the matching degree is calculated between each of the plurality of reference images Iv1 as a plurality of pieces of reference shape information obtained for the plurality of virtual camera positions P1 and the edge image Ir3 as the real shape information regarding the two-dimensional shape of the object captured in the real image capturing the component to be searched as illustrated in FIG. 12. The edge image Ir3 illustrated in FIG. 12 is a binary image in which the contour of the object is indicated in black and the other portions are indicated in white. Here, for example, relative rotational movement and parallel movement of the reference image Iv1 as the reference shape information are performed on the edge image Ir3 as the real shape information. In this event, a numerical value indicating the matching degree in a case where the matching degree of the reference image Iv1 as the reference shape information with respect to the edge image Ir3 as the real shape information becomes maximum can be calculated as a numerical value indicating the matching degree between the edge image Ir3 as the real shape information and the reference image Iv1 as the reference shape information. In other words, for each virtual camera position P1, a numerical value indicating the matching degree in a case where the matching degree between the reference image Iv1 as the reference shape information and the edge image Ir3 as the real shape information becomes maximum can be calculated as a numerical value indicating the matching degree between the edge image Ir3 as the real shape information and the reference image Iv1 as the reference shape information. In other words, for each virtual camera position P1, the matching degree in a case where the matching degree between the reference image Iv1 as the reference shape information and the edge image Ir3 as the real shape information becomes maximum is set as the matching degree between the edge image Ir3 as the real shape information and the reference image Iv1 as the reference shape information.

Furthermore, for example, as illustrated in FIG. 13, among the plurality of virtual camera positions P1, the virtual camera position P1 at which the matching degree between the edge image Ir3 as the real shape information and the reference image Iv1 as the reference shape information is the highest is detected. As a result, for the component to be searched, it is possible to search among the plurality of virtual camera positions P1, for a virtual camera position that, by imaging the 3D model 3dm from that position, can yield a virtual image in which the two-dimensional shape of the 3D model 3dm of the component to be searched has the highest matching degree with the component to be searched captured in the real image capturing the component to be searched obtained by imaging by the camera CM.

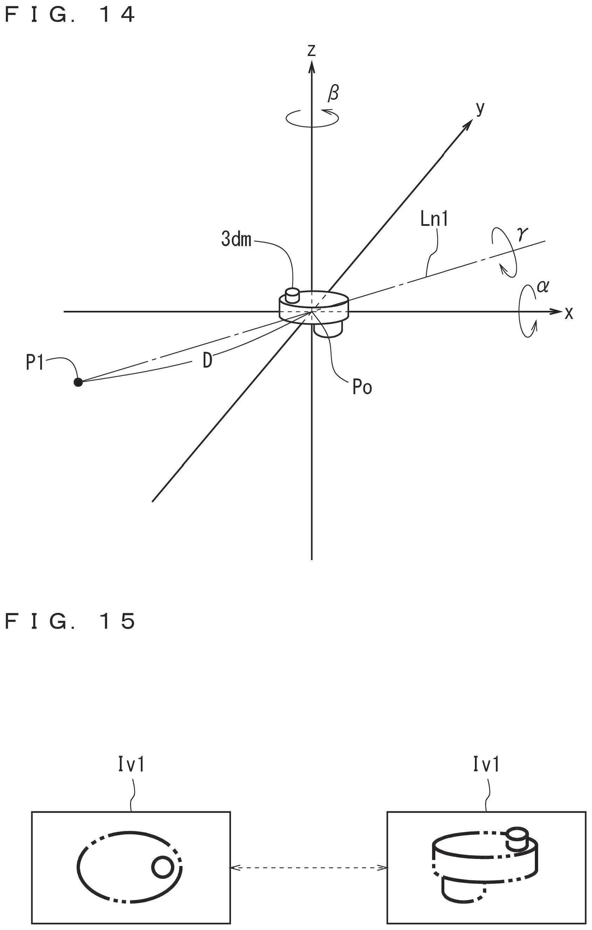

By the way, as illustrated in FIG. 14, a case is assumed where a xyz coordinate of a right-handed coordinate system in which the center of the 3D model 3dm is an origin as the reference point Po is set. For example, the center of gravity of the 3D model 3dm is adopted as the center of the 3D model 3dm. In this case, the plurality of virtual camera positions P1 about the 3D model 3dm can be defined by an angle (also referred to as a latitude) α in the rotation direction about the x axis, an angle (also referred to as a longitude) β in the rotation direction about the z axis, and a distance D from the origin. Furthermore, the posture of the virtual camera that images the 3D model 3dm from the virtual camera position P1 can be defined by an angle (also referred to as a roll angle) γ in a rotation direction around a line Ln1 indicated by a thin one-dot chain line passing through the reference point Po and the virtual camera position P1.

Here, if the latitude α and the longitude β defining the virtual camera position P1 change, a direction of imaging the 3D model 3dm from the virtual camera position P1 changes. Thus, if the latitude α and the longitude β defining the virtual camera position P1 change, for example, as illustrated in FIG. 15, the two-dimensional shape of the contour of the 3D model 3dm indicated by a thick two-dot chain line in the reference image Iv1 as the reference shape information may change.

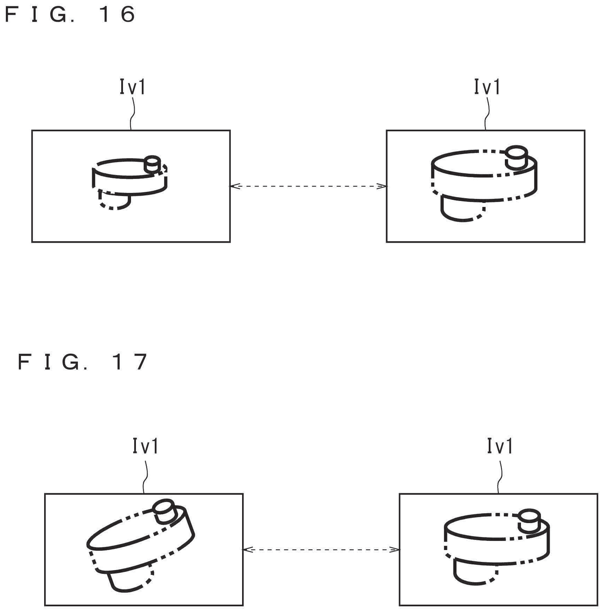

Furthermore, here, even if the distance D defining the virtual camera position P1 changes, the direction of imaging the 3D model 3dm from the virtual camera position P1 does not change. Thus, if the distance D defining the virtual camera position P1 changes, for example, as illustrated in FIG. 16, the two-dimensional shape of the contour of the 3D model 3dm indicated by a thick two-dot chain line in the reference image Iv1 as the reference shape information may change in size without changing in shape.

Furthermore, here, if the roll angle γ defining the posture of the virtual camera at the virtual camera position P1 changes, for example, as illustrated in FIG. 17, the two-dimensional shape of the contour of the 3D model 3dm indicated by a thick two-dot chain line in the reference image Iv1 as the reference shape information may change in direction without changing in shape and size.

In the first embodiment, in order to efficiently advance the search processing, the search processing unit 61 performs primary search processing and then performs secondary search processing using the result of the primary search processing. In other words, the search processing includes the primary search processing and the secondary search processing which are sequentially performed.

In the primary search processing, for example, a limited number of virtual camera positions P1 are set within the initial setting range for the component to be searched defined by the setting range information 58. Here, for example, the range of the distance D from the reference point Po of the 3D model 3dm in which the virtual camera position P1 is set is limited to a first numerical range that is a range of the distance included in the initial setting range for the component to be searched defined by the setting range information 58. For example, the range of the latitude α in which the virtual camera position P1 is set is limited to a second numerical range that is a range of the latitude included in the initial setting range for the component to be searched defined in the setting range information 58. For example, the range of the longitude β in which the virtual camera position P1 is set is limited to a third numerical range that is a range of the longitude included in the initial setting range for the component to be searched defined by the setting range information 58.

In addition, in the primary search processing, the latitude α and the longitude β are made coarsely different to some extent, a numerical value indicating the matching degree between the reference shape information and the real shape information is calculated for a limited number of virtual camera positions P1, and the virtual camera position P1 (also referred to as a virtual camera position with high matching degree) at which the matching degree between the reference shape information and the real shape information is the highest is detected.

In the secondary search processing, the virtual camera position P1 at which the matching degree between the reference shape information and the real shape information becomes higher is more finely searched based on the virtual camera position with high matching degree detected in the primary search processing. In other words, in the secondary search processing, the virtual camera position with the maximum matching degree described above is searched based on the virtual camera position with high matching degree. In other words, the search processing unit 61 searches for the virtual camera position with the maximum matching degree based on the virtual camera position with high matching degree.

When the numerical value indicating the matching degree between the reference shape information and the real shape information is calculated in the primary search processing and the secondary search processing, for example, the roll angle γ at which the matching degree becomes higher is also obtained, and the numerical value indicating the matching degree is calculated in consideration of the roll angle γ. As a result, the latitude α, the longitude β, the distance D, and the roll angle γ for the virtual camera position with the maximum matching degree, which is the virtual camera position P1 where the matching degree between the reference shape information and the real shape information is the highest, can be acquired as a result of the search processing. By the latitude α, the longitude β, the distance D, and the roll angle γ, the posture of the 3D model 3dm based on the virtual camera position with the maximum matching degree can be recognized. Thus, according to the result of the search processing, the posture of the component to be searched based on the position of the camera CM that has captured the real image capturing the component to be searched can be recognized. In other words, according to the result of the search processing, the posture of the component to be searched captured in the real image can be recognized. Here, the posture of the component to be searched may be recognized in the form of, for example, the latitude α, the longitude β, the distance D, and the roll angle γ.

### <3-2-2. Functional Configuration of Search Processing Unit>

The search processing unit 61 includes, for example, a first search processing unit 611 and a second search processing unit 612 as a plurality of functional processing units. The first search processing unit 611 and the second search processing unit 612 are implemented, for example, by the CPU reading and executing the program Pg1 stored in the storage unit 45b in the arithmetic unit 45a. The first search processing unit 611 performs processing related to the primary search processing, and the second search processing unit 612 performs processing related to the secondary search processing.

### <3-2-2-1. First Search Processing Unit>

The first search processing unit 611 includes, for example, a congestion degree determination unit 6111, a first shape information acquisition unit 6112, a first calculation unit 6113, and a first detection unit 6114 as a plurality of functional processing units. The congestion degree determination unit 6111, the first shape information acquisition unit 6112, the first calculation unit 6113, and the first detection unit 6114 are implemented, for example, by the CPU reading and executing the program Pg1 stored in the storage unit 45b in the arithmetic unit 45a. In the first search processing unit 611, for example, the primary search processing can be implemented by the first shape information acquisition unit 6112, the first calculation unit 6113, and the first detection unit 6114.

### <<Congestion Degree Determination Unit 6111>>

For example, the congestion degree determination unit 6111 determines a region (also referred to as a low congestion degree region) in which the congestion degree of the contour of the component is low for the edge image as the real shape information acquired by the contour extraction unit 592. In the congestion degree determination unit 6111, for example, in the edge image as the real shape information, the proportion occupied by the contour of the component is calculated as the congestion degree of the contour of the component for each region of a predetermined size (also referred to as a unit determination region), and the unit determination region in which the congestion degree is equal to or less than a predetermined value can be determined as a low congestion degree region. The predetermined size of the unit determination region can be set, for example, according to the size of the reference image as the reference shape information described above. The predetermined value can be set to a numerical value such as zero, for example.

For example, in a case where zero is adopted as the predetermined value, the unit determination region that does not include the contour of the component at all in the edge image as the real shape information is determined as the low congestion degree region. The determination result in the congestion degree determination unit 6111 is given to the first calculation unit 6113 and the second search processing unit 612. Here, it is estimated that the low congestion degree region does not include the contour of the component to be searched. Thus, for example, in the first calculation unit 6113 and the second calculation unit 6124 to be described later, the low congestion degree region of the edge image as the real shape information is excluded from the calculation target for calculating the numerical value indicating the matching degree between the real shape information and the reference shape information, so that the amount of calculation required for the search processing can be reduced.

### <<First Shape Information Acquisition Unit 6112>>

The first shape information acquisition unit 6112 acquires the reference shape information generated for each of a plurality of first virtual camera positions assuming a case where the 3D model 3dm of the component to be searched is imaged from each of the plurality of first virtual camera positions, for example, based on the three-dimensional design information regarding the component to be searched and the setting range information 58 stored in the storage unit 45b, or the like. The plurality of first virtual camera positions is located along a plurality of virtual spherical surfaces surrounding the 3D model 3dm of the component to be searched centered around the reference point Po of the 3D model 3dm of the component to be searched, and is a plurality of virtual camera positions corresponding to at least one initial setting range of one or more initial setting ranges for the component to be searched defined by the setting range information 58. Here, in a case where the range of the position and the posture of the component to be searched is limited, the amount of calculation in the search processing can be reduced by limiting the range in which the plurality of first virtual camera positions is set. As a result, the amount of calculation for recognizing the posture of the component to be searched captured in the real image can be reduced. As a result, the substrate processing apparatus 1 can efficiently recognize the posture of the component to be searched.

Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the first virtual camera position. The virtual image can be generated, for example, by projecting the 3D model 3dm onto a virtual plane by processing such as rendering. The reference point Po of the 3D model 3dm of the component to be searched may be set to, for example, a center point such as a center of gravity of the 3D model 3dm of the component to be searched. At least one initial setting range of the one or more initial setting ranges for the component to be searched includes an initial setting range corresponding to a position where the component to be searched at the confirmation required timing should originally exist at the confirmation required timing. The plurality of virtual camera positions corresponding to at least one initial setting range of the one or more initial setting ranges for the component to be searched may be a plurality of virtual camera positions virtually set within the range of at least one initial setting range of the one or more initial setting ranges for the component to be searched.

Here, for example, a case is assumed where one or more initial setting ranges for the component to be searched defined in the setting range information 58 include the first initial setting range for the first position, and it is the timing at which the component to be searched is located at the first position by the moving mechanism. At this timing, for example, the search processing unit 61 can acquire the reference shape information generated for each of the plurality of first virtual camera positions corresponding to the first initial setting range assuming a case where the 3D model 3dm of the component to be searched is imaged from each of the plurality of first virtual camera positions corresponding to the first initial setting range by the first shape information acquisition unit 6112 based on the three-dimensional design information regarding the component to be searched and the setting range information 58 stored in the storage unit 45b, or the like. As a result, for example, in a case where the component to be searched moves between the first position and the second position, the range in which the plurality of first virtual camera positions is set can be limited for the first position in which the range in which the posture of the component to be searched changes is more limited. As a result, the amount of calculation for recognizing the posture of the component to be searched captured in the real image can be reduced. Thus, the substrate processing apparatus 1 can efficiently recognize the posture of the component to be searched. Here, the first initial setting range corresponds to at least one initial setting range of one or more initial setting ranges for the component to be searched described above. In other words, at least one initial setting range of one or more initial setting ranges for the component to be searched described above is the first initial setting range. The plurality of virtual camera positions corresponding to the first initial setting range for the component to be searched may be a plurality of virtual camera positions virtually set within the first initial setting range for the component to be searched.

For example, if the component to be searched at the confirmation required timing is the first chuck, and it is the timing at which the first chuck is located at the open position as the first A position that is the first position by the chuck moving mechanism 17, the first initial setting range may be the first A initial setting range for the open position of the first chuck. For example, if the component to be searched at the confirmation required timing is the guard 23, and it is the timing at which the guard 23 is located at the lowered position as the first B position that is the first position by the guard moving mechanism 25, the first initial setting range may be the first B initial setting range for the lowered position of the guard 23. For example, if the component to be searched at the confirmation required timing is the nozzle 33, and it is the timing at which the nozzle 33 is located at the standby position as the first C position that is the first position by the nozzle moving mechanism 35, the first initial setting range may be the first C initial setting range for the standby position of the nozzle 33.

Here, for example, a case is assumed where one or more initial setting ranges for the component to be searched defined in the setting range information 58 include the second initial setting range for the second position, and it is the timing at which the component to be searched is located at the second position by the moving mechanism. At this timing, for example, the search processing unit 61 can acquire the reference shape information generated for each of the plurality of first virtual camera positions corresponding to the second initial setting range assuming a case where the 3D model 3dm of the component to be searched is imaged from each of the plurality of first virtual camera positions corresponding to the second initial setting range by the first shape information acquisition unit 6112 based on the three-dimensional design information regarding the component to be searched and the setting range information 58 stored in the storage unit 45b, or the like. As a result, for example, in a case where the component to be searched moves between the first position and the second position, the range in which the plurality of first virtual camera positions is set can be limited for the second position in which the range in which the posture of the component to be searched changes is more limited. As a result, the amount of calculation for recognizing the posture of the component to be searched captured in the real image can be reduced. Thus, the substrate processing apparatus 1 can efficiently recognize the posture of the component to be searched. Here, the second initial setting range corresponds to at least one initial setting range of one or more initial setting ranges for the component to be searched described above. In other words, at least one initial setting range of one or more initial setting ranges for the component to be searched described above is the second initial setting range. The plurality of virtual camera positions corresponding to the second initial setting range for the component to be searched may be a plurality of virtual camera positions virtually set within the second initial setting range for the component to be searched.

For example, if the component to be searched at the confirmation required timing is the first chuck, and it is the timing at which the first chuck is located at the closed position as the second A position that is the second position by the chuck moving mechanism 17, the second initial setting range may be the second A initial setting range for the closed position of the first chuck. For example, if the component to be searched at the confirmation required timing is the guard 23, and it is the timing at which the guard 23 is located at the raised position as the second B position that is the second position by the guard moving mechanism 25, the second initial setting range may be the second B initial setting range for the raised position of the guard 23. For example, if the component to be searched at the confirmation required timing is the nozzle 33, and it is the timing at which the nozzle 33 is located at the discharge position as the second C position that is the second position by the nozzle moving mechanism 35, the second initial setting range may be the second C initial setting range for the discharge position of the nozzle 33.

Here, for example, as illustrated in FIG. 4, if each of the one or more initial setting ranges for the component to be searched includes the first numerical range that is the range of the distance, the second numerical range that is the range of the latitude, and the third numerical range that is the range of the longitude, in a case where the range in which each of the angular relationship and the distance between the camera CM and the component to be searched changes is limited, the range in which the plurality of first virtual camera positions is set can be limited. As a result, the amount of calculation in the search processing can be reduced. As a result, the amount of calculation for recognizing the posture of the component to be searched captured in the real image can be reduced. Thus, the substrate processing apparatus 1 can efficiently recognize the posture of the component to be searched.

Furthermore, here, for example, as described above with reference to FIG. 4, if the setting range information 58 includes information defining one or more initial setting ranges related to the virtual camera position for each target component, the range in which the plurality of first virtual camera positions is set can be limited for each component to be searched as the target component at the confirmation required timing. As a result, the amount of calculation in the search processing can be reduced. As a result, the amount of calculation for recognizing the posture of the component to be searched captured in the real image can be reduced. Thus, the substrate processing apparatus 1 can efficiently recognize the posture of the component to be searched. Here, a fact that the setting range information 58 includes information defining one or more initial setting ranges related to the virtual camera position for each target component is synonymous with a fact that the setting range information 58 defines one or more initial setting ranges related to the virtual camera position for each of two or more target components as at least one target component among two or more target components as the one or more target components.

In the first embodiment, more specifically, for example, the first shape information acquisition unit 6112 acquires the reference shape information generated for each of M1×T1 first virtual camera positions assuming a case where the 3D model 3dm of the component to be searched is imaged from each of the M1×T1 (both M1 and T1 are natural numbers equal to or greater than 2) first virtual camera positions that are the plurality of first virtual camera positions based on the three-dimensional design information regarding the component to be searched and the setting range information 58 stored in the storage unit 45b, or the like. In the present specification, in a case where each of N1 and N2 is a natural number, N1×N2 means the number obtained by multiplying N1 by N2. For example, 2×3 means 6 as the number of 6 which is a number obtained by multiplying 2 by 3. The M1×T1 first virtual camera positions are a plurality of virtual camera positions set by virtually setting one virtual camera position for each of M1 virtual surfaces in each of T1 surface aggregations in a case where the T1 surface aggregations having mutually different distances from the reference point Po of the 3D model 3dm of the component to be searched are virtually set. The T1 surface aggregations are a plurality of aggregates of surfaces each including a plurality of virtual surfaces located along a virtual spherical surface surrounding the 3D model 3dm centered around the reference point Po of the 3D model 3dm of the component to be searched and corresponding to the first numerical range that is the range of the distance in at least one initial setting range of one or more initial setting ranges for the component to be searched defined by the setting range information 58. The M1 virtual surfaces in each of the T1 surface aggregations are a plurality of virtual surfaces corresponding to both of the second numerical range that is the range of the latitude and the third numerical range that is the range of the longitude in at least one initial setting range of one or more initial setting ranges for the component to be searched defined in the setting range information 58.

Here, for example, as illustrated in FIG. 14, the position and the posture of each virtual surface, each first virtual camera position, and the like, can be defined by setting the xyz coordinate of the right-handed coordinate system with the reference point Po of the 3D model 3dm of the component to be searched defined by the three-dimensional design information regarding the component to be searched as the origin, the angle (latitude) α in the rotation direction around the x axis, the angle (longitude) β in the rotation direction around the z axis, and the distance D from the origin.

Here, in each of the M1 virtual surfaces in each of the T1 surface aggregations, for example, the first virtual camera position is virtually set at a predetermined position of the virtual surface. For example, the position of the center of the virtual surface is adopted as the predetermined position. For example, the center of gravity of the virtual surface is adopted as the center of the virtual surface. The plurality of surface aggregations corresponding to the first numerical range that is the range of the distance in at least one initial setting range of one or more initial setting ranges for the component to be searched defined by the setting range information 58 may be, for example, a plurality of surface aggregations in which the distance from the reference point Po of the 3D model 3dm of the component to be searched is included within the first numerical range, or a plurality of surface aggregations located along a plurality of virtual spherical surfaces in which the distance from the reference point Po of the 3D model 3dm of the component to be searched is included within the first numerical range. In addition, the plurality of virtual surfaces corresponding to both of the second numerical range that is the range of the latitude and the third numerical range that is the range of the longitude in at least one initial setting range of the one or more initial setting ranges for the component to be searched defined in the setting range information 58 may be a plurality of virtual surfaces whose latitude is included in the second numerical range and whose longitude is included in the third numerical range. The plurality of virtual surfaces may be a plurality of virtual surfaces in which the latitude of the predetermined position of each of the plurality of virtual surfaces is included in the range of the second numerical range, and the longitude of the predetermined position of each of the plurality of virtual surfaces is included in the range of the third numerical range. The predetermined position of each of the plurality of virtual surfaces may be, for example, a center such as the center of gravity of the virtual surface.

In the first embodiment, for example, a triangular surface is adopted as each of a plurality of virtual surfaces constituting the surface aggregation, and a polyhedron constituted by a plurality of triangular surfaces is adopted as the surface aggregation. In other words, a spherical polyhedron constituted by a plurality of triangular surfaces is adopted as the surface aggregation. In other words, for example, a triangular surface is adopted as each of the plurality of virtual surfaces constituting the T1 surface aggregations, and a polyhedron constituted by a plurality of triangular surfaces is adopted as each of the T1 surface aggregations. As a result, the surface aggregation including the plurality of virtual surfaces can be easily set. Here, an equilateral triangle may be adopted as the triangle. If the virtual surface is a triangular surface, the center of the virtual surface may be, for example, the center of gravity or the incenter of the triangle.

In the first embodiment, the first shape information acquisition unit 6112, for example, sets the plurality of first virtual camera positions and generates the reference shape information for each of the plurality of first virtual camera positions based on the three-dimensional design information regarding the component to be searched and the setting range information 58 stored in the storage unit 45b, or the like, so that the reference shape information generated for each of the plurality of first virtual camera positions can be acquired.

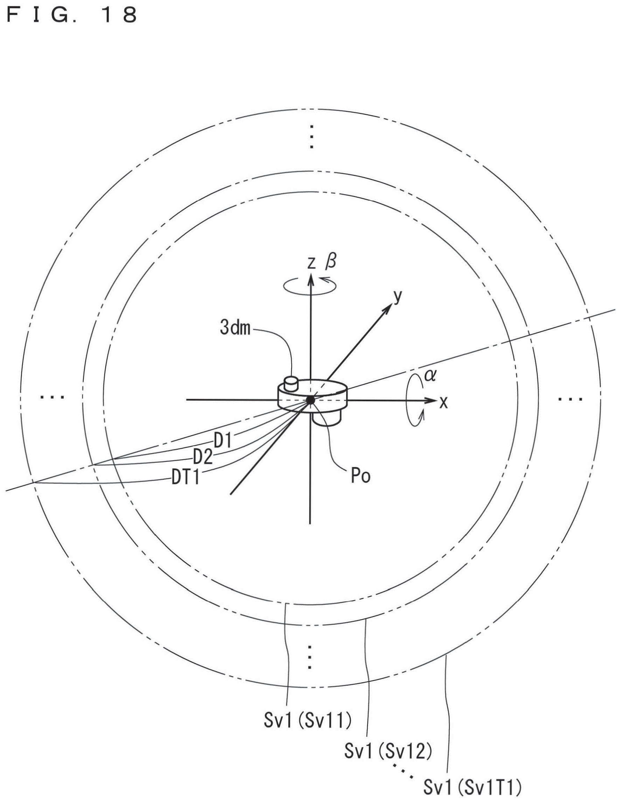

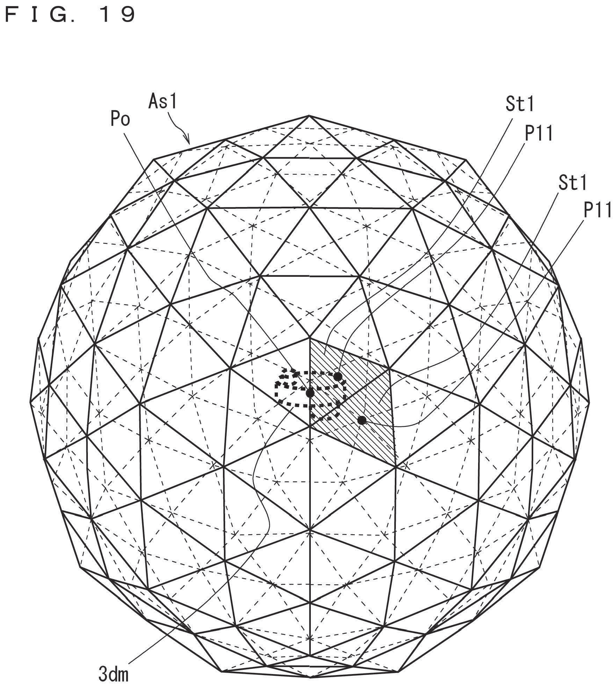

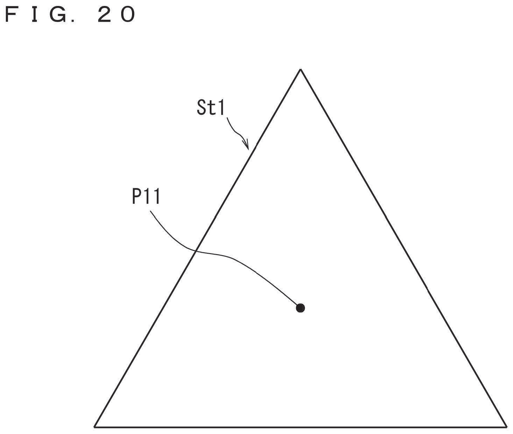

FIG. 18 is a view for describing an example of a mode in which T1 surface aggregations As1 having mutually different distances from the reference point Po of the 3D model 3dm of the component to be searched are virtually set. FIG. 19 is a view illustrating an example of a setting mode of one surface aggregation As1. FIG. 20 is a view illustrating an example of a setting mode of the first virtual camera position P11 in one virtual surface St1.

In FIG. 18, outer edges of the T1 virtual spherical surfaces Sv1 are indicated by a thin two-dot chain line. The T1 virtual spherical surfaces Sv1 are virtually generated based on the three-dimensional design information regarding the component to be searched. The T1 virtual spherical surfaces Sv1 have different distances from the reference point Po of the 3D model 3dm of the component to be searched. Each of the T1 virtual spherical surfaces Sv1 surrounds the 3D model 3dm centered around the reference point Po of the 3D model 3dm of the component to be searched. In FIG. 18, among the T1 virtual spherical surfaces Sv1, three virtual spherical surfaces Sv1 are illustrated, and illustration of the other virtual spherical surfaces Sv1 is omitted. More specifically, FIG. 18 illustrates, as the three virtual spherical surfaces Sv1, a first virtual spherical surface Sv1 (also referred to as a virtual spherical surface Sv11) at a distance D1 from the reference point Po, a second virtual spherical surface Sv1 (also referred to as a virtual spherical surface Sv12) at a distance D2 from the reference point Po, and a T1-th virtual spherical surface Sv1 (also referred to as a virtual spherical surface Sv1T1) at a distance DT1 from the reference point Po.

In FIG. 19, for the purpose of avoiding complication of the drawing, only the origin as the reference point Po among the xyz coordinates of the right-handed coordinate system is illustrated, and description of three axes of xyz is omitted, and description of the angle (latitude) α and the angle (longitude) β is also omitted. In addition, in FIG. 19, description of the angle (roll angle) γ in the rotation direction about the line passing through the origin as the reference point Po and the first virtual camera position P11, which defines the posture of the virtual camera that images the 3D model 3dm of the component to be searched from the first virtual camera position P11, is also omitted. In FIG. 19, the contour of a front portion of the surface aggregation As1 is indicated by a solid line, and the contour of a rear portion of the surface aggregation As1 is indicated by a thin broken line. In FIG. 19, the contour of the 3D model 3dm of the component to be searched is indicated by a thick broken line for convenience. Furthermore, in FIG. 19, two triangular virtual surfaces St1 as an example of M1 virtual surfaces St1 among the plurality of virtual surfaces St1 are indicated by reference signs "St1" and hatching using oblique lines, for convenience.

In the first shape information acquisition unit 6112, for example, as illustrated in FIG. 18, the surface aggregation As1 as illustrated in FIG. 19 is virtually set along each of the T1 virtual spherical surfaces Sv1. As a result, T1 surface aggregations As1 are virtually set. Here, the T1 virtual spherical surfaces Sv1 are set at a predetermined pitch, for example. For example, 1 centimeter (cm), or the like, is adopted as the predetermined pitch. The T1 surface aggregations As1 have a shape of a mutually enlarged and reduced similarity relationship about the reference point Po of the 3D model 3dm of the component to be searched. In other words, the T1 surface aggregations As1 are different in size from each other, but have the same shape and have the same posture with respect to the 3D model 3dm. In the example of FIG. 19, the surface aggregation As1 is a polyhedron constituted with a plurality of triangular virtual surfaces St1. FIG. 19 illustrates an example of a spherical polyhedron in which the surface aggregation As1 is constituted with about 200 triangular virtual surfaces St1. The number of the plurality of virtual surfaces St1 constituting the surface aggregation As1 is not limited to about 200, and is set to, for example, about 100 to 300. Here, each of the T1 surface aggregations As1 includes a plurality of virtual surfaces St1 located along a virtual spherical surface Sv1 surrounding the 3D model 3dm centered around the reference point Po of the 3D model 3dm of the component to be searched. Then, for example, in each of the surface aggregations As1, the first virtual camera position P11 is virtually set for each of the two virtual surfaces St1 as an example of the M1 virtual surfaces in the surface aggregation As1. In FIG. 19, a first virtual camera position P11 set for each of two virtual surfaces St1 as an example of M1 virtual surfaces in one surface aggregation As1 is indicated by a black circle. Here, for example, as illustrated in FIG. 20, in each of the two virtual surfaces St1 as an example of the M1 virtual surfaces, the first virtual camera position P11 is set at the center of the virtual surface St1 as a predetermined position of the virtual surface St1. Also in FIG. 20, similarly to FIG. 19, the first virtual camera position P11 is indicated by a black circle.

When the reference shape information for each of the M1×T1 first virtual camera positions P11 is generated, the first shape information acquisition unit 6112 sets an imaging direction by a virtual camera that images the 3D model 3dm of the component to be searched from the first virtual camera position P11 to a direction from the first virtual camera position P11 toward the reference point Po of the 3D model 3dm of the component to be searched. Furthermore, in this event, the first shape information acquisition unit 6112 sets the roll angle γ that defines the posture of the virtual camera that images the 3D model 3dm of the component to be searched from the first virtual camera position P11 to, for example, zero (0) degrees. Here, for each first virtual camera position P11, for example, a reference image Iv1 as the reference shape information as schematically illustrated in FIG. 11 is generated.

### <<First Calculation Unit 6113>>

The first calculation unit 6113 calculates, for each of the plurality of first virtual camera positions P11, a numerical value indicating the matching degree between information (real shape information) on the two-dimensional shape of the object captured in the real image capturing the component to be searched and the reference shape information. More specifically, the first calculation unit 6113 calculates, for each of the M1×T1 first virtual camera positions P11 as the plurality of first virtual camera positions P11 described above, a numerical value indicating the matching degree between the information (real shape information) on the two-dimensional shape of the object captured in the real image capturing the component to be searched and the reference shape information.

Here, for example, a case is assumed where one or more initial setting ranges related to the virtual camera position for the component to be searched defined in the setting range information 58 include the first initial setting range for the first position, and it is the timing at which the component to be searched is located at the first position by the moving mechanism. At this timing, the search processing unit 61 can calculate, by the first calculation unit 6113, a numerical value indicating the matching degree between the information (real shape information) on the two-dimensional shape of the object captured in the real image capturing the component to be searched and the reference shape information, for each of the plurality of first virtual camera positions P11 corresponding to the first initial setting range. Here, the real image capturing the component to be searched is a real image obtained by imaging by the camera CM at the timing when the component to be searched is located at the first position by the moving mechanism.

For example, if the component to be searched at the confirmation required timing is the first chuck, and it is the timing at which the first chuck is located at the open position as the first A position that is the first position by the chuck moving mechanism 17, the real image capturing the component to be searched may be a real image obtained by imaging by the camera CM at the timing when the first chuck is located at the open position by the chuck moving mechanism 17. For example, if the component to be searched at the confirmation required timing is the guard 23, and it is the timing at which the guard 23 is located at the lowered position as the first B position which is the first position by the guard moving mechanism 25, the real image capturing the component to be searched may be a real image obtained by imaging by the camera CM at the timing when the guard 23 is located at the open position by the guard moving mechanism 25. For example, if the component to be searched at the confirmation required timing is the nozzle 33, and it is the timing at which the nozzle 33 is located at the standby position as the first C position that is the first position by the nozzle moving mechanism 35, the real image capturing the component to be searched may be a real image obtained by imaging by the camera CM at the timing when the nozzle 33 is located at the standby position by the nozzle moving mechanism 35.

Here, for example, a case is assumed where one or more initial setting ranges related to the virtual camera position for the component to be searched defined in the setting range information 58 include the second initial setting range for the second position, and it is the timing at which the component to be searched is located at the second position by the moving mechanism. At this timing, the search processing unit 61 can calculate, by the first calculation unit 6113, for each of the plurality of first virtual camera positions P11 corresponding to the second initial setting range, a numerical value indicating the matching degree between the information (real shape information) on the two-dimensional shape of the object captured in the real image capturing the component to be searched and the reference shape information. Here, the real image capturing the component to be searched is a real image obtained by imaging by the camera CM at the timing when the component to be searched is located at the second position by the moving mechanism.

For example, if the component to be searched at the confirmation required timing is the first chuck, and it is the timing at which the first chuck is located at the closed position as the second A position which is the second position by the chuck moving mechanism 17, the real image capturing the component to be searched may be a real image obtained by imaging by the camera CM at the timing when the first chuck is located at the closed position by the chuck moving mechanism 17. For example, if the component to be searched at the confirmation required timing is the guard 23, and it is the timing at which the guard 23 is located at the raised position as the second B position that is the second position by the guard moving mechanism 25, the real image capturing the component to be searched may be a real image obtained by imaging by the camera CM at the timing when the guard 23 is located at the raised position by the guard moving mechanism 25. For example, if the component to be searched at the confirmation required timing is the nozzle 33, and it is the timing at which the nozzle 33 is located at the discharge position as the second C position that is the second position by the nozzle moving mechanism 35, the real image capturing the component to be searched may be a real image obtained by imaging by the camera CM at the timing when the nozzle 33 is located at the discharge position by the nozzle moving mechanism 35.

Here, calculation processing of a numerical value indicating the matching degree between the real shape information and the reference shape information for one first virtual camera position P11 in the first calculation unit 6113 will be described with a specific example.

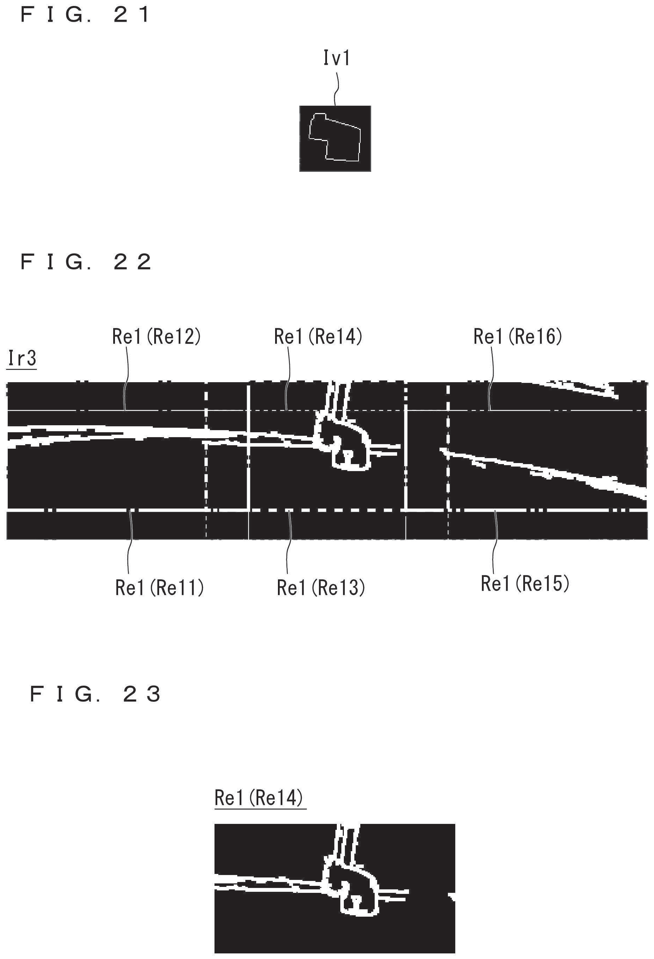

FIGS. 21 to 25 are views for describing a specific example of the calculation processing of the numerical value indicating the matching degree between the real shape information and the reference shape information for one first virtual camera position P11.

FIG. 21 illustrates an example of the reference image Iv1 as the reference shape information for one first virtual camera position P11. For example, the first calculation unit 6113 calculates the numerical value indicating the matching degree of the two-dimensional shape of the contour between the reference image Iv1 as the reference shape information acquired by the first shape information acquisition unit 6112 and the edge image Ir3 (FIG. 9) as the real shape information acquired by the image processing unit 59.

When the numerical value indicating the matching degree between the edge image as the real shape information and the reference image as the reference shape information is calculated for each first virtual camera position P11, the first calculation unit 6113 performs, for example, [processing 1a] processing of detecting a deviation amount of the direction of the two-dimensional shape of the contour corresponding to the deviation of the roll angle γ between the edge image and the reference image, [processing 1b] processing of rotating the edge image according to the deviation of the roll angle γ, and [processing 1c] processing of detecting a position of a region having a maximum matching degree with the reference image targeted for the rotated edge image, in this order.

In the processing 1a, for example, the first calculation unit 6113 detects a deviation amount in the direction of the two-dimensional shape of the contour between the edge image as the real shape information and the reference image as the reference shape information using a rotation-invariant phase-only correlation (RIPOC) method. The deviation amount in the direction of the two-dimensional shape of the contour is the deviation amount in the rotation direction of the contour on the image. Here, for example, as illustrated in FIG. 22, the first calculation unit 6113 divides the edge image Ir3 as the real shape information input from the image processing unit 59 into a plurality of comparison target regions Re1, and calculates, for each of the comparison target regions Re1, a deviation amount γ1 in the rotation direction in which the matching degree of the contour can be the highest with the reference image as the reference shape information using the RIPOC method. The deviation amount γ1 corresponds to the roll angle γ at which the matching degree between the reference image as the reference shape information and the edge image as the real shape information can be further increased.

The size of each comparison target region Re1 is set to, for example, one time or more and several times or less (for example, three times) in each of the longitudinal direction and the lateral direction based on the size of the reference image as the reference shape information. In addition, the plurality of comparison target regions Re1 is set so as to partially overlap each other in the adjacent comparison target regions Re1. In the example of FIG. 22, six comparison target regions Re1 are set in the edge image Ir3. In FIG. 22, the outer edge of the first comparison target region Re11, which is the first comparison target region Re1, is indicated by a thick one-dot chain line. The outer edge of the second comparison target region Re12, which is the second comparison target region Re1, is indicated by a thin one-dot chain line. The outer edge of the third comparison target region Re13, which is the third comparison target region Re1, is indicated by a thick broken line. The outer edge of the fourth comparison target region Re14, which is the fourth comparison target region Re1, is indicated by a thin broken line. The outer edge of the fifth comparison target region Re15, which is the fifth comparison target region Re1, is indicated by a thick two-dot chain line. The outer edge of the sixth comparison target region Re16, which is the sixth comparison target region Re1, is indicated by a thin two-dot chain line. Here, the first calculation unit 6113 detects, among the plurality of comparison target regions Re1, one comparison target region Re1 in which the matching degree of the contour can be the highest with the reference image as the reference shape information, and the deviation amount γ1 in the rotation direction in which the matching degree of the contour can be the highest between the one comparison target region Re1 and the reference image as the reference shape information.

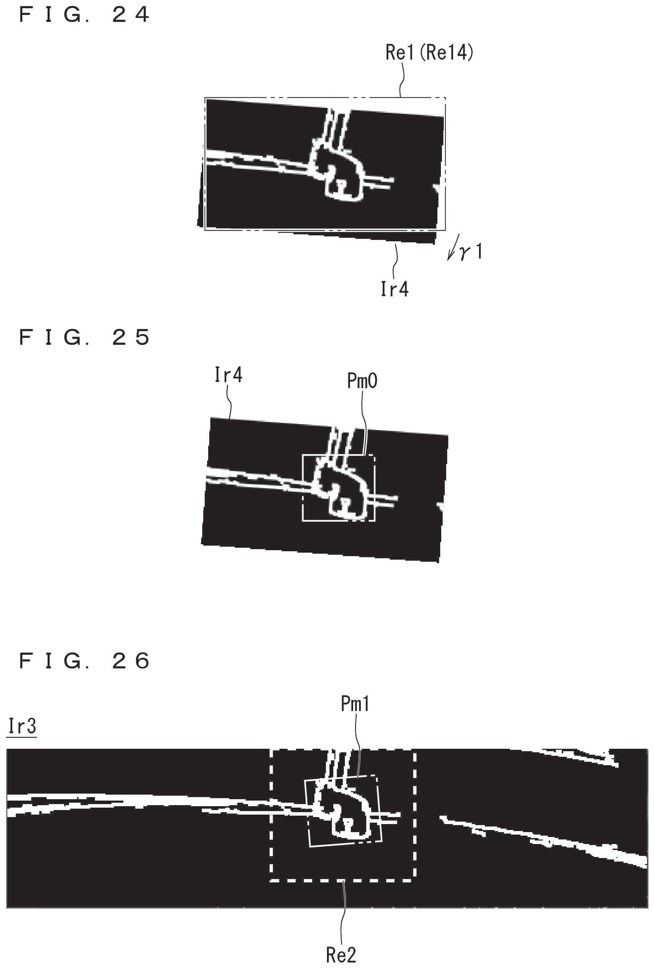

In the processing 1b, for example, the first calculation unit 6113 rotates the edge image as the real shape information so as to correct the deviation amount γ1 detected in the processing 1a. As a result, the rotated edge image is generated, and the orientation is matched between the two-dimensional shape of the contour in the edge image as the real shape information and the two-dimensional shape of the contour in the reference image as the reference shape information. Here, for example, the first calculation unit 6113 rotates the edge image of the comparison target region Re1 detected in the processing 1a so as to correct the deviation amount γ1 detected in the processing 1a. As a result, the rotated edge image is generated, and the orientation is matched between the two-dimensional shape of the contour in the comparison target region Re1 constituting the real shape information and the two-dimensional shape of the contour in the reference image as the reference shape information. FIGS. 23 and 24 illustrate, for example, a state in which the edge image of the fourth comparison target region Re14, which is the fourth comparison target region Re1 illustrated in FIG. 23, is rotated by the deviation amount γ1 to generate the rotated edge image Ir4 illustrated in FIG. 24. In FIG. 24, the outer edge of the edge image of the fourth comparison target region Re14 before rotation is schematically illustrated by a thin two-dot chain line.

In the processing 1c, for example, the first calculation unit 6113 performs template matching using the reference image as the reference shape information on the rotated edge image related to the real shape information generated in the processing 1b. Here, for example, the first calculation unit 6113 scans the reference image in the rotated edge image, and detects the position of a region where the matching degree (similarity) between each partial region in the rotated edge image and the reference image becomes maximum. As a result, in the edge image as the real shape information, a position (also referred to as a matching candidate position) of a region where the matching degree with the two-dimensional shape of the contour of the 3D model 3dm of the component to be searched in the reference image as the reference shape information becomes maximum can be detected.

Here, although the matching degree is not particularly limited, for example, the matching degree of the reference image with respect to a partial region of the rotated edge image in a case where each partial region of the rotated edge image and the reference image are superimposed is adopted as the matching degree. This matching degree (similarity) may be expressed using, for example, a known score (also referred to as a matching score) indicating the matching degree (similarity) such as a sum of squared differences of pixel values, a sum of absolute differences of pixel values, normalized cross-correlation, or zero mean normalized cross-correlation. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the first virtual camera position P11. In other words, for each first virtual camera position P11, the matching degree in a case where the matching degree of the reference image with respect to the partial region in the rotated edge image becomes maximum is set as the matching degree between the edge image as the real shape information and the reference image as the reference shape information.

Here, the numerical value indicating the matching degree may be, for example, a matching score indicating the matching degree. For example, as the matching degree between the edge image as the real shape information and the reference image as the reference shape information increases, the matching score indicating the matching degree may increase, or the matching score indicating the matching degree may decrease. In other words, there are a case where it can be evaluated that the matching degree between the edge image as the real shape information and the reference image as the reference shape information is higher as the matching score indicating the matching degree is larger, and a case where it can be evaluated that the matching degree between the edge image as the real shape information and the reference image as the reference shape information is higher as the matching score indicating the matching degree is smaller. Hereinafter, in a case where no particular condition is described, it is assumed that the matching score indicating the matching degree increases as the matching degree between the edge image as the real shape information and the reference image as the reference shape information increases. In FIG. 25, an outer edge of an example of the matching candidate position Pm0 in the edge image Ir4 is indicated by a thin two-dot chain line.

### <<First Detection Unit 6114>>

Based on the calculation result by the first calculation unit 6113, the first detection unit 6114 detects, among the plurality of first virtual camera positions P11, a virtual camera position with high matching degree which is the first virtual camera position P11 having the highest matching degree between the information (real shape information) on the two-dimensional shape of the object captured in the real image capturing the component to be searched and the reference shape information. More specifically, based on the calculation result by the first calculation unit 6113, the first detection unit 6114 detects a virtual camera position with high matching degree which is the first virtual camera position P11 having the highest matching degree between the real shape information and the reference shape information among the M1×T1 first virtual camera positions P11 as the plurality of first virtual camera positions P11.

Here, for example, among the M1×T1 first virtual camera positions P11 as the plurality of first virtual camera positions P11, the first virtual camera position P11 having the highest matching score calculated between the information (real shape information) on the two-dimensional shape of the object captured in the real image capturing the component to be searched and the reference shape information by the first calculation unit 6113 may be detected as the virtual camera position with high matching degree. In addition, for example, when the virtual camera position with high matching degree is detected, the first detection unit 6114 also detects the matching candidate position detected for the virtual camera position with high matching degree by the first calculation unit 6113 as a target component candidate position.

Here, for example, a case is assumed where one or more initial setting ranges related to the virtual camera position for the component to be searched defined in the setting range information 58 include the first initial setting range for the first position, and it is the timing at which the component to be searched is located at the first position by the moving mechanism. At this timing, the search processing unit 61 can detect, by the first detection unit 6114, the virtual camera position with high matching degree, which is the first virtual camera position P11 having the highest matching degree between the information (real shape information) on the two-dimensional shape of the object captured in the real image capturing the component to be searched and the reference shape information, among the plurality of first virtual camera positions P11 corresponding to the first initial setting range based on the calculation result by the first calculation unit 6113. Here, the real image capturing the component to be searched is a real image obtained by imaging by the camera CM at the timing when the component to be searched is located at the first position by the moving mechanism.

As described above, for example, if the component to be searched at the confirmation required timing is the first chuck, and it is the timing at which the first chuck is located at the open position as the first A position which is the first position by the chuck moving mechanism 17, the real image capturing the component to be searched may be a real image obtained by imaging by the camera CM at the timing when the first chuck is located at the open position by the chuck moving mechanism 17. For example, if the component to be searched at the confirmation required timing is the guard 23, and it is the timing at which the guard 23 is located at the lowered position as the first B position which is the first position by the guard moving mechanism 25, the real image capturing the component to be searched may be a real image obtained by imaging by the camera CM at the timing when the guard 23 is located at the lowered position by the guard moving mechanism 25. For example, if the component to be searched at the confirmation required timing is the nozzle 33, and it is the timing at which the nozzle 33 is located at the standby position as the first C position that is the first position by the nozzle moving mechanism 35, the real image capturing the component to be searched may be a real image obtained by imaging by the camera CM at the timing when the nozzle 33 is located at the standby position by the nozzle moving mechanism 35.

Here, for example, a case is assumed where one or more initial setting ranges related to the virtual camera position for the component to be searched defined by the setting range information 58 include the second initial setting range for the second position, and it is the timing at which the component to be searched is located at the second position by the moving mechanism. At this timing, the search processing unit 61 can detect, by the first detection unit 6114, the virtual camera position with high matching degree, which is the first virtual camera position P11 having the highest matching degree between the information (real shape information) on the two-dimensional shape of the object captured in the real image capturing the component to be searched and the reference shape information, among the plurality of first virtual camera positions P11 corresponding to the second initial setting range based on the calculation result by the first calculation unit 6113. Here, the real image capturing the component to be searched is a real image obtained by imaging by the camera CM at the timing when the component to be searched is located at the second position by the moving mechanism.

As described above, for example, if the component to be searched at the confirmation required timing is the first chuck, and it is the timing at which the first chuck is located at the closed position as the second A position which is the second position by the chuck moving mechanism 17, the real image capturing the component to be searched may be a real image obtained by imaging by the camera CM at the timing when the first chuck is located at the closed position by the chuck moving mechanism 17. For example, if the component to be searched at the confirmation required timing is the guard 23, and it is the timing at which the guard 23 is located at the raised position as the second B position that is the second position by the guard moving mechanism 25, the real image capturing the component to be searched may be a real image obtained by imaging by the camera CM at the timing when the guard 23 is located at the raised position by the guard moving mechanism 25. For example, if the component to be searched at the confirmation required timing is the nozzle 33, and it is the timing at which the nozzle 33 is located at the discharge position as the second C position that is the second position by the nozzle moving mechanism 35, the real image capturing the component to be searched may be a real image obtained by imaging by the camera CM at the timing when the nozzle 33 is located at the discharge position by the nozzle moving mechanism 35.

### <3-2-2-2. Second Search Processing Unit>

The second search processing unit 612 includes, for example, a collation target region setting unit 6121, a divided surface generation unit 6122, a second shape information generation unit 6123, a second calculation unit 6124, and a second detection unit 6125 as a plurality of functional processing units. The collation target region setting unit 6121, the divided surface generation unit 6122, the second shape information generation unit 6123, the second calculation unit 6124, and the second detection unit 6125 are implemented, for example, by the CPU reading and executing the program Pg1 stored in the storage unit 45b in the arithmetic unit 45a. In the second search processing unit 612, for example, the secondary search processing can be implemented by the divided surface generation unit 6122, the second shape information generation unit 6123, the second calculation unit 6124, and the second detection unit 6125.

### <<Collation Target Region Setting Unit 6121>>

The collation target region setting unit 6121 sets a region (also referred to as a collation target region) to be used for matching (collation) processing in the second calculation unit 6124 in the edge image as the real shape information acquired by the contour extraction unit 592 based on the target component candidate position detected by the first detection unit 6114. As a result, the amount of calculation in the processing of the second calculation unit 6124 is reduced, and efficiency of the processing in the second calculation unit 6124 can be improved.

FIG. 26 is a view illustrating a specific example in which a collation target region Re2 is set in the edge image Ir3 as the real shape information acquired by the contour extraction unit 592. As illustrated in FIG. 26, with respect to the edge image Ir3, a region including a target component candidate position Pm1 detected by the first detection unit 6114 and having a size larger than the target component candidate position Pm1 is set as the collation target region Re2. In FIG. 26, the outer edge of the target component candidate position Pm1 is indicated by a thin two-dot chain line, and the outer edge of the collation target region Re2 is indicated by a thick broken line. The size of the collation target region Re2 is set to, for example, more than one time and several times or less (for example, double) in each of the longitudinal direction and the lateral direction based on the size of the target component candidate position Pm1.

### <<Divided Surface Generation Unit 6122>>

The divided surface generation unit 6122 divides, according to a same rule, each of T2 (T2 is a natural number equal to or greater than 2) virtual surfaces St1 including a virtual surface with high matching degree St1m that is a virtual surface in which the virtual camera position with high matching degree detected by the first detection unit 6114 is virtually set and having mutually different distances from the reference point Po of the 3D model 3dm of the component to be searched, among the M1 virtual surfaces St1 in each of the T1 surface aggregations As1. As a result, the divided surface generation unit 6122 generates M2 (M2 is a natural number equal to or greater than 2) virtual surfaces (also referred to as virtual divided surfaces) for each of the T2 virtual surfaces St1, thereby generating M2×T2 virtual divided surfaces. Here, each of the T2 virtual surfaces St1 intersects a line passing through the reference point Po and the virtual camera position with high matching degree P11m on a side of the virtual camera position with high matching degree P11m with respect to the reference point Po of the 3D model 3dm of the component to be searched. T2 is, for example, equal to T1. T2 may be, for example, less than T1.

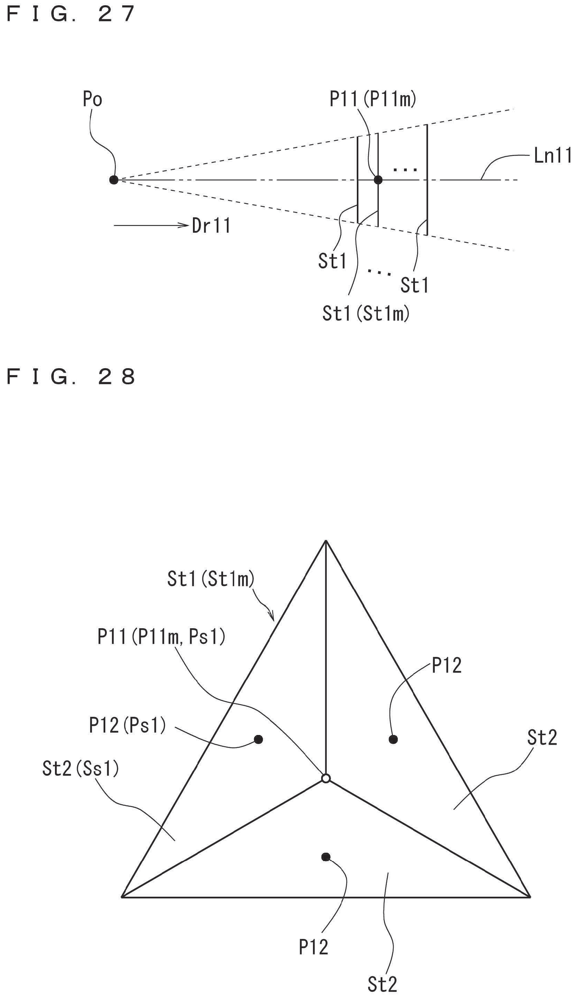

FIG. 27 is an image diagram schematically illustrating an example of the T2 virtual surfaces St1. In FIG. 27, a direction (also referred to as a first direction) Dr11 from the reference point Po of the 3D model 3dm of the target component toward the virtual camera position with high matching degree P11m is indicated by an arrow indicated by a thin line, and a line Ln11 passing through the reference point Po and the virtual camera position with high matching degree P11m is indicated by a thin two-dot chain line. In FIG. 27, a line passing through the reference point Po and passing through the outer edge of each of the T2 virtual surfaces St1 is indicated by a thin broken line. In FIG. 27, three virtual surfaces St1 among the T2 virtual surfaces St1 are illustrated for convenience, and illustration of the other virtual surfaces St1 is omitted. As illustrated in FIG. 27, each of the T2 virtual surfaces St1 intersects with a portion of the line Ln11 located closer to the virtual camera position with high matching degree P11m than the reference point Po. Here, the T2 virtual surfaces St1 have similar shapes enlarged and reduced in a radial direction with respect to the reference point Po of the 3D model 3dm of the component to be searched.

Here, the same rule related to the division of the T2 virtual surfaces St1 may be a rule of dividing each of the T2 virtual surfaces St1 in the same shape as viewed from the reference point Po of the 3D model 3dm of the component to be searched. In other words, the same rule related to the division of the T2 virtual surfaces St1 may be a rule of dividing each of the T2 virtual surfaces St1 by a line having a similar shape enlarged and reduced in the radial direction around the reference point Po when viewed from the reference point Po of the 3D model 3dm of the component to be searched. In other words, the same rule related to the division of the T2 virtual surfaces St1 may be a rule of dividing the T2 virtual surfaces St1 such that T2 divided virtual surfaces having the same shape are generated for each of the M2 virtual divided surfaces between the T2 virtual surfaces St1 as viewed from the reference point Po of the 3D model 3dm of the component to be searched. As a result, in the T2 virtual surfaces St1, for each of the M2 virtual divided surfaces, there are T2 virtual divided surfaces having similar shapes enlarged and reduced in the radial direction around the reference point Po of the 3D model 3dm of the target component. If the same rule related to the division of the T2 virtual surfaces St1 is, for example, a rule of dividing a surface to be divided (also referred to as a division target surface) into a plurality of surfaces by a plurality of line segments respectively connecting a center point of the division target surface and all vertices of the division target surface, the division target surface can be easily divided. If each of the T2 virtual surfaces St1 is a triangular surface, M2 may be three.

FIG. 28 is a view schematically illustrating a specific example in which a virtual surface with high matching degree St1m among the T2 virtual surfaces St1 is divided into a plurality of virtual divided surfaces St2. FIG. 28 illustrates a specific example of a case where each of the plurality of virtual surfaces St1 constituting the surface aggregation As1 is a triangular surface as illustrated in FIG. 19. In FIG. 28, the virtual camera position with high matching degree P11m is indicated by a white circle. As illustrated in FIG. 28, the divided surface generation unit 6122 divides the virtual surface with high matching degree St1m into three virtual divided surfaces St2 as M2 virtual divided surfaces St2 by, for example, three line segments connecting each of three vertices in the virtual surface with high matching degree St1m and the virtual camera position with high matching degree P11m. As a result, the virtual surface St1 can be easily divided. In this case, the divided surface generation unit 6122 divides each of the T2 virtual surfaces St1 into three virtual divided surfaces St2 by three line segments connecting each of three vertices and the first virtual camera position P11, similarly to the virtual surface with high matching degree St1m illustrated in FIG. 28. As a result, each of the T2 virtual surfaces St1 is divided into three triangular virtual divided surfaces St2.

### <<Second Shape Information Generation Unit 6123>>

The second shape information generation unit 6123 generates the reference shape information for each of M2×T2 second virtual camera positions P12 assuming a case where the 3D model 3dm of the component to be searched is imaged from each of the M2×T2 second virtual camera positions P12 as the plurality of second virtual camera positions P12 based on the three-dimensional design information regarding the component to be searched stored in the storage unit 45b, or the like. The M2×T2 second virtual camera positions P12 are M2×T2 virtual camera positions set by virtually setting one virtual camera position for each of the M2×T2 virtual divided surfaces St2 generated by the divided surface generation unit 6122. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the second virtual camera position P12. The virtual image can be generated, for example, by projecting the 3D model 3dm onto a virtual plane by processing such as rendering.

For example, the second shape information generation unit 6123 virtually sets the second virtual camera position P12 at a predetermined position of the virtual divided surface St2 in each virtual divided surface St2. For example, the position of the center of the virtual divided surface St2 is adopted as the predetermined position. For example, the center of gravity of the virtual divided surface St2 is adopted as the center of the virtual divided surface St2. For example, as illustrated in FIG. 28, the second virtual camera position P12 is set at a predetermined position of each of M2 virtual divided surfaces St2 generated by dividing the virtual surface with high matching degree St1m among the T2 virtual surfaces St1. In FIG. 28, the second virtual camera position P12 is indicated by a black circle. In this case, for example, also in each of the M2×T2 virtual divided surfaces St2 generated by dividing each of the T2 virtual surfaces St1, similarly to the M2 virtual divided surfaces St2 generated by dividing the virtual surface with high matching degree St1m illustrated in FIG. 28, the second virtual camera position P12 is virtually set at the predetermined position of the virtual divided surface St2.

When the reference shape information is generated for each of the second virtual camera positions P12, the second shape information generation unit 6123 sets an imaging direction by a virtual camera that images the 3D model 3dm of the component to be searched from the second virtual camera position P12 to a direction from the second virtual camera position P12 toward the reference point Po of the 3D model 3dm of the component to be searched. Furthermore, in this event, the second shape information generation unit 6123 sets the roll angle γ that defines the posture of the virtual camera that images the 3D model 3dm of the component to be searched from the second virtual camera position P12 to, for example, zero (0) degrees. Here, for each second virtual camera position P12, for example, a reference image Iv1 as the reference shape information as schematically illustrated in FIG. 11 is generated.

### <<Second Calculation Unit 6124>>

The second calculation unit 6124 calculates, for each of the M2×T2 second virtual camera positions P12, a numerical value indicating the matching degree between the information (real shape information) on the two-dimensional shape of the object captured in the real image capturing the component to be searched and the reference shape information.

As described above, in the first embodiment, the second virtual camera position P12 is set to each of the plurality of virtual divided surfaces St2 generated by dividing each of the plurality of virtual surfaces St1 including the virtual surface with high matching degree St1m, which is the virtual surface St1 to which the virtual camera position with high matching degree P11m detected by the first detection unit 6114 among the M1×T1 virtual surfaces St1 is set, and the numerical value indicating the matching degree between the real shape information and the reference shape information is calculated for each second virtual camera position P12. For this reason, the plurality of virtual surfaces St1 including the virtual surface with high matching degree St1m and the plurality of virtual divided surfaces St2 are not irrelevant surfaces, and increase in at least one of the number or the area of the plurality of virtual divided surfaces St2 can be reduced. As a result, the amount of calculation for recognizing the posture of the component to be searched captured in the real image can be reduced. As a result, the substrate processing apparatus 1 can efficiently recognize the posture of the component to be searched.

Here, calculation processing of a numerical value indicating the matching degree between the real shape information and the reference shape information for one second virtual camera position P12 in the second calculation unit 6124 will be described with a specific example.

A specific example of the calculation processing of the numerical value indicating the matching degree between the real shape information and the reference shape information for one second virtual camera position P12 in the second calculation unit 6124 can be similar to the specific example of the calculation processing of the numerical value indicating the matching degree between the real shape information and the reference shape information for one first virtual camera position P11 in the first calculation unit 6113 described above. However, for example, the second calculation unit 6124 calculates a numerical value indicating the matching degree of the two-dimensional shape of the contour between the reference image as the reference shape information acquired by the second shape information generation unit 6123 and the collation target region Re2 (FIG. 26) set in the edge image as the real shape information by the collation target region setting unit 6121.

When the numerical value indicating the matching degree between the edge image as the real shape information and the reference image as the reference shape information is calculated for each of the second virtual camera positions P12, the second calculation unit 6124 performs, for example, [processing 2a] processing of detecting a deviation amount of the direction of the two-dimensional shape of the contour corresponding to the deviation of the roll angle γ between the edge image and the reference image, [processing 2b] processing of rotating the edge image according to the deviation of the roll angle γ, and [processing 2c] processing of detecting a position of a region having the maximum matching degree with the reference image for the rotated edge image in this order.

In the processing 2a, similarly to the processing 1a, for example, the second calculation unit 6124 detects the deviation amount in the direction of the two-dimensional shape of the contour using the RIPOC method between the edge image as the real shape information and the reference image as the reference shape information. The deviation amount in the direction of the two-dimensional shape of the contour is the deviation amount in the rotation direction of the contour on the image. Here, the second calculation unit 6124 detects the deviation amount γ2 in the rotation direction in which the matching degree of the contour can be the highest between the collation target region Re2 (FIG. 26) set in the edge image as the real shape information by the collation target region setting unit 6121 and the reference image as the reference shape information using, for example, the RIPOC method. The deviation amount γ2 corresponds to the roll angle γ at which the matching degree between the reference image as the reference shape information and the edge image as the real shape information can be further increased.

In the processing 2b, similarly to the processing 1b, for example, the second calculation unit 6124 rotates the edge image as the real shape information so as to correct the deviation amount γ2 detected in the processing 2a. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount γ2 detected in the processing 2a. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2c, similarly to the processing 1c, for example, the second calculation unit 6124 performs template matching using the reference image as the reference shape information for the rotated edge image related to the real shape information generated in the processing 2b. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, a position (matching candidate position) of a region having the maximum matching degree with the two-dimensional shape of the contour of the 3D model 3dm of the component to be searched in the reference image as the reference shape information can be detected.

Here, although the matching degree is not particularly limited, for example, the matching degree of the reference image with respect to a partial region of the rotated edge image in a case where each partial region of the rotated edge image and the reference image are superimposed is adopted as the matching degree. For example, as described above, the matching degree (similarity) may be expressed using a known score (matching score) indicating the matching degree (similarity) such as a sum of squares of differences of pixel values, a sum of absolute values of differences of pixel values, normalized cross-correlation, or zero-mean normalized cross-correlation. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the second virtual camera position P12. In other words, for each second virtual camera position P12, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<Second Detection Unit 6125>>

The second detection unit 6125 detects a virtual camera position having the highest matching degree between the information (real shape information) on the two-dimensional shape of the object captured in the real image obtained by capturing the component to be searched and the reference shape information, among the virtual camera position with high matching degree P11m detected by the first detection unit 6114 and the above-described M2×T2 second virtual camera positions P12.

Here, for example, the matching score calculated for the virtual camera position with high matching degree P11m by the first calculation unit 6113 and the matching score calculated for each of the M2×T2 second virtual camera positions P12 by the second calculation unit 6124 are compared. Then, for example, among the virtual camera position with high matching degree P11m and the M2×T2 second virtual camera positions P12, the virtual camera position at which the matching score calculated between the information (real shape information) on the two-dimensional shape of the object captured in the real image capturing the component to be searched and the reference shape information is the highest is detected.

Here, the virtual camera position detected by the second detection unit 6125 is the virtual camera position detected first by the second detection unit 6125 in the search processing for the component to be searched. In the present specification, the X-th (X is a natural number) means the X-th when the search processing is performed for one component to be searched. In the first embodiment, the virtual camera position detected first by the second detection unit 6125 is, for example, a first reference virtual camera position to be described later. Then, in the first embodiment, the search processing unit 61 searches for the virtual camera position with the maximum matching degree based on the virtual camera position detected by the second detection unit 6125, by the second search processing unit 612.

### <3-2-2-3. Repetition of Unit Processing>

For example, the search processing unit 61 executes one or more times of n-th unit processing (n is a natural number equal to or greater than 2) after executing first unit processing for the component to be searched, by the second search processing unit 612.

The unit processing means specific processing in a case where the same or similar specific processing is repeated two or more times. In the first embodiment, the first unit processing and the n-th unit processing are similar processing, and the n-th unit processing of each time is substantially the same processing. Here, the first unit processing means the first time of the unit processing in two or more times of the unit processing. A variable n which is a natural number equal to or greater than 2 in the n-th unit processing indicates the number of times the unit processing is being performed. In other words, the n-th unit processing means the n-th time of the unit processing in two or more times of the unit processing. For example, if the variable n is 2, the n-th unit processing means the second unit processing that is the second time of the unit processing. From another point of view, when one or more times of the n-th unit processing are executed, the variable n which is a natural number equal to or greater than 2 is set to 2 as an initial value, and each time the n-th unit processing is executed, 1 is added to the variable n to perform the next n-th unit processing. Then, that the search processing unit 61 executes one or more times of the n-th unit processing after executing the first unit processing means that, for example, the search processing unit 61 sequentially executes the first unit processing, the second unit processing, and .... For example, that the search processing unit 61 executes one time of the n-th unit processing after executing the first unit processing means that the search processing unit 61 sequentially executes the first unit processing and the second unit processing. That the search processing unit 61 executes two times of the n-th unit processing after executing the first unit processing means that the search processing unit 61 sequentially executes the first unit processing, the second unit processing, and the third unit processing.

For example, the first unit processing is started in response to the virtual camera position being detected first by the second detection unit 6125 when the secondary search processing for the component to be searched is performed in the search processing unit 61.

Here, the search processing unit 61 sequentially performs the following first A processing, the following first B processing, the following first C processing, and the following first D processing in the first unit processing by the second search processing unit 612. In addition, in the n-th unit processing, the search processing unit 61 sequentially performs the following n-th A processing, the following n-th B processing, the following n-th C processing, and the following n-th D processing by the second search processing unit 612.

### <<First A Processing>>

The first A processing is processing in which the divided surface generation unit 6122 generates first M3×T3 (M3 and T3 are each a natural number equal to or greater than 2) virtual divided surfaces. In this processing, the divided surface generation unit 6122 divides each of T3 virtual divided surfaces (also referred to as first T3 virtual divided surfaces), which are a plurality of virtual divided surfaces generated by dividing each of the T2 virtual surfaces St1, according to the same rule. As a result, the divided surface generation unit 6122 generates M3 virtual divided surfaces (also referred to as first M3 virtual divided surfaces) for each of the first T3 virtual divided surfaces, thereby generating first M3×T3 virtual divided surfaces. Here, the first T3 virtual divided surfaces include a virtual divided surface (also referred to as a first reference virtual divided surface) including a first reference virtual camera position that is a virtual camera position detected first by the second detection unit 6125, and having mutually different distances from the reference point Po of the 3D model 3dm of the component to be searched. Furthermore, the first T3 virtual divided surfaces are a plurality of virtual divided surfaces intersecting a line passing through the reference point Po and the first reference virtual camera position on a side of the first reference virtual camera position with respect to the reference point Po of the 3D model 3dm of the component to be searched. T3 is, for example, equal to T2. T3 may be, for example, less than T2.

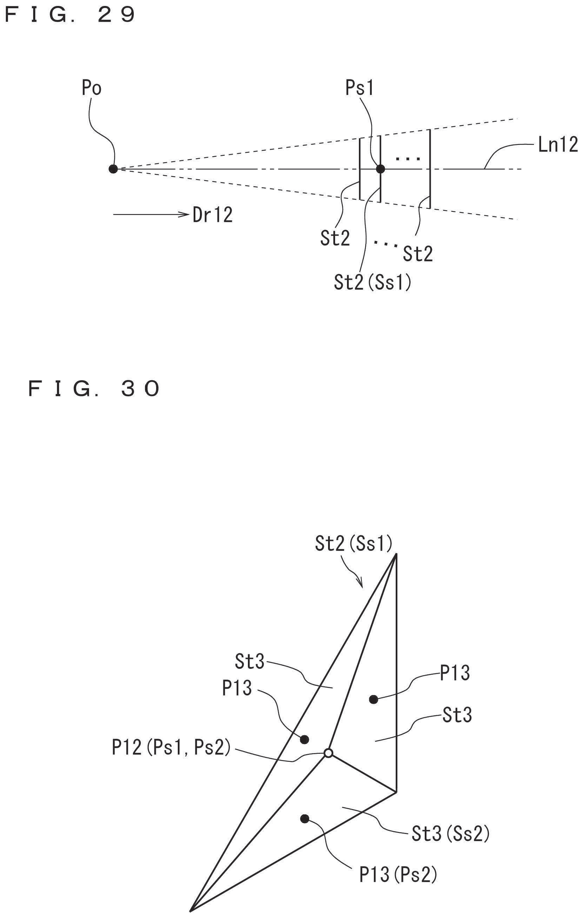

FIG. 29 is an image diagram schematically illustrating an example of the first T3 virtual divided surfaces St2. In FIG. 29, a direction (also referred to as a second direction) Dr12 from the reference point Po of the 3D model 3dm of the component to be searched toward the first reference virtual camera position Ps1 is indicated by a thin arrow, and a line Ln12 passing through the reference point Po and the first reference virtual camera position Ps1 is indicated by a thin two-dot chain line. In FIG. 29, a line passing through the reference point Po and passing through the outer edge of each of the first T3 virtual divided surfaces St2 is indicated by a thin broken line. In FIG. 29, for convenience, three virtual divided surfaces St2 among the first T3 virtual divided surfaces St2 are illustrated, and illustration of the other virtual divided surfaces St2 is omitted. As illustrated in FIG. 29, each of the first T3 virtual divided surfaces St2 intersects with a portion of the line Ln12 located closer to the first reference virtual camera position Ps1 than the reference point Po. Here, the first T3 virtual divided surfaces St2 have similar shapes enlarged and reduced in the radial direction around the reference point Po of the 3D model 3dm of the component to be searched.

Here, the same rule related to the division of the first T3 virtual divided surfaces St2 may be a rule of dividing each of the first T3 virtual divided surfaces St2 in the same shape as viewed from the reference point Po of the 3D model 3dm of the component to be searched. In other words, the same rule related to the division of the first T3 virtual divided surfaces St2 may be a rule of dividing each of the first T3 virtual divided surfaces St2 by a line having a similar shape enlarged and reduced in the radial direction around the reference point Po when viewed from the reference point Po of the 3D model 3dm of the component to be searched. In other words, the same rule related to the division of the first T3 virtual divided surfaces St2 may be a rule of dividing the first T3 virtual divided surfaces St2 such that T3 divided virtual surfaces having the same shape are generated for each of the M3 virtual divided surfaces between the first T3 virtual divided surfaces St2 as viewed from the reference point Po of the 3D model 3dm of the component to be searched. As a result, in the first T3 virtual divided surfaces St2, for each of the M3 virtual divided surfaces, there are T3 virtual divided surfaces having similar shapes enlarged and reduced in the radial direction around the reference point Po of the 3D model 3dm of the component to be searched. If the same rule related to the division of the first T3 virtual divided surfaces St2 is, for example, a rule of dividing a division target surface into a plurality of surfaces by a plurality of line segments respectively connecting a center point of the division target surface to be divided and all vertices of the division target surface, the division target surface can be easily divided. M3 may be, for example, equal to M2. If each of the first T3 virtual divided surfaces St2 is a triangular surface, M3 may be three.

In the first A processing, the method of generating the first M3×T3 virtual divided surfaces is different according to the virtual camera position (first reference virtual camera position) Ps1 detected first by the second detection unit 6125. More specifically, in a case where the first reference virtual camera position Ps1 is the second virtual camera position P12 of any one of the M2×T2 second virtual camera positions P12 described above (also referred to as a first first case), and in a case where the first reference virtual camera position Ps1 is the virtual camera position with high matching degree P11m detected by the first detection unit 6114 (also referred to as a first second case), the first M3×T3 virtual divided surfaces are generated using different methods.

### <<<First First Case>>>

In a case where the second detection unit 6125 detects any one of the above-described M2×T2 second virtual camera positions P12 as the first reference virtual camera position Ps1, the matching degree between the information (real shape information) on the two-dimensional shape of the object captured in the real image capturing the component to be searched and the reference shape information is higher for any one of the above-described M2×T2 second virtual camera positions P12 than the virtual camera position with high matching degree P11m.

In other words, the matching degree between the real shape information and the reference shape information for any one of the M2×T2 second virtual camera positions P12 calculated by the second calculation unit 6124 in the secondary search processing is higher than the matching degree between the real shape information and the reference shape information for the virtual camera position with high matching degree P11m calculated by the first calculation unit 6113 in the primary search processing.

Thus, among the M2×T2 second virtual camera positions P12 described above, the divided surface generation unit 6122 sets the second virtual camera position P12 having the highest matching degree between the information (real shape information) on the two-dimensional shape of the object captured in the real image capturing the component to be searched and the reference shape information as the first reference virtual camera position Ps1 which is a reference for next dividing the virtual surface, and generates the first M3×T3 virtual divided surfaces. As a result, for example, in the secondary search processing, a virtual camera position at which the matching degree between the reference shape information and the real shape information becomes higher can be searched for.

Here, the divided surface generation unit 6122 divides each of the first T3 virtual divided surfaces St2 including the virtual divided surface (first reference virtual divided surface) including the first reference virtual camera position Ps1 among the M2×T2 virtual divided surfaces St2 described above and having mutually different distances from the reference point Po of the 3D model 3dm of the component to be searched according to the same rule. As a result, the divided surface generation unit 6122 generates the first M3×T3 virtual divided surfaces by generating the first M3 virtual divided surfaces, which are the M3 virtual divided surfaces, for each of the first T3 virtual divided surfaces St2. The first T3 virtual divided surfaces St2 are a plurality of virtual divided surfaces St2 intersecting a line Ln12 passing through the reference point Po and the first reference virtual camera position Ps1 on the side of the first reference virtual camera position Ps1 with respect to the reference point Po of the 3D model 3dm of the component to be searched.

Here, the same rule related to the division of the first T3 virtual divided surfaces St2 may be, for example, a rule of dividing the division target surface into a plurality of surfaces by a plurality of line segments respectively connecting a center point of the division target surface to be divided and all vertices of the division target surface as described above. For example, if each of the first T3 virtual divided surfaces St2 is a triangle, each of the first T3 virtual divided surfaces St2 may be divided into three virtual divided surfaces which are M3 virtual divided surfaces by three line segments connecting each of three vertices and the second virtual camera position P12. By this means, each of the first T3 virtual divided surfaces St2 can be divided into three triangular virtual divided surfaces. As a result, the first M3×T3 virtual divided surfaces as the M3×T3 virtual divided surfaces are generated.

Here, for example, a case is assumed where one second virtual camera position P12 on the upper left among the three second virtual camera positions P12 in FIG. 28 is detected as the first reference virtual camera position Ps1. In this case, as illustrated in FIG. 28, the virtual divided surface St2 including the first reference virtual camera position Ps1 among the three virtual divided surfaces St2 generated by dividing the virtual surface St1 is the first reference virtual divided surface Ss1.

FIG. 30 is a view schematically illustrating a specific example in which the first reference virtual divided surface Ss1 among the first T3 virtual divided surfaces St2 is divided into a plurality of virtual divided surfaces St3 in the first first case. FIG. 30 illustrates a specific example of a case where each of the first T3 virtual divided surfaces St2 is a triangular surface. In FIG. 30, the first reference virtual camera position Ps1 is indicated by a white circle. As illustrated in FIG. 30, for example, the divided surface generation unit 6122 divides the first reference virtual divided surface Ss1 into three virtual divided surfaces St3 as the first M3 virtual divided surfaces by three line segments connecting each of three vertices of the first reference virtual divided surface Ss1 and the first reference virtual camera position Ps1. As a result, the first reference virtual divided surface Ss1 can be easily divided. In this case, the divided surface generation unit 6122 divides each of the first T3 virtual divided surfaces St2 into three virtual divided surfaces St3 by three line segments connecting each of three vertices and the second virtual camera position P12, similarly to the first reference virtual divided surface Ss1 illustrated in FIG. 30. As a result, each of the first T3 virtual divided surfaces St2 is divided into three triangular virtual divided surfaces St3 as the first M3 virtual divided surfaces.

### <<<First Second Case>>>

In a case where the virtual camera position with high matching degree P11m is detected as the first reference virtual camera position Ps1 by the second detection unit 6125, the matching degree between the information (real shape information) on the two-dimensional shape of the object captured in the real image capturing the component to be searched and the reference shape information is higher for the virtual camera position with high matching degree P11m than any of the above-described M2×T2 second virtual camera positions P12.

In other words, the matching degree between the real shape information and the reference shape information for all of the M2×T2 second virtual camera positions P12 calculated by the second calculation unit 6124 in the secondary search processing is lower than the matching degree between the real shape information and the reference shape information for the virtual camera position with high matching degree P11m calculated by the first calculation unit 6113 in the primary search processing.

Thus, the divided surface generation unit 6122 generates the first M3×T3 virtual divided surfaces St3 using the virtual camera position with high matching degree P11m as the first reference virtual camera position Ps1 that is a reference for next division of the virtual surface. As a result, for example, in the secondary search processing, a virtual camera position at which the matching degree between the reference shape information and the real shape information becomes higher can be searched for.

Here, the divided surface generation unit 6122 divides each of the first T3 virtual divided surfaces including the virtual divided surface (first reference virtual divided surface) including the first reference virtual camera position Ps1 that is the same as the virtual camera position with high matching degree P11m and having mutually different distances from the reference point Po of the 3D model 3dm of the component to be searched according to the same rule. As a result, the divided surface generation unit 6122 generates the first M3×T3 virtual divided surfaces by generating the first M3 virtual divided surfaces as M3 virtual divided surfaces for each of the first T3 virtual divided surfaces. The first T3 virtual divided surfaces are a plurality of virtual divided surfaces intersecting a line Ln12 passing through the reference point Po and the first reference virtual camera position Ps1 on the side of the first reference virtual camera position Ps1 with respect to the reference point Po of the 3D model 3dm of the component to be searched.

Here, the first reference virtual divided surface is set according to a predetermined rule. For example, among M4 (M4 is a natural number equal to or greater than 2) virtual divided surfaces generated by dividing the virtual surface with high matching degree St1m, a virtual divided surface including the virtual camera position with high matching degree P11m as the first reference virtual camera position Ps1 is set as the first reference virtual divided surface. Here, each of the M4 virtual divided surfaces is a surface generated by dividing the virtual surface St1, and thus, each of the M4 virtual divided surfaces is a reset virtual divided surface St2. For example, if the virtual surface St1 is a triangular surface, as a predetermined rule for setting the first reference virtual divided surface, a rule for setting one virtual divided surface including the virtual camera position with high matching degree P11m among four triangular virtual divided surfaces generated by dividing the virtual surface with high matching degree St1m by three line segments respectively connecting midpoints of respective sides as the first reference virtual divided surface Ss1 is considered. Here, the midpoint of each side may be, for example, a point slightly shifted from the midpoint of each side.

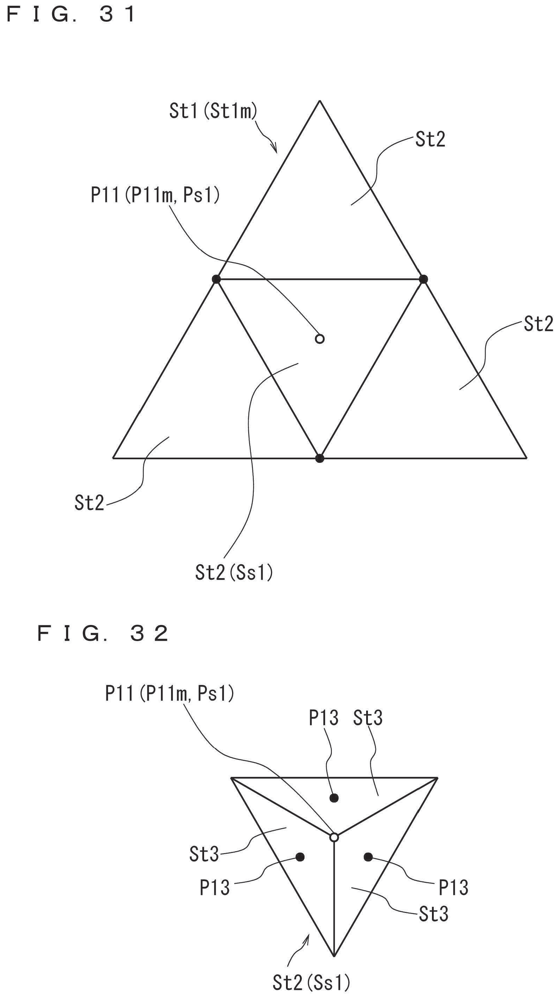

FIG. 31 is a view schematically illustrating a specific example in which the first reference virtual divided surface Ss1 is set in the first second case. FIG. 31 illustrates a specific example of a case where each of the plurality of virtual surfaces St1 is a triangular surface. In FIG. 31, the virtual camera position with high matching degree P11m as the first reference virtual camera position Ps1 is indicated by a white circle. For example, as illustrated in FIG. 31, the virtual surface with high matching degree St1m is divided by three line segments respectively connecting midpoints of respective sides of the virtual surface with high matching degree St1m, so that four triangular virtual divided surfaces St2 as the M4 virtual divided surfaces are generated. Then, among the four triangular virtual divided surfaces St2, a virtual divided surface St2 including the virtual camera position with high matching degree P11m as the first reference virtual camera position Ps1 is set as the first reference virtual divided surface Ss1.

Here, the first T3 virtual divided surfaces including the first reference virtual divided surface Ss1 may be T3 virtual divided surfaces each including the first virtual camera position P11 among M4×T3 virtual divided surfaces generated by dividing each of the T3 virtual surfaces St1 among the T2 virtual surfaces St1 into the M4 virtual divided surfaces according to the same rule as the virtual surface with high matching degree St1m. Also here, each of the M4 virtual divided surfaces in each of the T3 virtual surfaces St1 is a surface generated by dividing each of the T3 virtual surfaces St1, and thus, each of the M4 virtual divided surfaces may be a reset virtual divided surface St2.

In addition, the first T3 virtual divided surfaces St2 including the first reference virtual divided surface Ss1 are a portion of the M4×T3 virtual divided surfaces St2, and have similar shapes enlarged and reduced in the radial direction around the reference point Po of the 3D model 3dm of the component to be searched. The T3 virtual surfaces St1 have a similar shape that is enlarged and reduced with respect to each other in the radial direction around the reference point Po of the 3D model 3dm of the component to be searched. That each of the T3 virtual surfaces St1 is divided into M4 virtual divided surfaces according to the same rule as the virtual surface with high matching degree St1m means that each of the T3 virtual surfaces St1 is divided according to the same rule. The same rule may be a rule of dividing each of the T3 virtual surfaces St1 in the same shape as viewed from the reference point Po of the 3D model 3dm of the component to be searched. In other words, the same rule may be a rule of dividing each of the T3 virtual surfaces St1 by a line having a similar shape enlarged and reduced in the radial direction around the reference point Po when viewed from the reference point Po of the 3D model 3dm of the component to be searched. In other words, the same rule may be a rule for dividing the T3 virtual surfaces St1 such that T3 divided virtual surfaces having the same shape are generated for each of the M4 virtual divided surfaces between the T3 virtual surfaces St1 when viewed from the reference point Po of the 3D model 3dm of the component to be searched.

Here, for example, each of the T3 virtual surfaces St1 may be divided by three line segments respectively connecting midpoints of respective sides, similarly to the virtual surface with high matching degree St1m illustrated in FIG. 31. As a result, each of the T3 virtual surfaces St1 can be divided into four triangular virtual divided surfaces St2. From another point of view, when viewed from the reference point Po of the 3D model 3dm of the target component, each of the T3 virtual surfaces St1 is divided by lines having similar shapes enlarged and reduced in the radial direction around the reference point Po, so that 4×T3 virtual divided surfaces St2 are generated. Then, the first T3 virtual divided surfaces St2 including the first reference virtual divided surface Ss1 are a portion of the 4×T3 virtual divided surfaces St2, and have similar shapes enlarged and reduced in the radial direction around the reference point Po of the 3D model 3dm of the component to be searched.

Here, the same rule related to the division of the first T3 virtual divided surfaces St2 may be, for example, a rule of dividing the division target surface into a plurality of surfaces by a plurality of line segments respectively connecting a center point of the division target surface to be divided and all vertices of the division target surface as described above. For example, if each of the first T3 virtual divided surfaces St2 is a triangle, each of the first T3 virtual divided surfaces St2 may be divided into three virtual divided surfaces which are M3 virtual divided surfaces by three line segments connecting each of three vertices and the first virtual camera position P11. By this means, each of the first T3 virtual divided surfaces St2 can be divided into three triangular virtual divided surfaces. As a result, the first M3×T3 virtual divided surfaces as the M3×T3 virtual divided surfaces are generated.

FIG. 32 is a view schematically illustrating a specific example in which the first reference virtual divided surface Ss1 among the first T3 virtual divided surfaces St2 is divided into a plurality of virtual divided surfaces St3 in the first second case. FIG. 32 illustrates a specific example of a case where each of the first T3 virtual divided surfaces St2 is a triangular surface. In FIG. 32, the virtual camera position with high matching degree P11m as the first reference virtual camera position Ps1 is indicated by a white circle. As illustrated in FIG. 32, for example, the divided surface generation unit 6122 divides the first reference virtual divided surface Ss1 into three virtual divided surfaces St3 as the first M3 virtual divided surfaces by three line segments connecting each of three vertices of the first reference virtual divided surface Ss1 and the first reference virtual camera position Ps1. As a result, the first reference virtual divided surface Ss1 can be easily divided. In this case, the divided surface generation unit 6122 divides each of the first T3 virtual divided surfaces St2 into three virtual divided surfaces St3 by three line segments connecting each of three vertices and the first virtual camera position P11, similarly to the first reference virtual divided surface Ss1 illustrated in FIG. 32. As a result, each of the first T3 virtual divided surfaces St2 is divided into three triangular virtual divided surfaces St3 as the first M3 virtual divided surfaces.

### <<First B Processing>>

The first B processing is processing in which the second shape information generation unit 6123 generates the reference shape information for each of first M3×T3 third virtual camera positions assuming a case where the 3D model 3dm of the component to be searched is imaged from each of the first M3×T3 third virtual camera positions based on the three-dimensional design information regarding the target component stored in the storage unit 45b, or the like. The first M3×T3 third virtual camera positions are M3×T3 virtual camera positions set by virtually setting one virtual camera position for each of the first M3×T3 virtual divided surfaces St3 generated in the first A processing. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the virtual camera position. The virtual image can be generated, for example, by projecting the 3D model 3dm onto a virtual plane by processing such as rendering.

In each of the first M3×T3 virtual divided surfaces St3, for example, the third virtual camera position P13 is virtually set at a predetermined position of the virtual divided surface St3. For example, the position of the center of the virtual divided surface St3 is adopted as the predetermined position. For example, the center of gravity of the virtual divided surface St3 is adopted as the center of the virtual divided surface St3. For example, as illustrated in FIG. 30 or FIG. 32, the third virtual camera position P13 is set on each virtual divided surface St3. If each of the first M3×T3 virtual divided surfaces St3 is a triangular surface, the center of the virtual divided surface St3 may be, for example, the center of gravity or the incenter of the triangle. In FIGS. 30 and 32, the third virtual camera position P13 is indicated by a black circle.

For example, for each of the plurality of third virtual camera positions P13 illustrated in FIG. 30 or FIG. 32, the second shape information generation unit 6123 generates reference shape information about the two-dimensional shape of the 3D model 3dm of the component to be searched in the virtual image that can be acquired by imaging the 3D model 3dm of the component to be searched from the third virtual camera position P13. In this event, the imaging direction by the virtual camera that images the 3D model 3dm of the component to be searched from the third virtual camera position P13 is set to a direction from the third virtual camera position P13 toward the reference point Po of the 3D model 3dm of the component to be searched. The roll angle γ that defines the posture of the virtual camera that images the 3D model 3dm of the component to be searched from the third virtual camera position P13 is set to, for example, zero (0) degrees. Here, for each third virtual camera position P13, for example, a reference image Iv1 as the reference shape information as schematically illustrated in FIG. 11 is generated.

### <<First C Processing>>

The first C processing is processing in which the second calculation unit 6124 calculates, for each of the first M3×T3 third virtual camera positions P13, a numerical value indicating the matching degree between the information (real shape information) on the two-dimensional shape of the object captured in the real image capturing the component to be searched and the reference shape information.

In the first C processing, for example, the second calculation unit 6124 calculates a numerical value indicating the matching degree of the two-dimensional shape of the contour between the reference image as the reference shape information generated by the second shape information generation unit 6123 in the first B processing and the collation target region Re2 (FIG. 26) set in the edge image as the real shape information by the collation target region setting unit 6121.

In the first C processing, when a numerical value indicating the matching degree between the edge image as the real shape information and the reference image as the reference shape information is calculated for each of the third virtual camera positions P13, the second calculation unit 6124 performs, for example, [processing 2a1] processing of detecting a deviation amount of the orientation of the two-dimensional shape of the contour corresponding to the deviation of the roll angle γ between the edge image and the reference image, [processing 2b1] processing of rotating the edge image according to the deviation of the roll angle γ, and [processing 2c1] processing of detecting a position of a region having the maximum matching degree with the reference image for the rotated edge image in this order.

In the processing 2a1, similarly to the processing 2a, for example, the second calculation unit 6124 detects the deviation amount in the direction of the two-dimensional shape of the contour using the RIPOC method between the edge image as the real shape information and the reference image as the reference shape information. The deviation amount in the direction of the two-dimensional shape of the contour is the deviation amount in the rotation direction of the contour on the image. Here, the second calculation unit 6124 detects the deviation amount γ21 in the rotation direction in which the matching degree of the contour can be the highest between the collation target region Re2 (FIG. 26) set in the edge image as the real shape information by the collation target region setting unit 6121 and the reference image as the reference shape information using, for example, the RIPOC method. The deviation amount γ21 corresponds to the roll angle γ at which the matching degree between the reference image as the reference shape information and the edge image as the real shape information can be further increased.

In the processing 2b1, similarly to the processing 2b, for example, the second calculation unit 6124 rotates the edge image as the real shape information so as to correct the deviation amount γ21 detected in the processing 2a1. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount γ21 detected in the processing 2a1. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2c1, similarly to the processing 2c, for example, the second calculation unit 6124 performs template matching using the reference image as the reference shape information for the rotated edge image related to the real shape information generated in the processing 2b1. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, the position (matching candidate position) of the region having the maximum matching degree with the two-dimensional shape of the contour of the 3D model 3dm of the component to be searched in the reference image can be detected. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the third virtual camera position P13. In other words, for each third virtual camera position P13, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<First D Processing>>

The first D processing is processing in which the second detection unit 6125 detects a second reference virtual camera position, which is the virtual camera position having the highest matching degree between the information (real shape information) on the two-dimensional shape of the object captured in the real image capturing the component to be searched and the reference shape information, among the first reference virtual camera position Ps1 and the first M3×T3 third virtual camera positions P13.

Here, for example, the matching score calculated for the first reference virtual camera position Ps1 and the matching score calculated for each of the first M3×T3 third virtual camera positions P13 by the second calculation unit 6124 in the first C processing are compared. Then, for example, among the first reference virtual camera position Ps1 and the first M3×T3 third virtual camera positions P13, the virtual camera position having the highest matching score calculated between the information (real shape information) on the two-dimensional shape of the object captured in the real image capturing the component to be searched and the reference shape information is detected as the second reference virtual camera position.

### <<n-th A Processing>>

The n-th A processing is processing in which the divided surface generation unit 6122 generates n-th M3×T3 virtual divided surfaces. In this processing, the divided surface generation unit 6122 divides each of T3 virtual divided surfaces (also referred to as n-th T3 virtual divided surfaces) generated by dividing each of the (n-1)-th T3 virtual divided surfaces according to the same rule. As a result, the divided surface generation unit 6122 generates M3 virtual divided surfaces (also referred to as n-th M3 virtual divided surfaces) for each of the n-th T3 virtual divided surfaces, thereby generating n-th M3×T3 virtual divided surfaces. Here, the n-th T3 virtual divided surfaces include a virtual divided surface (also referred to as an n-th reference virtual divided surface) including an n-th reference virtual camera position that is a virtual camera position detected n-th by the second detection unit 6125, and having mutually different distances from the reference point Po of the 3D model 3dm of the component to be searched. Furthermore, the n-th T3 virtual divided surfaces are a plurality of virtual divided surfaces intersecting a line passing through the reference point Po and the n-th reference virtual camera position on the side of the n-th reference virtual camera position with respect to the reference point Po of the 3D model 3dm of the component to be searched.

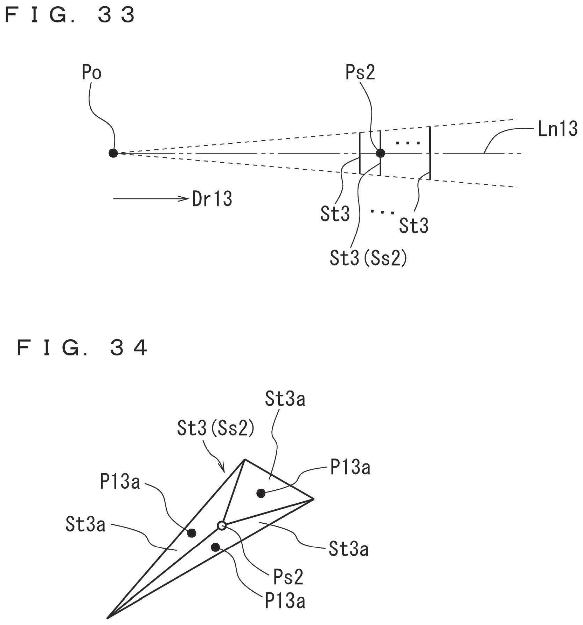

FIG. 33 is an image diagram schematically illustrating an example of second T3 virtual divided surfaces St3 as a specific example of the n-th T3 virtual divided surfaces St3. In FIG. 33, a direction (also referred to as a third direction) Dr13 from the reference point Po of the 3D model 3dm of the component to be searched toward the second reference virtual camera position Ps2 is indicated by a thin arrow, and a line Ln13 passing through the reference point Po and the second reference virtual camera position Ps2 is indicated by a thin two-dot chain line. In FIG. 33, a line passing through the reference point Po and passing through the outer edge of each of the second T3 virtual divided surfaces St3 is indicated by a thin broken line. In FIG. 33, for convenience, three virtual divided surfaces St3 among the second T3 virtual divided surfaces St3 are illustrated, and illustration of the other virtual divided surfaces St3 is omitted. As illustrated in FIG. 33, each of the second T3 virtual divided surfaces St3 intersects with a portion of the line Ln13 located closer to the second reference virtual camera position Ps2 than the reference point Po. Here, the second T3 virtual divided surfaces St3 have similar shapes enlarged and reduced in the radial direction around the reference point Po of the 3D model 3dm of the component to be searched.

Here, the same rule related to the division of the n-th T3 virtual divided surfaces may be a rule of dividing each of the n-th T3 virtual divided surfaces in the same shape when viewed from the reference point Po of the 3D model 3dm of the component to be searched. In other words, the same rule related to the division of the n-th T3 virtual divided surfaces may be a rule of dividing each of the n-th T3 virtual divided surfaces by a line having a similar shape enlarged and reduced in the radial direction around the reference point Po when viewed from the reference point Po of the 3D model 3dm of the component to be searched. In other words, the same rule related to the division of the n-th T3 virtual divided surfaces may be a rule of dividing the n-th T3 virtual divided surfaces such that T3 divided virtual surfaces having the same shape are generated for each of the M3 virtual divided surfaces between the n-th T3 virtual divided surfaces as viewed from the reference point Po of the 3D model 3dm of the component to be searched. The same rule related to the division of the n-th T3 virtual divided surfaces may be, for example, a rule of dividing the division target surface into a plurality of surfaces by a plurality of line segments respectively connecting the center point of the division target surface to be divided and all vertices of the division target surface. As a result, the division target surface can be easily divided.

In this n-th A processing, the method of generating the n-th M3×T3 virtual divided surfaces is different according to the virtual camera position (n-th reference virtual camera position) detected n-th by the second detection unit 6125. More specifically, the method of generating the n-th M3×T3 virtual divided surfaces is different between a case where the n-th reference virtual camera position is any one of the (n-1)-th M3×T3 third virtual camera positions (also referred to as an n-th first case) and a case where the n-th reference virtual camera position is the (n-1)-th reference virtual camera position (also referred to as an n-th second case).

### <<<n-th First Case>>>

In a case where the third virtual camera position of any one of the (n-1)-th M3×T3 third virtual camera positions described above is detected as the n-th reference virtual camera position by the second detection unit 6125, for any one of the (n-1)-th M3×T3 third virtual camera positions described above, the matching degree between the information (real shape information) on the two-dimensional shape of the object captured in the real image capturing the component to be searched and the reference shape information is higher than that for the (n-1)-th reference virtual camera position.

For example, the matching score indicating the matching degree between the real shape information and the reference shape information for any one of the (n-1)-th M3×T3 third virtual camera positions is higher than the matching score indicating the matching degree between the real shape information and the reference shape information for the (n-1)-th reference virtual camera position.

Thus, the divided surface generation unit 6122 generates the n-th M3×T3 virtual divided surfaces, using the third virtual camera position having the highest matching degree between the information (real shape information) on the two-dimensional shape of the object captured in the real image capturing the component to be searched and the reference shape information among the (n-1)-th M3×T3 third virtual camera positions described above, as the n-th reference virtual camera position that is a reference for next dividing the virtual surface. As a result, for example, in the secondary search processing, the virtual camera position at which the matching degree between the reference shape information and the real shape information is further increased can be searched.

Here, the divided surface generation unit 6122 divides each of the n-th T3 virtual divided surfaces including the n-th reference virtual divided surface that is a virtual divided surface including the n-th reference virtual camera position among the (n-1)-th M3×T3 virtual divided surfaces described above and having mutually different distances from the reference point Po of the 3D model 3dm of the component to be searched according to the same rule. As a result, the divided surface generation unit 6122 generates the n-th M3×T3 virtual divided surfaces by generating the n-th M3 virtual divided surfaces as the M3 virtual divided surfaces for each of the n-th T3 virtual divided surfaces. The n-th T3 virtual divided surfaces are a plurality of virtual divided surfaces intersecting a line passing through the reference point Po and the n-th reference virtual camera position on the side of the n-th reference virtual camera position with respect to the reference point Po of the 3D model 3dm of the component to be searched.

Here, the same rule related to the division of the n-th T3 virtual divided surfaces may be, for example, a rule of dividing the division target surface into a plurality of surfaces by a plurality of line segments respectively connecting the center point of the division target surface to be divided and all vertices of the division target surface as described above. For example, if each of the n-th T3 virtual divided surfaces is a triangle, each of the n-th T3 virtual divided surfaces may be divided into three virtual divided surfaces that are the n-th M3 virtual divided surfaces by three line segments connecting each of three vertices and an (n-1)-th third virtual camera position. As a result, each of the n-th T3 virtual divided surfaces can be divided into three triangular virtual divided surfaces. As a result, the n-th M3×T3 virtual divided surfaces as the M3×T3 virtual divided surfaces are generated.

Here, for example, a case is assumed where one third virtual camera position P13 on the lower side among the three third virtual camera positions P13 in FIG. 30 is detected as the second reference virtual camera position Ps2. In this case, as illustrated in FIG. 30, the virtual divided surface St3 including the second reference virtual camera position Ps2 among the three virtual divided surfaces St3 generated by dividing the virtual divided surface St2 is the second reference virtual divided surface Ss2.

FIG. 34 is a view schematically illustrating a specific example in which the second reference virtual divided surface Ss2 among the second T3 virtual divided surfaces St3 is divided into a plurality of virtual divided surfaces St3a in the second first case. FIG. 34 illustrates a specific example of a case where each of the second T3 virtual divided surfaces St3 is a triangular surface. In FIG. 34, the second reference virtual camera position Ps2 is indicated by a white circle. As illustrated in FIG. 34, the divided surface generation unit 6122 divides the second reference virtual divided surface Ss2 into three virtual divided surfaces St3a as second M3 virtual divided surfaces, for example, by three line segments connecting each of three vertices of the second reference virtual divided surface Ss2 and the second reference virtual camera position Ps2. As a result, the second reference virtual divided surface Ss2 can be easily divided. In this case, the divided surface generation unit 6122 divides each of the second T3 virtual divided surfaces St3 into three virtual divided surfaces St3a by three line segments connecting each of three vertices and the third virtual camera position P13, similarly to the second reference virtual divided surface Ss2 illustrated in FIG. 34. As a result, each of the second T3 virtual divided surfaces St3 is divided into three triangular virtual divided surfaces St3a as the second M3 virtual divided surfaces.

### <<<n-th Second Case>>>

In a case where the (n-1)-th reference virtual camera position is detected as the n-th reference virtual camera position by the second detection unit 6125, the matching degree between the information (real shape information) on the two-dimensional shape of the object captured in the real image capturing the component to be searched and the reference shape information is higher for the (n-1)-th reference virtual camera position than any of the (n-1)-th M3×T3 third virtual camera positions described above.

In other words, the matching degree between the real shape information and the reference shape information for all of the (n-1)-th M3×T3 third virtual camera positions calculated by the second calculation unit 6124 in the (n-1)-th unit processing is lower than the matching degree between the real shape information and the reference shape information for the (n-1)-th reference virtual camera position calculated by the first calculation unit 6113 or the second calculation unit 6124.

Thus, the divided surface generation unit 6122 sets the (n-1)-th reference virtual camera position as the n-th reference virtual camera position that is a reference for next dividing the virtual divided surface, and generates the n-th M3×T3 virtual divided surfaces. As a result, for example, in the secondary search processing, the virtual camera position at which the matching degree between the reference shape information and the real shape information is further increased can be searched.

Here, the divided surface generation unit 6122 divides, according to the same rule, each of n-th T3 virtual divided surfaces including a virtual divided surface (n-th reference virtual divided surface) including an n-th reference virtual camera position that is the same as the (n-1)-th reference virtual camera position and having mutually different distances from the reference point Po of the 3D model 3dm of the component to be searched. As a result, the divided surface generation unit 6122 generates the n-th M3×T3 virtual divided surfaces by generating the n-th M3 virtual divided surfaces as the M3 virtual divided surfaces for each of the n-th T3 virtual divided surfaces. The n-th T3 virtual divided surfaces are a plurality of virtual divided surfaces intersecting a line passing through the reference point Po and the n-th reference virtual camera position on the side of the n-th reference virtual camera position with respect to the reference point Po of the 3D model 3dm of the component to be searched.

Here, the n-th reference virtual divided surface is set according to a predetermined rule. For example, in a case where the variable n is 2, a virtual divided surface including the second reference virtual camera position Ps2 that is the same as the first reference virtual camera position Ps1 among the M4 virtual divided surfaces generated by dividing the first reference virtual divided surface Ss1 among the M2×T2 virtual divided surfaces St2 is set as the second reference virtual divided surface Ss2. Here, each of the M4 virtual divided surfaces is a surface generated by dividing the virtual divided surface St2, and thus, each of the M4 virtual divided surfaces is a reset virtual divided surface St3. For example, if the virtual divided surface St2 is a triangular surface, as a predetermined rule for setting the second reference virtual divided surface Ss2, a rule for setting one virtual divided surface St3 including the second reference virtual camera position Ps2 among four triangular virtual divided surfaces St3 generated by dividing the first reference virtual divided surface Ss1 by three line segments respectively connecting midpoints of respective sides as the second reference virtual divided surface Ss2 is conceivable. Here, the midpoint of each side may be, for example, a point slightly shifted from the midpoint of each side.

Furthermore, for example, in a case where the variable n is 3 or more, a virtual divided surface including an n-th reference virtual camera position that is the same as the (n-1)-th reference virtual camera position among the M4 virtual divided surfaces generated by dividing the (n-1)-th reference virtual divided surface among the (n-2)-th M3×T3 virtual divided surfaces is set as the n-th reference virtual divided surface. For example, if each of the (n-2)-th M3×T3 virtual divided surfaces is a triangular surface, as a predetermined rule of setting the n-th reference virtual divided surface, a rule of setting a virtual divided surface including the n-th reference virtual camera position among four triangular virtual divided surfaces generated by dividing the (n-1)-th reference virtual divided surface by three line segments respectively connecting midpoints of respective sides as the n-th reference virtual divided surface is conceivable. Here, the midpoint of each side may be, for example, a point slightly shifted from the midpoint of each side.

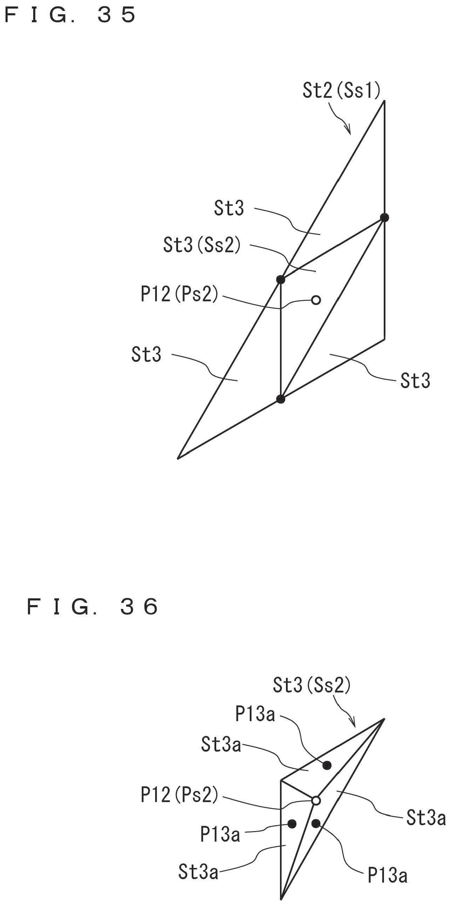

FIG. 35 is a view schematically illustrating a specific example in which the second reference virtual divided surface Ss2 is set in the second second case. FIG. 35 illustrates a specific example of a case where each of the plurality of virtual divided surfaces St2 is a triangular surface. In FIG. 35, the second reference virtual camera position Ps2 is indicated by a white circle. For example, as illustrated in FIG. 35, the first reference virtual divided surface Ss1 is divided by three line segments connecting midpoints of respective sides of the first reference virtual divided surface Ss1, so that four triangular virtual divided surfaces St3 as M4 triangular virtual divided surfaces are generated. Then, among the four triangular virtual divided surfaces St3, a virtual divided surface St3 including the second reference virtual camera position Ps2 is set as the second reference virtual divided surface Ss2.

Here, the second T3 virtual divided surfaces including the second reference virtual divided surface Ss2 may be T3 virtual divided surfaces St3 each including the second virtual camera position P12 among the M4×T3 virtual divided surfaces generated by dividing each of the first T3 virtual divided surfaces St2 according to the same rule as the first reference virtual divided surface Ss1. Also here, each of the M4 virtual divided surfaces in each of the T3 virtual divided surfaces St2 is a surface generated by dividing each of the T3 virtual divided surfaces St2, and thus, each of the M4 virtual divided surfaces may be a reset virtual divided surface St3.

In addition, the second T3 virtual divided surfaces St3 including the second reference virtual divided surface Ss2 are a portion of the M4×T3 virtual divided surfaces St3, and have similar shapes enlarged and reduced in the radial direction around the reference point Po of the 3D model 3dm of the component to be searched. The first T3 virtual divided surfaces St2 have similar shapes enlarged and reduced in the radial direction around the reference point Po of the 3D model 3dm of the component to be searched. That each of the first T3 virtual divided surfaces St2 is divided according to the same rule as the first reference virtual divided surface Ss1 means that each of the first T3 virtual divided surfaces St2 is divided according to the same rule. The same rule may be a rule of dividing each of the first T3 virtual divided surfaces St2 in the same shape as viewed from the reference point Po of the 3D model 3dm of the component to be searched. In other words, the same rule may be a rule of dividing each of the first T3 virtual divided surfaces St2 by a line having a similar shape enlarged and reduced in the radial direction around the reference point Po when viewed from the reference point Po of the 3D model 3dm of the component to be searched. In other words, the same rule may be a rule of dividing the first T3 virtual divided surfaces St2 such that T3 divided virtual surfaces having the same shape are generated for each of the M4 virtual divided surfaces between the first T3 virtual divided surfaces St2 as viewed from the reference point Po of the 3D model 3dm of the component to be searched.

Here, for example, each of the first T3 virtual divided surfaces St2 may be divided by three line segments respectively connecting midpoints of respective sides, similarly to the first reference virtual divided surface Ss1 illustrated in FIG. 35. As a result, each of the first T3 virtual divided surfaces St2 can be divided into four triangular virtual divided surfaces St3. From another point of view, when viewed from the reference point Po of the 3D model 3dm of the component to be searched, each of the first T3 virtual divided surfaces St2 is divided by lines having similar shapes enlarged and reduced in the radial direction around the reference point Po, so that 4 ×T3 virtual divided surfaces St3 are generated. Then, the second T3 virtual divided surfaces St3 including the second reference virtual divided surface Ss2 are a portion of the 4×T3 virtual divided surfaces St3, and have shapes similar to each other enlarged and reduced in the radial direction around the reference point Po of the 3D model 3dm of the component to be searched.

Here, the same rule related to the division of the n-th T3 virtual divided surfaces may be, for example, a rule of dividing the division target surface into a plurality of surfaces by a plurality of line segments respectively connecting the center point of the division target surface to be divided and all vertices of the division target surface as described above. For example, in a case where the variable n is 2, the same rule related to the division of the second T3 virtual divided surfaces St3 may be, for example, a rule of dividing the division target surface into a plurality of surfaces by a plurality of line segments respectively connecting the center point of the division target surface to be divided and all vertices of the division target surface as described above. For example, if each of the second T3 virtual divided surfaces St3 is a triangle, each of the second T3 virtual divided surfaces St3 can be divided into three virtual divided surfaces which are M3 virtual divided surfaces by three line segments connecting the center position (for example, the position of the center of gravity) as a predetermined position and each of three vertices. As a result, each of the second T3 virtual divided surfaces St3 can be divided into three triangular virtual divided surfaces. As a result, the second M3×T3 virtual divided surfaces as the M3×T3 virtual divided surfaces are generated.

FIG. 36 is a view schematically illustrating a specific example in which the second reference virtual divided surface Ss2 among the second T3 virtual divided surfaces St3 is divided into a plurality of virtual divided surfaces St3a in the second second case. FIG. 36 illustrates a specific example of a case where each of the second T3 virtual divided surfaces St3 is a triangular surface. In FIG. 36, the second reference virtual camera position Ps2 is indicated by a white circle. As illustrated in FIG. 36, the divided surface generation unit 6122 divides the second reference virtual divided surface Ss2 into three virtual divided surfaces St3a as the second M3 virtual divided surfaces, for example, by three line segments connecting each of three vertices of the second reference virtual divided surface Ss2 and the second reference virtual camera position Ps2. As a result, the second reference virtual divided surface Ss2 can be easily divided. In this case, the divided surface generation unit 6122 divides each of the second T3 virtual divided surfaces St3 into three virtual divided surfaces St3a by three line segments connecting each of three vertices and the second reference virtual camera position Ps2, similarly to the second reference virtual divided surface Ss2 illustrated in FIG. 36. As a result, each of the second T3 virtual divided surfaces St3 is divided into three triangular virtual divided surfaces St3a as the second M3 virtual divided surfaces.

### <<n-th B Processing>>

The n-th B processing is processing in which the second shape information generation unit 6123 generates the reference shape information for each of the n-th M3×T3 third virtual camera positions assuming a case where the 3D model 3dm of the component to be searched is imaged from each of the n-th M3×T3 third virtual camera positions based on the three-dimensional design information regarding the component to be searched stored in the storage unit 45b, or the like. The n-th M3×T3 third virtual camera positions are M3×T3 virtual camera positions set by virtually setting one virtual camera position for each of the n-th M3×T3 virtual divided surfaces generated in the n-th A processing. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the virtual camera position. The virtual image can be generated, for example, by projecting the 3D model 3dm onto a virtual plane by processing such as rendering.

For each of the n-th M3×T3 virtual divided surfaces, for example, a third virtual camera position (n-th third virtual camera position) is virtually set at a predetermined position on the virtual divided surface. For example, the position of the center of the virtual divided surface is adopted as the predetermined position. For example, the center of gravity of the virtual divided surface is adopted as the center of the virtual divided surface. For example, in a case where the variable n is 2, a third virtual camera position P13a is set on each virtual divided surface St3a as illustrated in FIG. 34 or 36. If each of the n-th M3×T3 virtual divided surfaces is a triangular surface, the center of the virtual divided surface may be, for example, the center of gravity or the incenter of the triangle. In FIGS. 34 and 36, the third virtual camera position P13a is indicated by a black circle.

For example, for each of the n-th M3×T3 third virtual camera positions, the second shape information generation unit 6123 generates reference shape information about the two-dimensional shape of the 3D model 3dm of the component to be searched in the virtual image that can be acquired by imaging the 3D model 3dm of the component to be searched from the third virtual camera position. In this event, the imaging direction by the virtual camera that images the 3D model 3dm of the component to be searched from each third virtual camera position is set to a direction from the third virtual camera position toward the reference point Po of the 3D model 3dm of the component to be searched. The roll angle γ that defines the posture of the virtual camera that images the 3D model 3dm of the component to be searched from the third virtual camera position is set to, for example, zero (0) degrees. Also here, for each third virtual camera position, for example, a reference image Iv1 as the reference shape information as schematically illustrated in FIG. 11 is generated.

### <<n-th C Processing>>

The n-th C processing is processing in which the second calculation unit 6124 calculates, for each of the n-th M3×T3 third virtual camera positions, a numerical value indicating the matching degree between the information (real shape information) on the two-dimensional shape of the object captured in the real image capturing the component to be searched and the reference shape information.

In the n-th C processing, for example, the second calculation unit 6124 calculates a numerical value indicating the matching degree of the two-dimensional shape of the contour between the reference image as the reference shape information acquired by the second shape information generation unit 6123 in the n-th B processing and the collation target region Re2 (FIG. 26) set in the edge image as the real shape information by the collation target region setting unit 6121.

In the n-th C processing, when a numerical value indicating the matching degree between the edge image as the real shape information and the reference image as the reference shape information is calculated for each third virtual camera position, for example, the second calculation unit 6124 performs [processing 2an] processing of detecting a deviation amount in the direction of the two-dimensional shape of the contour corresponding to the deviation of the roll angle γ between the edge image and the reference image, [processing 2bn] processing of rotating the edge image according to the deviation of the roll angle γ, and [processing 2cn] processing of detecting a position of a region having the maximum matching degree with the reference image for the rotated edge image, in this order.

In the processing 2an, similarly to the processing 2a1, for example, the second calculation unit 6124 detects the deviation amount in the direction of the two-dimensional shape of the contour between the edge image as the real shape information and the reference image as the reference shape information using the RIPOC method. The deviation amount in the direction of the two-dimensional shape of the contour is the deviation amount in the rotation direction of the contour on the image. Here, the second calculation unit 6124 calculates the deviation amount y2n in the rotation direction in which the matching degree of the contour can be the highest between the collation target region Re2 (FIG. 26) set in the edge image as the real shape information by the collation target region setting unit 6121 and the reference image as the reference shape information using, for example, the RIPOC method. The deviation amount y2n corresponds to the roll angle γ at which the matching degree between the reference image as the reference shape information and the edge image as the real shape information can be further increased.

In the processing 2bn, similarly to the processing 2b1, for example, the second calculation unit 6124 rotates the edge image as the real shape information so as to correct the deviation amount γ2n detected in the processing 2an. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount y2n detected in the processing 2an. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2cn, similarly to the processing 2c1, for example, the second calculation unit 6124 performs template matching using the reference image as the reference shape information for the rotated edge image related to the real shape information generated in the processing 2bn. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, the position (matching candidate position) of the region having the maximum matching degree with the two-dimensional shape of the contour of the 3D model 3dm of the component to be searched in the reference image can be detected. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the third virtual camera position. In other words, for each third virtual camera position, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<n-th D Processing>>

The n-th D processing is processing in which the second detection unit 6125 detects, among the n-th reference virtual camera position and the n-th M3×T3 third virtual camera positions, a virtual camera position having the highest matching degree between the information (real shape information) on the two-dimensional shape of the object captured in the real image capturing the component to be searched and the reference shape information.

Here, for example, the matching score calculated for the n-th reference virtual camera position and the matching score calculated for each of the n-th M3×T3 third virtual camera positions by the second calculation unit 6124 in the n-th C processing are compared. Then, for example, among the n-th reference virtual camera position and the n-th M3×T3 third virtual camera positions, the virtual camera position having the highest matching score calculated between the information (real shape information) on the two-dimensional shape of the object captured in the real image capturing the component to be searched and the reference shape information is detected.

### <<Effects by Repetition of Unit Processing>>

As described above, when the unit processing is repeatedly executed, a plurality of virtual divided surfaces including a virtual divided surface including a virtual camera position at which the matching degree between the real shape information and the reference shape information becomes the highest and having mutually different distances from the reference point Po of the 3D model 3dm of the component to be searched is divided according to the same rule to generate a plurality of virtual divided surfaces in which the next virtual camera position is to be set. As a result, the virtual divided surfaces before the division and the virtual divided surfaces after the division are not irrelevant, and increase in at least one of the number or the area can be reduced for the virtual divided surfaces after the division. As a result, the amount of calculation for recognizing the posture of the component to be searched captured in the real image can be reduced. Thus, the substrate processing apparatus 1 can efficiently recognize the posture of the component to be searched.

### <<End of One or More Times of n-th Unit Processing>>

For example, in response to one reference virtual camera position among from the first reference virtual camera position Ps1 to the n-th reference virtual camera positions being continuously detected a predetermined number of times (also referred to as a first predetermined number of times) set in advance by the second detection unit 6125, the search processing unit 61 ends execution of one or more times of the n-th unit processing. The first predetermined number of times may be set to any number of times, for example, two or more times. In this case, in the secondary search processing, even if the unit processing is repeatedly performed to some extent, if the virtual camera position at which the matching degree between the reference shape information and the real shape information becomes higher is not detected, the repetitive execution of the unit processing is ended. As a result, the amount of calculation for recognizing the posture of the component to be searched captured in the real image can be reduced. Thus, the substrate processing apparatus 1 can efficiently recognize the posture of the component to be searched.

Furthermore, for example, the search processing unit 61 may end execution of one or more times of the n-th unit processing in response to the n-th unit processing being executed a predetermined number of times (also referred to as a second predetermined number of times) set in advance. In other words, the search processing unit 61 may end execution of one or more times of the n-th unit processing in response to the n-th unit processing in one or more times of the n-th unit processing being executed the second predetermined number of times set in advance. The second predetermined number of times may be set to any number of times, for example, one or more times. As a result, the amount of calculation for recognizing the posture of the component to be searched captured in the real image can be reduced. Thus, the substrate processing apparatus 1 can efficiently recognize the posture of the component to be searched.

Here, for example, the search processing unit 61 detects, as the virtual camera position with the maximum matching degree, a virtual camera position having the highest matching degree between the real shape information and the reference shape information detected by the second detection unit 6125 in the last n-th D processing in the executed one or more times of n-th unit processing. In other words, for example, the virtual camera position detected by the second detection unit 6125 in the last n-th D processing in the executed one or more times of n-th unit processing is the virtual camera position with the maximum matching degree. Then, the search processing unit 61 can acquire, for example, the latitude α, the longitude β, and the distance D that define the virtual camera position with the maximum matching degree, and the roll angle γ corresponding to the deviation amount (deviation amount γ1, deviation amount γ2, deviation amount γ21 or deviation amount γ2n) calculated by the first calculation unit 6113 or the second calculation unit 6124 for the virtual camera position with the maximum matching degree as a result of the search processing. As a result, the posture of the component to be searched captured in the real image can be recognized.

Furthermore, for example, the search processing unit 61 may acquire, as a portion of the result of the search processing, a matching candidate position (also referred to as a final matching position) at which the matching degree (similarity) with the reference image as the reference shape information in the edge image as the real shape information becomes maximum, detected by the first calculation unit 6113 or the second calculation unit 6124 for the virtual camera position with the maximum matching degree.

### <4. Specific Example of Processing in Substrate Processing Apparatus>

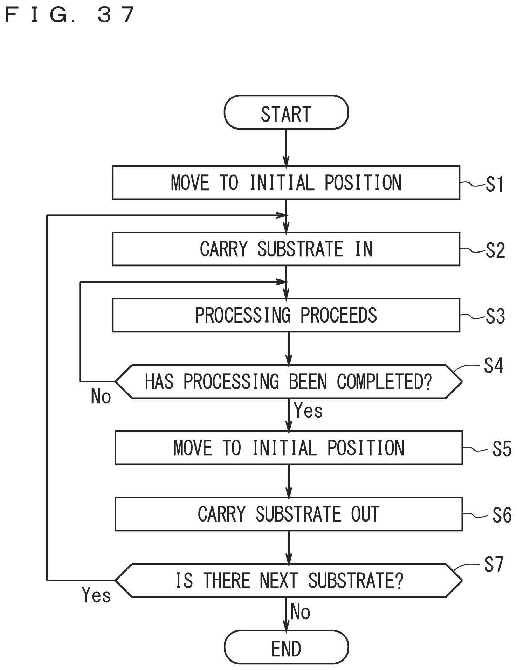

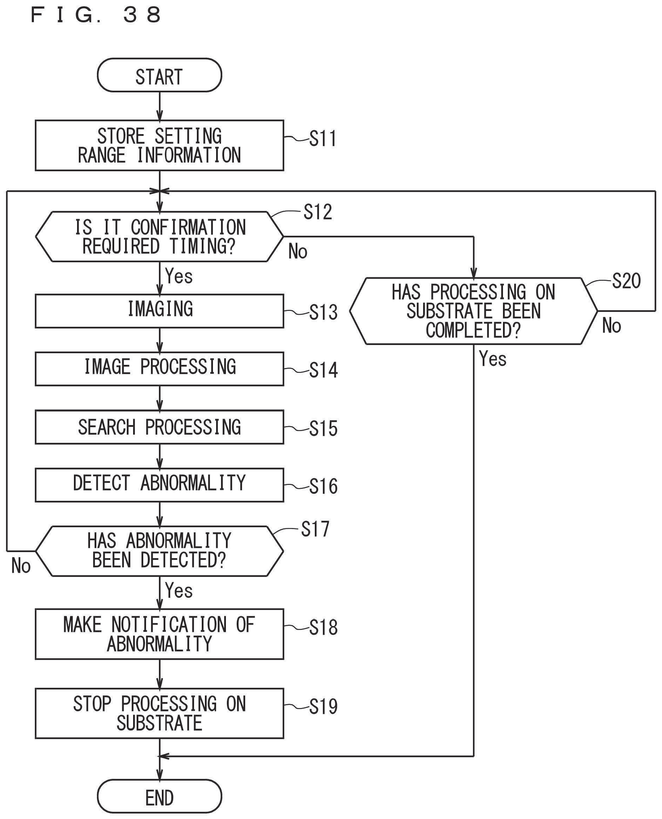

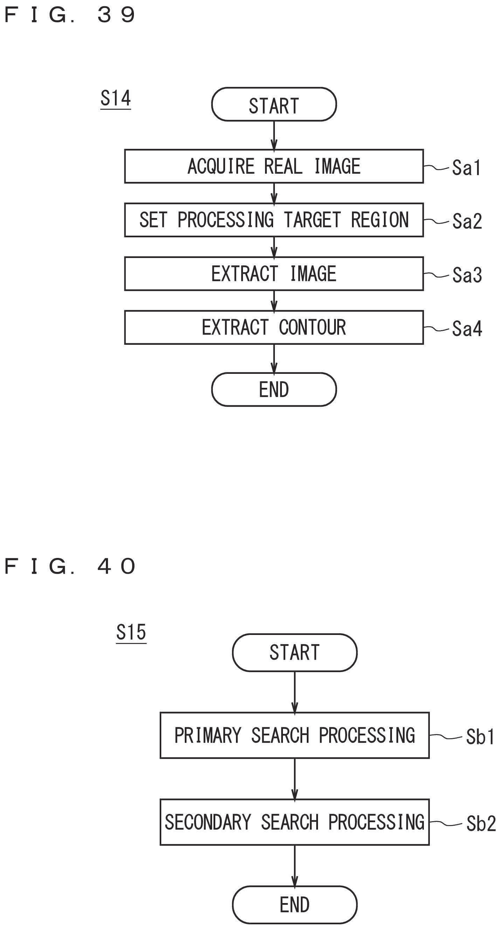

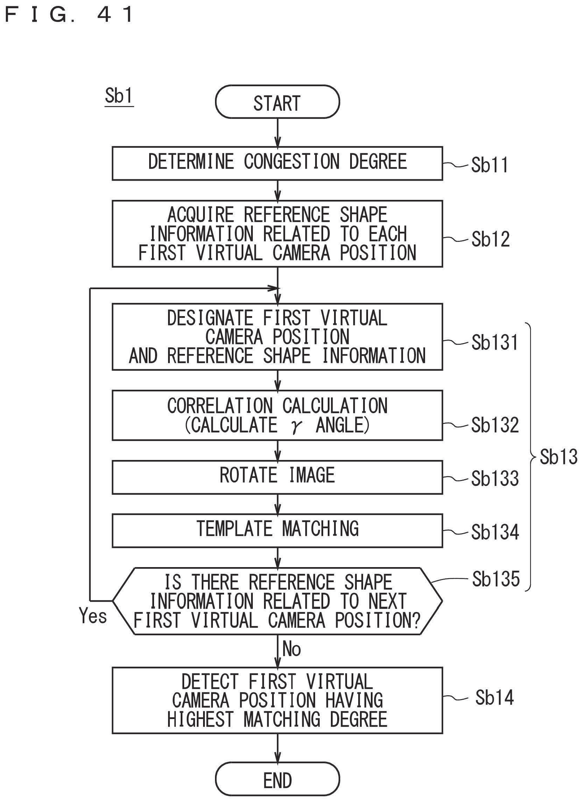

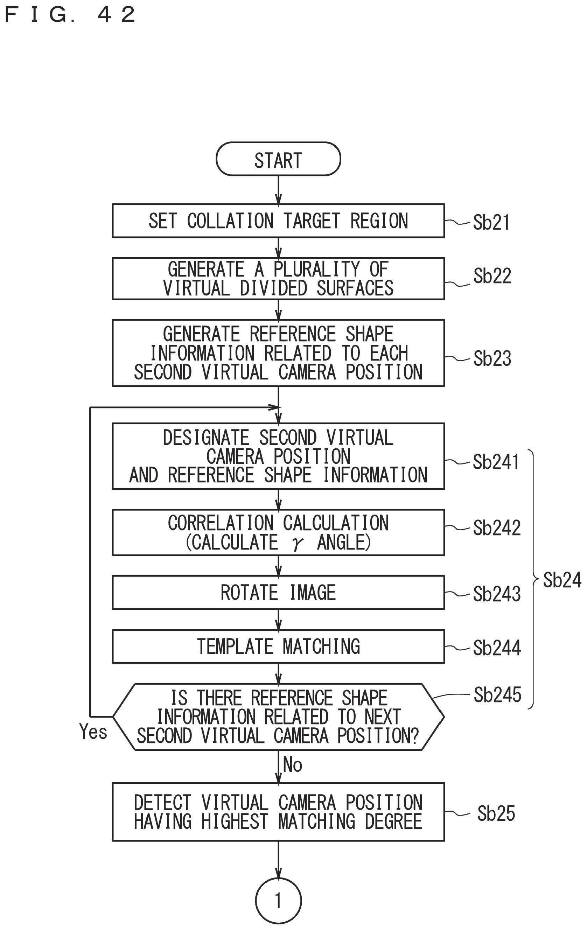

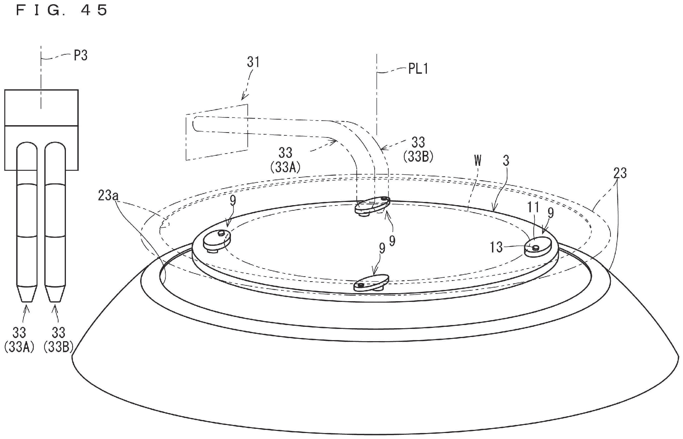

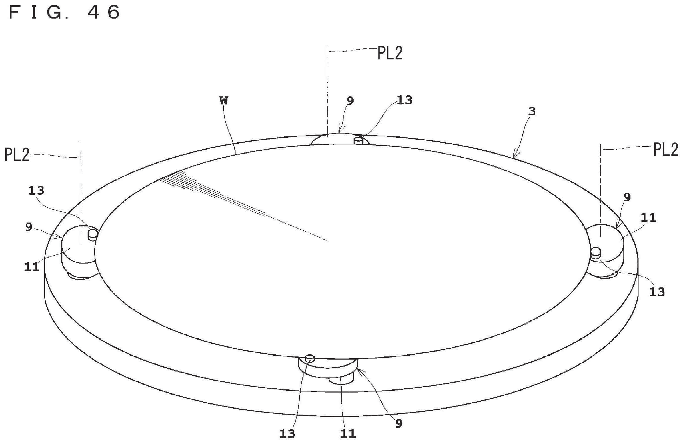

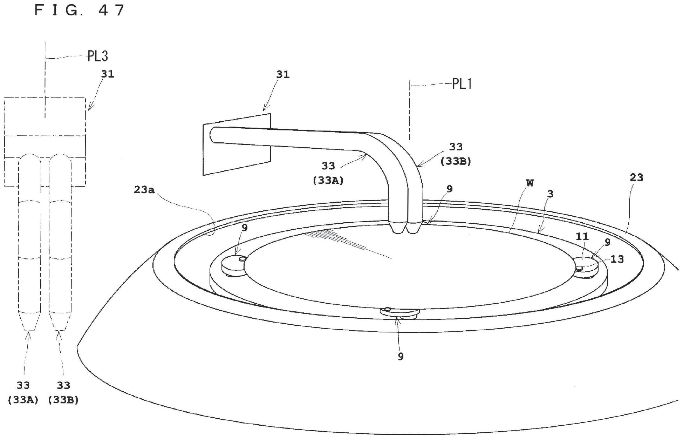

Next, a specific example of processing in the substrate processing apparatus 1 will be described with reference to FIGS. 37 to 47. FIG. 37 is a flowchart indicating a specific example of schematic flow of operation related to processing of one or more substrates W in the substrate processing apparatus 1. FIG. 38 is a flowchart indicating a specific example of schematic flow of operation related to processing of detecting an abnormality in the substrate processing apparatus 1. FIG. 39 is a flowchart indicating a specific example of flow of image processing in step S14 of FIG. 38. FIG. 40 is a flowchart indicating a specific example of processing flow in the search processing in step S15 of FIG. 38. FIG. 41 is a flowchart indicating a specific example of processing flow in the primary search processing in step Sb1 of FIG. 40. FIGS. 42 to 44 are flowcharts indicating a specific example of processing flow in the secondary search processing in step Sb2 in FIG. 40. FIG. 45 is a view schematically illustrating an example of a state in which the target component is located at an initial position. Here, the initial position of the chuck 9 as the target component is the open position, the initial position of the guard 23 as the target component is the lowered position, and the initial position of the nozzle 33 as the target component is the standby position. FIG. 46 is a view schematically illustrating an example of a state in which each chuck 9 is located at the closed position. FIG. 47 is a view schematically illustrating an example of a state in which the nozzle 33 is located at the discharge position and the guard 23 is located at the raised position.

For example, in the substrate processing apparatus 1, if the operator gives an instruction to execute a recipe in recipe information 53 by operating the instruction unit 47, the operation control unit 51 controls the operation of each unit of the substrate processing apparatus 1 according to the recipe instructed to execute. By this means, the processing on each substrate W in the substrate processing apparatus 1 proceeds. In this event, the processing from steps S1 to S7 of FIG. 37 for the operation related to the processing of one or more substrates W in the substrate processing apparatus 1 is performed. Further, when the operation related to the processing of one or more substrates W from steps S1 to S7 in FIG. 37 is performed, the processing from steps S11 to S20 in FIG. 38 for the operation related to the processing of detecting the abnormality in the substrate processing apparatus 1 is performed in parallel with the operation in steps S1 to S7.

### <4-1. Operation Related to Processing of Substrate in Substrate Processing Apparatus>

### <<Step S1>>

In step S1, each target component moves to the initial position. Here, the operation control unit 51 controls the operation of the chuck moving mechanism 17, the guard moving mechanism 25, and the nozzle moving mechanism 35.

For example, the operation control unit 51 controls the operation of the chuck moving mechanism 17 by the chuck operation command to move the chuck 9 as the target component to the open position as the initial position. Here, the chuck 9 rotates about the rotation center PL2 in response to the chuck operation command in a state where the substrate W is not placed on the lower surface support portion 11, and the peripheral edge support portion 13 moves in a direction away from the rotation center PL1 of the spin chuck 3, whereby the chuck 9 moves to the open position. In this event, the output signal of the first sensor Z1 is turned on. The operation control unit 51 recognizes that the chuck 9 has moved to the open position by the output signal of the first sensor Z1. In FIG. 45, a state in which the chuck 9 is located at the open position is indicated by a solid line, and a position of the outer edge of the substrate W when the substrate W is placed on the lower surface support portion 11 is indicated by a thin two-dot chain line. Here, the peripheral edge support portion 13 of each chuck 9 moves to a position farther away from the rotation center PL1 than the outer edge of the substrate W in a case where the substrate W is placed on the lower surface support portion 11.

For example, the operation control unit 51 controls the operation of the guard moving mechanism 25 by the guard operation command to move the guard 23 as the target component to the lowered position as the initial position. Here, the guard 23 moves to the lowered position. In this event, the output of the second sensor Z2 is turned on. The operation control unit 51 recognizes that the guard 23 has moved to the lowered position by the output signal of the second sensor Z2. In FIG. 45, a state in which the guard 23 is located at the lowered position is indicated by a solid line, and a state in which the guard 23 is located at the raised position is schematically indicated by a thin two-dot chain line.

For example, the operation control unit 51 controls the operation of the nozzle moving mechanism 35 by the nozzle operation command to move the nozzle 33 as the target component to the standby position as the initial position. Here, the nozzle 33 rotates about the rotation center PL3 and moves to the standby position deviated laterally from the guard 23. In this event, the output of the third sensor Z3 is turned on. The operation control unit 51 recognizes that the nozzle 33 has moved to the standby position by the output signal of the third sensor Z3. In FIG. 45, a state in which the nozzle 33 is located at the standby position is indicated by a solid line, and a state in which the nozzle 33 is located at the discharge position is indicated by a thin two-dot chain line.

Here, when the processing from steps S1 to S7 is started, if each target component is located at the initial position in advance, the processing in step S1 may be omitted.

### <<Step S2>>

In step S2, the substrate W to be processed is carried into the substrate processing apparatus 1. The substrate W is carried into the substrate processing apparatus 1 by, for example, a transportation robot (not illustrated), or the like.

### <<Step S3>>

In step S3, the processing on the substrate W proceeds according to the recipe. Specifically, first, the substrate W is placed on the plurality of chucks 9. For example, the operation control unit 51 operates the chuck moving mechanism 17 by the chuck operation command to move each chuck 9 from the open position to the closed position. This state is, for example, as illustrated in FIG. 46. In other words, each chuck 9 rotates about the rotation center PL2 in a state where the substrate W is placed, and the peripheral edge support portion 13 moves to the rotation center PL1 side of the spin chuck 3. As a result, the peripheral edge support portions 13 of the plurality of chucks 9 abut on the outer edge of the substrate W to clamp the substrate W.

### <<Step S4>>

In step S4, the operation control unit 51 determines whether or not the processing on the substrate W has been completed. Here, if the processing on the substrate W has been completed, the processing proceeds from step S4 to step S5. On the other hand, if the processing on the substrate W has not been completed, the processing returns from step S4 to step S3. For example, if the substrate W is merely placed on the plurality of chucks 9, and the substrate W is clamped by the plurality of chucks 9, the processing on the substrate W has not been completed, and the processing returns from step S4 to step S3.

### <<Step S3>>

In step S3, the processing on the substrate W proceeds according to the recipe. Specifically, for example, the operation control unit 51 operates the guard moving mechanism 25 by the guard operation command to move the guard 23 located at the lowered position as illustrated in FIG. 45 to the raised position as illustrated in FIG. 47. At this time point, the nozzle 33 located above the substrate W in FIG. 47 is located at the standby position.

### <<Step S4>>

In step S4, the operation control unit 51 determines whether or not the processing on the substrate W has been completed. Here, if the processing on the substrate W has been completed, the processing proceeds from step S4 to step S5. On the other hand, if the processing on the substrate W has not been completed, the processing returns from step S4 to step S3. For example, if the substrate W is simply clamped by the plurality of chucks 9 and the guard 23 moves to the raised position, the processing on the substrate W has not been completed, and the processing returns from step S4 to step S3.

### <<Step S3>>

In step S3, the processing on the substrate W proceeds according to the recipe. Specifically, for example, the operation control unit 51 operates the nozzle moving mechanism 35 by the nozzle operation command to move the nozzle 33B of the nozzles 33A, 33B from the state of being located at the standby position illustrated in FIG. 45 to the state of being located at the discharge position illustrated in FIG. 47. The discharge position is, for example, a position on the rotation center PL1.

### <<Step S4>>

In step S4, the operation control unit 51 determines whether or not the processing on the substrate W has been completed. Here, if the processing on the substrate W has been completed, the processing proceeds from step S4 to step S5. On the other hand, if the processing on the substrate W has not been completed, the processing returns from step S4 to step S3. For example, if the substrate W is clamped by the plurality of chucks 9, the guard 23 moves to the raised position, and the nozzle 33B only moves to the discharge position, the processing on the substrate W has not been completed, and the processing returns from step S4 to step S3.

### <<Steps S3, S4>>

Thereafter, the processing in step S3 and the processing in step S4 are repeated. In this event, in step S3, the operation control unit 51 controls the operation of each unit in the substrate processing apparatus 1 according to the recipe instructed to be executed so that the processing on the substrate W proceeds. Specifically, for example, by the rotation of the spin chuck 3 by being driven by the motor 7 according to the recipe, the supply of the processing liquid from the nozzle 33B onto the substrate W, and the like, being sequentially performed, the processing on the substrate W is performed by the operation of each unit according to the recipe instructed to be executed. Then, at a time point when the processing on the substrate W has been completed, the processing proceeds from step S4 to step S5.

### <<Step S5>>

In step S5, each target component moves to the initial position in a similar manner to step S1 described above. Here, the operation control unit 51 controls the operation of the chuck moving mechanism 17, the guard moving mechanism 25, and the nozzle moving mechanism 35.

### <<Step S6>>

In step S6, the substrate W placed on the plurality of chucks 9 is carried out of the substrate processing apparatus 1. The substrate W is carried out to the outside of the substrate processing apparatus 1 by, for example, a transportation robot (not illustrated), or the like.

### <<Step S7>>

In step S7, the operation control unit 51 determines whether or not there is a next substrate W to be subjected to the processing according to the recipe instructed to be executed. Here, if there is a next substrate W, the processing returns from step S7 to step S2. Thus, as long as the next substrate W to be processed is present, the processing of steps S2 to S7 is repeatedly performed. Then, in step S7, if there is no next substrate W to be processed, the operation related to the processing of one or more substrates W in the substrate processing apparatus 1 illustrated in FIG. 37 is ended.

### <4-2. Operation Related to Processing of Detecting Abnormality in Substrate Processing Apparatus>

### <<Step S11>>

In step S11, the setting range information 58 is stored in the storage unit 45b. Here, for example, by the operator operating the instruction unit 47, the setting range information 58 is stored in the storage unit 45b. The setting range information 58 may be stored in the storage unit 45b in advance, for example. In this case, step S11 may be omitted. The processing of storing the setting range information 58 in the storage unit 45b corresponds to a storage step of the present invention.

### <<Step S12>>

In step S12, the operation control unit 51 confirms whether or not the target component is at the confirmation required timing. Specifically, the operation control unit 51 refers to the target component and the confirmation required timing in the parameter information 55. Here, in a case where the target component is at the confirmation required timing, the processing proceeds from step S12 to step S13, and if the target component is not at the confirmation required timing, the processing proceeds from step S12 to step S20.

More specifically, in step S12, for example, if it is the timing at which the chuck 9 as the target component is located at the open position which is the first A position, the processing proceeds from step S12 to step S13. In this case, the operation control unit 51 notifies the search processing unit 61 of information specifying the chuck 9 as the component to be searched which is the target component at the confirmation required timing and information indicating the open position where the chuck 9 should originally be located at the confirmation required timing. Then, the processing from step S13 to step S17 is performed on the chuck 9 at the confirmation required timing.

Further, in step S12, for example, if it is the timing at which the guard 23 as the target component is located at the lowered position which is the first B position, the processing proceeds from step S12 to step S13. In this case, the operation control unit 51 notifies the search processing unit 61 of the information for specifying the guard 23 as the component to be searched which is the target component at the confirmation required timing and the information indicating the lowered position where the guard 23 should originally be located at the confirmation required timing. Then, the processing from step S13 to step S17 is performed on the guard 23 at the confirmation required timing.

In step S12, for example, if it is the timing at which the nozzle 33 as the target component is located at the standby position that is the first C position, the processing proceeds from step S12 to step S13. In this case, the operation control unit 51 notifies the search processing unit 61 of the information for specifying the nozzle 33 as the component to be searched which is the target component at the confirmation required timing and the information indicating the standby position where the nozzle 33 should originally be located at the confirmation required timing. Then, the processing from step S13 to step S17 is performed on the nozzle 33 at the confirmation required timing.

In addition, in step S12, for example, if it is the timing at which the chuck 9 as the target component is located at the closed position which is the second A position, the processing proceeds from step S12 to step S13. In this case, the operation control unit 51 notifies the search processing unit 61 of information specifying the chuck 9 as the component to be searched which is the target component at the confirmation required timing and information indicating the closed position where the chuck 9 should originally be located at the confirmation required timing. Then, the processing from step S13 to step S17 is performed on the chuck 9 at the confirmation required timing.

In addition, in step S12, for example, if it is the timing at which the guard 23 as the target component is located at the raised position which is the second B position, the processing proceeds from step S12 to step S13. In this case, the operation control unit 51 notifies the search processing unit 61 of the information specifying the guard 23 as the component to be searched which is the target component at the confirmation required timing and the information indicating the raised position where the guard 23 should originally be located at the confirmation required timing. Then, the processing from step S13 to step S17 is performed on the guard 23 at the confirmation required timing.

Further, in step S12, for example, if it is the timing at which the nozzle 33 as the target component is located at the discharge position which is the second C position, the processing proceeds from step S12 to step S13. In this case, the operation control unit 51 notifies the search processing unit 61 of the information specifying the nozzle 33 as the component to be searched which is the target component at the confirmation required timing and the information indicating the discharge position where the nozzle 33 should originally be located at the confirmation required timing. Then, the processing from step S13 to step S17 is performed on the nozzle 33 at the confirmation required timing.

### <<Step S13>>

In step S13, the operation control unit 51 causes the camera CM to perform imaging. Here, a real image capturing the component to be searched that is any one target component of the one or more target components is obtained by imaging by the camera CM. Step S13 corresponds to an imaging step of the present invention.

More specifically, in step S13, for example, if it is the timing at which the chuck 9 as the target component is located at the open position which is the first A position, the operation control unit 51 operates the camera CM according to the timing at which each chuck 9 is estimated to be moved to the open position by the chuck operation command. As a result, the camera CM acquires a real image including each chuck 9 by imaging.

Furthermore, in step S13, for example, if it is the timing at which the guard 23 as the target component is located at the lowered position which is the first B position, the operation control unit 51 operates the camera CM according to the timing at which the guard 23 is estimated to be moved to the lowered position by the guard operation command. As a result, the camera CM acquires the real image including the guard 23 by imaging.

In step S13, for example, if it is the timing at which the nozzle 33 as the target component is located at the standby position that is the first C position, the operation control unit 51 operates the camera CM according to the timing at which the nozzle 33 is estimated to be moved to the standby position by the nozzle operation command. As a result, the camera CM acquires the real image including the nozzle 33 by imaging.

In addition, in step S13, for example, if it is the timing at which the chuck 9 as the target component is located at the closed position which is the second A position, the operation control unit 51 operates the camera CM according to the timing at which each chuck 9 is estimated to be moved to the closed position by the chuck operation command. As a result, the camera CM acquires a real image including each chuck 9 by imaging.

Furthermore, in step S13, for example, if it is the timing at which the guard 23 as the target component is located at the raised position that is the second B position, the operation control unit 51 operates the camera CM according to the timing at which the guard 23 is estimated to be moved to the raised position by the guard operation command. As a result, the camera CM acquires the real image including the guard 23 by imaging.

In step S13, for example, if it is the timing at which the nozzle 33 as the target component is located at the discharge position that is the second C position, the operation control unit 51 operates the camera CM according to the timing at which the nozzle 33 is estimated to be moved to the discharge position by the nozzle operation command. As a result, the camera CM acquires the real image including the nozzle 33 by imaging.

### <<Step S14>>

In step S14, the image processing unit 59 performs image processing on the real image acquired by imaging by the camera CM in step S13. In step S14, the processing from step Sa1 to step Sa4 in FIG. 39 is sequentially performed.

In step Sa1, the image processing unit 59 acquires the real image obtained by capturing the component to be searched obtained by imaging in step S13 from the camera CM.

In step Sa2, the processing target region extraction unit 591 of the image processing unit 59 sets the processing target region for the real image capturing the component to be searched. Here, the processing target region is set for each component to be searched.

In step Sa3, the processing target region extraction unit 591 of the image processing unit 59 extracts a portion related to the processing target region as an image (processing target real image) from the real image capturing the component to be searched.

In step Sa4, the contour extraction unit 592 of the image processing unit 59 performs processing of extracting contour for all components captured in the processing target real image. As a result, an edge image as information (real shape information) about the two-dimensional shape of the object captured in the real image capturing the component to be searched is acquired.

Here, for example, if the component to be searched is the chuck 9, an edge image as information (real shape information) about the two-dimensional shape of the object including the chuck 9 captured in the real image capturing the chuck 9 is acquired. For example, if the component to be searched is the guard 23, an edge image as information (real shape information) on the two-dimensional shape of the object including the guard 23 captured in the real image capturing the guard 23 is acquired. For example, if the component to be searched is the nozzle 33, an edge image as information (real shape information) on the two-dimensional shape of the object including the nozzle 33 captured in the real image capturing the nozzle 33 is acquired.

### <<Step S15>>

In step S15, the search processing unit 61 performs search processing on the component to be searched. For example, if the component to be searched is the chuck 9, the search processing unit 61 performs search processing on the chuck 9. For example, if the component to be searched is the guard 23, the search processing unit 61 performs search processing on the guard 23. For example, if the component to be searched is the nozzle 33, the search processing unit 61 performs search processing on the nozzle 33.

Here, the search processing unit 61 executes search processing of searching for a virtual camera position with a maximum matching degree which is a virtual camera position having the highest matching degree between the reference shape information and the real shape information among the plurality of virtual camera positions based on the plurality of pieces of reference shape information and the real shape information. Here, each of the plurality of pieces of reference shape information is information generated based on the three-dimensional design information regarding the component to be searched stored in the storage unit 45b, or the like. More specifically, the plurality of pieces of reference shape information is information on the two-dimensional shape of the 3D model 3dm of the component to be searched in each of the plurality of virtual images that can be acquired by imaging the 3D model 3dm of the component to be searched from the plurality of virtual camera positions. For example, one piece of reference shape information is information generated based on the three-dimensional design information regarding one component to be searched, and is information regarding the two-dimensional shape of the 3D model 3dm of the component to be searched in a virtual image that can be acquired by imaging the 3D model 3dm of the component to be searched from one virtual camera position. The real shape information is information on the two-dimensional shape of the object in the real image capturing the component to be searched obtained in step S13. More specifically, the real shape information may be an edge image as the real shape information acquired in step Sa4. Step S15 corresponds to a search step of executing search processing by the arithmetic unit 45a of the present invention.

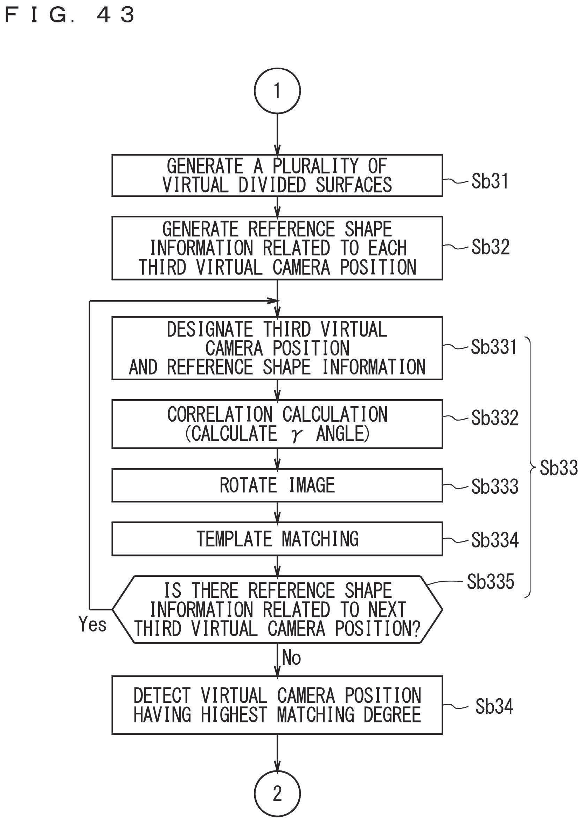

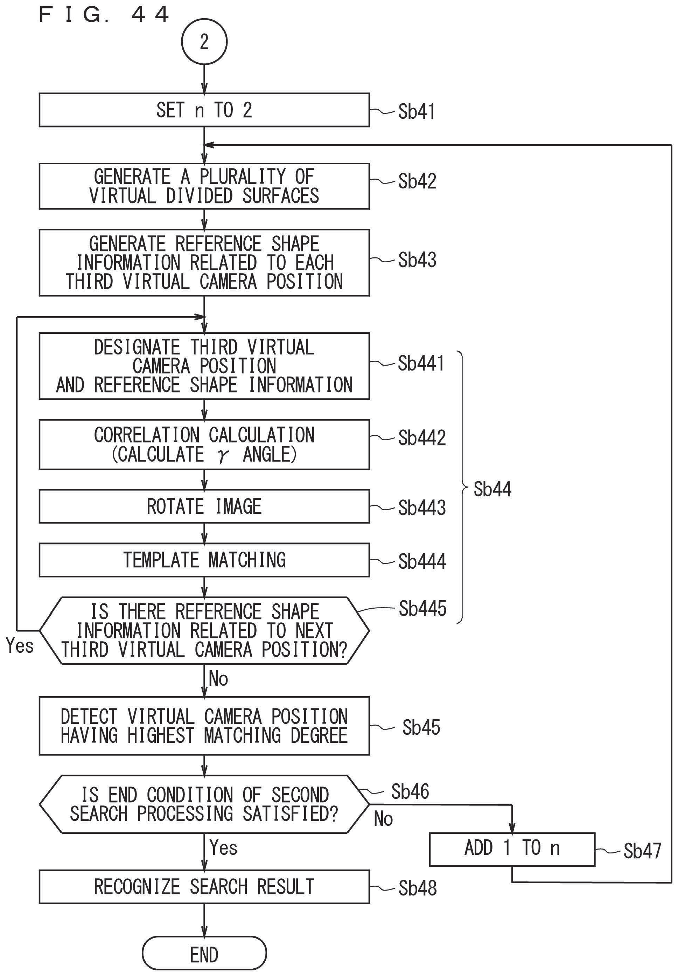

In step S15, the processing in step Sb1 and the processing in step Sb2 in FIG. 40 are sequentially performed on each target component. In step Sb1, the first search processing unit 611 performs the primary search processing. More specifically, in step Sb1, the processing from step Sb11 to step Sb14 in FIG. 41 is sequentially performed. In step Sb2, the second search processing unit 612 performs the secondary search processing. More specifically, in step Sb2, the processing from step Sb21 to step Sb25 in FIG. 42, the processing from step Sb31 to step Sb34 in FIG. 43, and the processing from step Sb41 to step Sb48 in FIG. 44 are performed. Here, the processing from step Sb31 to step Sb34 in FIG. 43 corresponds to the first unit processing described above. The processing from step Sb42 to step Sb45 in FIG. 44 corresponds to the n-th unit processing described above.

### <<<Step Sb1>>>

### <<<<Step Sb11>>>>

In step Sb11, the congestion degree determination unit 6111 determines a region (low congestion degree region) in which the congestion degree of the contour of the component is low for the edge image as the real shape information acquired in step Sa4. The determination result in the congestion degree determination unit 6111 is used for processing in the first calculation unit 6113 and the second calculation unit 6124. For example, in the processing in the first calculation unit 6113 and the second calculation unit 6124, the low congestion degree region of the edge image as the real shape information is excluded from the calculation target for calculating the numerical value indicating the matching degree, so that the amount of calculation required for the search processing can be reduced.

### <<<<Step Sb12>>>>

In step Sb12, the first shape information acquisition unit 6112 acquires the reference shape information generated for each of the plurality of first virtual camera positions P11 assuming a case where the 3D model 3dm of the component to be searched is imaged from each of the plurality of first virtual camera positions P11 based on the three-dimensional design information regarding the component to be searched and the setting range information 58 stored in the storage unit 45b, or the like. The plurality of first virtual camera positions P11 is located along the plurality of virtual spherical surfaces Sv1 surrounding the 3D model 3dm of the component to be searched centered around the reference point Po of the 3D model 3dm of the component to be searched, and is a plurality of virtual camera positions corresponding to at least one initial setting range of one or more initial setting ranges for the component to be searched defined by the setting range information 58. The reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the virtual camera position. Specifically, the reference shape information is a reference image. Here, step Sb12 corresponds to the first shape information acquisition step in the present invention. Here, in a case where the range of the position and the posture of the component to be searched is limited, the amount of calculation in the search processing can be reduced by limiting the range in which the plurality of first virtual camera positions P11 is set. As a result, the amount of calculation for recognizing the posture of the component to be searched captured in the real image can be reduced. As a result, the substrate processing apparatus 1 can efficiently recognize the posture of the component to be searched.

Here, for example, a case is assumed where one or more initial setting ranges for the component to be searched defined in the setting range information 58 include the first initial setting range for the first position, and it is the timing at which the component to be searched is located at the first position by the moving mechanism. At this timing, for example, the search processing unit 61 can acquire, by the first shape information acquisition unit 6112, the reference shape information generated for each of the plurality of first virtual camera positions P11 corresponding to the first initial setting range assuming a case where the 3D model 3dm of the component to be searched is imaged from each of the plurality of first virtual camera positions P11 corresponding to the first initial setting range based on the three-dimensional design information regarding the component to be searched and the setting range information 58 stored in the storage unit 45b, or the like. As a result, for example, in a case where the component to be searched moves between the first position and the second position, the range in which the plurality of first virtual camera positions P11 is set can be limited for the first position in which the range in which the posture of the component to be searched changes is more limited. As a result, the amount of calculation for recognizing the posture of the component to be searched captured in the real image can be reduced. Here, the first initial setting range corresponds to at least one initial setting range of one or more initial setting ranges for the component to be searched described above. In other words, at least one initial setting range of one or more initial setting ranges for the component to be searched described above is the first initial setting range. The plurality of virtual camera positions corresponding to the first initial setting range for the component to be searched may be a plurality of virtual camera positions virtually set within the first initial setting range for the component to be searched.

For example, if the component to be searched is the first chuck, and it is the timing at which the first chuck is located at the open position as the first A position that is the first position by the chuck moving mechanism 17, the first initial setting range may be the first A initial setting range for the open position of the first chuck.

For example, if the component to be searched is the guard 23, and it is the timing at which the guard 23 is located at the lowered position as the first B position that is the first position by the guard moving mechanism 25, the first initial setting range may be the first B initial setting range for the lowered position of the guard 23.

For example, if the component to be searched is the nozzle 33, and it is the timing at which the nozzle 33 is located at the standby position as the first C position that is the first position by the nozzle moving mechanism 35, the first initial setting range may be the first C initial setting range for the standby position of the nozzle 33.

Here, for example, a case is assumed where one or more initial setting ranges for the component to be searched defined in the setting range information 58 include the second initial setting range for the second position, and it is the timing at which the component to be searched is located at the second position by the moving mechanism. At this timing, for example, the search processing unit 61 can acquire, by the first shape information acquisition unit 6112, the reference shape information generated for each of the plurality of first virtual camera positions P11 corresponding to the second initial setting range assuming a case where the 3D model 3dm of the component to be searched is imaged from each of the plurality of first virtual camera positions P11 corresponding to the second initial setting range based on the three-dimensional design information regarding the component to be searched and the setting range information 58 stored in the storage unit 45b, or the like. As a result, for example, in a case where the component to be searched moves between the first position and the second position, the range in which the plurality of first virtual camera positions P11 is set can be limited for the second position in which the range in which the posture of the component to be searched changes is more limited. As a result, the amount of calculation for recognizing the posture of the component to be searched captured in the real image can be reduced. Here, the second initial setting range corresponds to at least one initial setting range of one or more initial setting ranges for the component to be searched described above. In other words, at least one initial setting range of one or more initial setting ranges for the component to be searched described above is the second initial setting range. The plurality of virtual camera positions corresponding to the second initial setting range for the component to be searched may be a plurality of virtual camera positions virtually set within the second initial setting range for the component to be searched.

For example, if the component to be searched is the first chuck, and it is the timing at which the first chuck is located at the closed position as the second A position which is the second position by the chuck moving mechanism 17, the second initial setting range may be the second A initial setting range for the closed position of the first chuck.

For example, if the component to be searched is the guard 23, and it is the timing at which the guard 23 is located at the raised position as the second B position that is the second position by the guard moving mechanism 25, the second initial setting range may be the second B initial setting range for the raised position of the guard 23.

For example, if the component to be searched is the nozzle 33, and it is the timing at which the nozzle 33 is located at the discharge position as the second C position that is the second position by the nozzle moving mechanism 35, the second initial setting range may be the second C initial setting range for the discharge position of the nozzle 33.

Here, for example, as illustrated in FIG. 4, if each of the one or more initial setting ranges for the component to be searched includes the first numerical range that is the range of the distance, the second numerical range that is the range of the latitude, and the third numerical range that is the range of the longitude, in a case where the range in which each of the angular relationship and the distance between the camera CM and the component to be searched changes is limited, the range in which the plurality of first virtual camera positions P11 is set can be limited. As a result, the amount of calculation in the search processing can be reduced. As a result, the amount of calculation for recognizing the posture of the component to be searched captured in the real image can be reduced.

Furthermore, here, for example, as illustrated in FIG. 4, if the setting range information 58 includes information defining one or more initial setting ranges related to the virtual camera position for each target component, the range in which the plurality of first virtual camera positions P11 is set can be limited for each component to be searched as the target component at the confirmation required timing. As a result, the amount of calculation in the search processing can be reduced. As a result, the amount of calculation for recognizing the posture of the component to be searched captured in the real image can be reduced.

More specifically, in step Sb12, the first shape information acquisition unit 6112 acquires the reference shape information generated for each of the M1×T1 first virtual camera positions P11 assuming a case where the 3D model 3dm of the component to be searched is imaged from each of the M1×T1 (both M1 and T1 are natural numbers equal to or greater than 2) first virtual camera positions P11 that are the plurality of first virtual camera positions P11 based on the three-dimensional design information regarding the component to be searched and the setting range information 58 stored in the storage unit 45b, or the like. The M1×T1 first virtual camera positions P11 are a plurality of virtual camera positions set by virtually setting one virtual camera position for each of the M1 virtual surfaces St1 in each of T1 surface aggregations As1 in a case where the T1 surface aggregations As1 having mutually different distances from the reference point Po of the 3D model 3dm of the component to be searched are virtually set. The T1 surface aggregations As1 each include a plurality of virtual surfaces St1 located along the virtual spherical surface Sv1 surrounding the 3D model 3dm centered around the reference point Po of the 3D model 3dm of the component to be searched, and are a plurality of surface aggregations As1 corresponding to the first numerical range that is the distance range in at least one initial setting range of one or more initial setting ranges for the component to be searched defined by the setting range information 58. M1 virtual surfaces St1 in each of the T1 surface aggregations As1 are a plurality of virtual surfaces corresponding to both of the second numerical range that is the range of the latitude and the third numerical range that is the range of the longitude in at least one initial setting range of one or more initial setting ranges for the component to be searched defined by the setting range information 58.

Here, for example, as illustrated in FIG. 14, the position and the posture of each virtual surface St1, each first virtual camera position P11, and the like, can be defined by setting the xyz coordinate of the right-handed coordinate system with the reference point Po of the 3D model 3dm of the component to be searched defined by the three-dimensional design information regarding the component to be searched as the origin, the angle (latitude) α in the rotation direction around the x axis, the angle (longitude) β in the rotation direction around the z axis, and the distance D from the origin.

Here, in each of the M1 virtual surfaces St1 in each of the T1 surface aggregations As1, for example, the first virtual camera position P11 is virtually set at a predetermined position of the virtual surface St1. For example, the position of the center of the virtual surface St1 is adopted as the predetermined position. For example, the center of gravity of the virtual surface St1 is adopted as the center of the virtual surface St1. The plurality of surface aggregations As1 corresponding to the first numerical range that is the range of the distance in at least one initial setting range of one or more initial setting ranges for the component to be searched defined by the setting range information 58 may be, for example, a plurality of surface aggregations As1 in which the distance from the reference point Po of the 3D model 3dm of the component to be searched is included within the first numerical range, or may be a plurality of surface aggregations As1 located along a plurality of virtual spherical surfaces Sv1 in which the distance from the reference point Po of the 3D model 3dm of the component to be searched is included within the first numerical range. In addition, the plurality of virtual surfaces St1 corresponding to both of the second numerical range that is the range of the latitude and the third numerical range that is the range of the longitude in at least one initial setting range of the one or more initial setting ranges for the component to be searched defined in the setting range information 58 may be a plurality of virtual surfaces St1 whose latitude is included in the second numerical range and whose longitude is included in the third numerical range. The plurality of virtual surfaces St1 may be a plurality of virtual surfaces in which the latitude of the predetermined position of each of the plurality of virtual surfaces St1 is included in the range of the second numerical range, and the longitude of the predetermined position of each of the plurality of virtual surfaces St1 is included in the range of the third numerical range. The predetermined position of each of the plurality of virtual surfaces St1 may be, for example, a center such as a center of gravity of the virtual surface St1.

For example, each of the plurality of virtual surfaces St1 constituting the surface aggregation As1 may be a triangular surface, and the surface aggregation As1 may be a polyhedron constituted with a plurality of triangular surfaces. In other words, the surface aggregation As1 may be a spherical polyhedron constituted with a plurality of triangular surfaces. In other words, for example, a triangular surface is adopted as each of the plurality of virtual surfaces St1 constituting the T1 surface aggregations As1, and a polyhedron constituted with a plurality of triangular surfaces is adopted as each of the T1 surface aggregations As1. As a result, the surface aggregation As1 including the plurality of virtual surfaces St1 can be easily set. Here, the triangle may be an equilateral triangle. If the virtual surface St1 is a triangular surface, the center of the virtual surface St1 may be the center of gravity or the incenter of the triangle.

In step Sb12, for example, the first shape information acquisition unit 6112 may acquire the reference shape information generated for each of the plurality of first virtual camera positions P11 by setting the plurality of first virtual camera positions P11 based on the three-dimensional design information regarding the component to be searched and the setting range information 58 stored in the storage unit 45b, or the like, and generating the reference shape information for each of the plurality of first virtual camera positions P11.

### <<<<Step Sb13>>>>

In step Sb13, the first calculation unit 6113 calculates a numerical value indicating the matching degree between the reference image as the reference shape information for each of the plurality of first virtual camera positions P11 acquired in step Sb12 and the edge image as the information (real shape information) on the two-dimensional shape of the object captured in the real image obtained in step S13. The edge image as the real shape information is the edge image as the real shape information acquired in step Sa4. Step Sb13 corresponds to a first calculation step in the present invention.

More specifically, in step Sb13, the first calculation unit 6113 calculates, for each of the M1×T1 first virtual camera positions P11 as the plurality of first virtual camera positions P11 described above, a numerical value indicating the matching degree between the edge image as the information (real shape information) on the two-dimensional shape of the object captured in the real image obtained in step S13 and the reference image as the reference shape information acquired in step Sb12. The edge image as the real shape information is the edge image as the real shape information acquired in step Sa4.

Here, for example, in a case where one or more initial setting ranges for the component to be searched defined by the setting range information 58 include the first initial setting range for the first position, at the timing at which the component to be searched is located at the first position by the moving mechanism, the search processing unit 61 may cause the first calculation unit 6113 to calculate, for each of the plurality of first virtual camera positions P11 corresponding to the first initial setting range, a numerical value indicating the matching degree between the edge image as the information (real shape information) about the two-dimensional shape of the object captured in the real image obtained in step S13 and the reference image as the reference shape information obtained in step Sb12. Here, the real image capturing the component to be searched may be a real image obtained by imaging by the camera CM at the timing when the component to be searched is located at the first position by the moving mechanism.

For example, if the component to be searched is the first chuck, and it is the timing at which the first chuck is located at the open position as the first A position which is the first position by the chuck moving mechanism 17, the real image capturing the component to be searched may be a real image obtained by imaging by the camera CM at the timing when the first chuck is located at the open position by the chuck moving mechanism 17.

For example, if the component to be searched is the guard 23, and it is the timing at which the guard 23 is located at the lowered position as the first B position which is the first position by the guard moving mechanism 25, the real image capturing the component to be searched may be a real image obtained by imaging by the camera CM at the timing when the guard 23 is located at the lowered position by the guard moving mechanism 25.

For example, if the component to be searched is the nozzle 33, and it is the timing at which the nozzle 33 is located at the standby position as the first C position that is the first position by the nozzle moving mechanism 35, the real image capturing the component to be searched may be a real image obtained by imaging by the camera CM at the timing when the nozzle 33 is located at the standby position by the nozzle moving mechanism 35.

Here, for example, in a case where one or more initial setting ranges for the component to be searched defined by the setting range information 58 include the second initial setting range for the second position, at the timing when the component to be searched is located at the second position by the moving mechanism, the search processing unit 61 may cause the first calculation unit 6113 to calculate, for each of the plurality of first virtual camera positions P11 corresponding to the second initial setting range, a numerical value indicating the matching degree between the edge image as the information (real shape information) on the two-dimensional shape of the object captured in the real image obtained in step S13 and the reference image as the reference shape information obtained in step Sb12. Here, the real image capturing the component to be searched may be a real image obtained by imaging by the camera CM at the timing when the component to be searched is located at the second position by the moving mechanism.

For example, if the component to be searched is the first chuck, and it is the timing at which the first chuck is located at the closed position as the second A position which is the second position by the chuck moving mechanism 17, the real image capturing the component to be searched may be a real image obtained by imaging by the camera CM at the timing when the first chuck is located at the closed position by the chuck moving mechanism 17.

For example, if the component to be searched is the guard 23, and it is the timing at which the guard 23 is located at the raised position as the second B position which is the second position by the guard moving mechanism 25, the real image capturing the component to be searched may be a real image obtained by imaging by the camera CM at the timing when the guard 23 is located at the raised position by the guard moving mechanism 25.

For example, if the component to be searched is the nozzle 33, and it is the timing at which the nozzle 33 is located at the discharge position as the second C position that is the second position by the nozzle moving mechanism 35, the real image capturing the component to be searched may be a real image obtained by imaging by the camera CM at the timing when the nozzle 33 is located at the discharge position by the nozzle moving mechanism 35.

Here, when the numerical value indicating the matching degree between the edge image as the real shape information and the reference image as the reference shape information is calculated for each first virtual camera position P11, the first calculation unit 6113 performs, for example, the above-described processing 1a, processing 1b, and processing 1c in this order. Specifically, in step Sb13, the first calculation unit 6113 sequentially performs the processing from step Sb131 to step Sb135. The processing in step Sb132 corresponds to the above-described processing 1a, the processing in step Sb133 corresponds to the above-described processing 1b, and the processing in step Sb134 corresponds to the above-described processing 1c.

In step Sb131, the first calculation unit 6113 designates one first virtual camera position P11 and a reference image as reference shape information related to the one first virtual camera position P11 among the reference images as reference shape information for each of the plurality of first virtual camera positions P11 acquired in step Sb12 as processing targets of steps Sb132 to Sb134.

In step Sb132, for example, the first calculation unit 6113 detects a deviation amount in the direction of the two-dimensional shape of the contour between the edge image as the real shape information and the reference image as the reference shape information using the RIPOC method. Here, for example, as illustrated in FIG. 22, the first calculation unit 6113 divides the edge image Ir3 as the real shape information input from the image processing unit 59 into a plurality of comparison target regions Re1, and calculates the deviation amount γ1 in the rotation direction in which the matching degree of the contour with the reference image can be the highest for each comparison target region Re1 using the RIPOC method. The deviation amount γ1 corresponds to the roll angle γ at which the matching degree between the reference image as the reference shape information and the edge image as the real shape information can be further increased. Here, one comparison target region Re1 in which the matching degree of the contour with the reference image can be the highest among the plurality of comparison target regions Re1 and the deviation amount γ1 in the rotation direction in which the matching degree of the contour can be the highest between the one comparison target region Re1 and the reference image are detected.

In step Sb133, for example, the first calculation unit 6113 rotates the edge image as the real shape information so as to correct the deviation amount γ1 detected in step Sb132. As a result, the rotated edge image is generated, and the orientation is matched between the two-dimensional shape of the contour in the edge image as the real shape information and the two-dimensional shape of the contour in the reference image as the reference shape information. Here, for example, the first calculation unit 6113 rotates the edge image of the comparison target region Re1 detected in step Sb132 so as to correct the deviation amount γ1 detected in step Sb132. As a result, the rotated edge image is generated, and the orientation is matched between the two-dimensional shape of the contour in the comparison target region Re1 constituting the real shape information and the two-dimensional shape of the contour in the reference image as the reference shape information.

In step Sb134, for example, the first calculation unit 6113 performs template matching using the reference image as the reference shape information on the rotated edge image related to the real shape information generated in step Sb133. Here, for example, the first calculation unit 6113 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the component to be searched in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the first virtual camera position P11. Here, the numerical value indicating the matching degree may be, for example, the known matching score indicating the matching degree described above.

In step Sb135, the first calculation unit 6113 determines whether or not there are the first virtual camera position P11 and reference shape information related to the first virtual camera position P11 that have not yet been designated as the processing targets of steps Sb132 to Sb134, among the reference shape information for each of the plurality of first virtual camera positions P11 acquired in step Sb12. Here, if there are the first virtual camera position P11 and reference shape information related to the first virtual camera position P11 that have not yet been designated as the processing targets of steps Sb132 to Sb134, the processing returns to step Sb131, and the first calculation unit 6113 designates, as the processing targets of steps Sb132 to Sb134, the next one first virtual camera position P11 and reference shape information related to the one first virtual camera position P11 among the reference shape information for each of the plurality of first virtual camera positions P11 acquired in step Sb12. On the other hand, if there is no first virtual camera position P11 and reference shape information related to the first virtual camera position P11 that have not yet been designated as the processing targets of steps Sb132 to Sb134, the processing proceeds from step Sb135 to step Sb14.

In other words, the first calculation unit 6113 repeats the processing from steps Sb131 to Sb135 until there is no first virtual camera position P11 and reference shape information related to the first virtual camera position P11 that have not yet been designated as the processing targets of steps Sb132 to Sb134 in the reference shape information for each of the plurality of first virtual camera positions P11 acquired in step Sb12. As a result, the first calculation unit 6113 calculates, for each first virtual camera position P11, a numerical value indicating the matching degree between the edge image as the real shape information and the reference image as the reference shape information.

### <<<<Step Sb14>>>>

In step Sb14, the first detection unit 6114 detects the virtual camera position with high matching degree P11m, which is the first virtual camera position P11 having the highest matching degree between the edge image as the real shape information and the reference image as the reference shape information, among the plurality of first virtual camera positions P11 based on the calculation result in step Sb13. Here, for example, among the plurality of first virtual camera positions P11, the first virtual camera position P11 at which the matching score calculated in step Sb13 between the edge image as the information (real shape information) on the two-dimensional shape of the object captured in the real image and the reference image as the reference shape information is the highest is detected as the virtual camera position with high matching degree P11m. Step Sb14 corresponds to a first detection step in the present invention.

More specifically, in step Sb14, the first detection unit 6114 detects the virtual camera position with high matching degree P11m, which is the first virtual camera position P11 having the highest matching degree between the edge image as the real shape information and the reference image as the reference shape information, among the M1×T1 first virtual camera positions P11 as the plurality of first virtual camera positions P11 based on the calculation result in step Sb13. Here, for example, among the M1xT1 first virtual camera positions P11, the virtual camera position with high matching degree P11m, which is the first virtual camera position P11 at which the matching score calculated in step Sb13 between the edge image as the information (real shape information) on the two-dimensional shape of the object captured in the real image and the reference image as the reference shape information is the highest, is detected.

In step Sb14, when the virtual camera position with high matching degree P11m is detected, the first detection unit 6114 also detects the matching candidate position detected for the virtual camera position with high matching degree P11m in step Sb13 as the target component candidate position.

### <<<Step Sb2>>>

In the secondary search processing in step Sb2, the virtual camera position at which the matching degree between the reference shape information and the real shape information becomes higher is more finely searched based on the virtual camera position with high matching degree P11m detected in the primary search processing in step Sb1. In other words, in the secondary search processing in step Sb2, the virtual camera position with the maximum matching degree described above is searched for based on the virtual camera position with high matching degree P11m described above. In other words, in step Sb2, the search processing unit 61 searches for the virtual camera position with the maximum matching degree based on the virtual camera position with high matching degree P11m.

### <<<<Step Sb21>>>>

In step Sb21, the collation target region setting unit 6121 of the second search processing unit 612 sets a region (collation target region) to be used for the matching (collation) processing in step Sb24 in the edge image as the real shape information acquired in step Sa4 based on the target component candidate position detected in step Sb14. Here, with respect to the edge image, a region including the target component candidate position and having a size larger than the target component candidate position is set as the collation target region.

### <<<<Step Sb22>>>>

In step Sb22, the divided surface generation unit 6122 divides, according to the same rule, each of T2 virtual surfaces St1 including the virtual surface with high matching degree Stlm that is a virtual surface St1 in which the virtual camera position with high matching degree P11m detected by the first detection unit 6114 in step Sb14 is virtually set and having mutually different distances from the reference point Po of the 3D model 3dm of the component to be searched among the M1 virtual surfaces St1 in each of the T1 surface aggregations As1. As a result, the divided surface generation unit 6122 generates M2×T2 virtual divided surfaces St2 by generating M2 virtual divided surfaces St2 for each of the T2 virtual surfaces St1. Here, each of the T2 virtual surfaces St1 intersects a line passing through the reference point Po and the virtual camera position with high matching degree P11m on the side of the virtual camera position with high matching degree P11m with respect to the reference point Po of the 3D model 3dm of the component to be searched. Here, M1 virtual surfaces St1 in each of the T1 surface aggregations As1 are M1 virtual surfaces St1 in each of the T1 surface aggregations As1 used in the processing of step Sb12.

Here, the T2 virtual surfaces St1 have similar shapes enlarged and reduced in the radial direction with respect to the reference point Po of the 3D model 3dm of the target component. When viewed from the reference point Po of the 3D model 3dm of the target component, each of the T2 virtual surfaces St1 is divided by lines having similar shapes enlarged and reduced in the radial direction around the reference point Po, thereby generating M2×T2 virtual divided surfaces St2. As a result, in the T2 virtual surfaces St1, for each of the M2 virtual divided surfaces St2, there are T2 virtual divided surfaces St2 having similar shapes enlarged and reduced in the radial direction around the reference point Po of the 3D model 3dm of the target component. T2 may be equal to or less than T1. The same rule related to the division of the T2 virtual surfaces St1 described above may be, for example, a rule of dividing the division target surface into a plurality of surfaces by a plurality of line segments respectively connecting the center point of the division target surface to be divided and all vertices of the division target surface. If each of the plurality of virtual surfaces St1 is a triangular surface, each of the T2 virtual surfaces St1 may be divided into three virtual divided surfaces St2 by three line segments connecting each of three vertices and the first virtual camera position P11. In this case, each of the T2 virtual surfaces St1 is divided into three triangular virtual divided surfaces St2.

### <<<<Step Sb23>>>>

In step Sb23, the second shape information generation unit 6123 generates reference shape information for each of the M2×T2 second virtual camera positions P12 assuming a case where the 3D model 3dm of the target component is imaged from each of the M2×T2 second virtual camera positions P12 based on the three-dimensional design information regarding the target component stored in the storage unit 45b, or the like. The M2×T2 second virtual camera positions P12 are M2×T2 virtual camera positions set by virtually setting one virtual camera position for each of the M2×T2 virtual divided surfaces St2 generated in step Sb22. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the second virtual camera position P12. A specific example of the reference shape information is a reference image. Here, in each virtual divided surface St2, the second virtual camera position P12 is virtually set at a predetermined position of the virtual divided surface St2. A position of the center of the virtual divided surface St2 may be adopted as the predetermined position. The center of gravity of the virtual divided surface St2 may be adopted as the center of the virtual divided surface St2. The plurality of virtual divided surfaces St2 may be triangular surfaces.

### <<<<Step Sb24>>>>

In step Sb24, the second calculation unit 6124 calculates, for each of the M2×T2 second virtual camera positions P12 virtually set in step Sb23, a numerical value indicating the matching degree between the edge image as the information (real shape information) on the two-dimensional shape of the object captured in the real image obtained in step S14 and the reference image as the reference shape information generated in step Sb23. The edge image as the real shape information is the edge image as the real shape information acquired in step Sa4.

Here, when the numerical value indicating the matching degree between the edge image as the real shape information and the reference image as the reference shape information is calculated for each second virtual camera position P12, the second calculation unit 6124 performs, for example, the processing 2a, the processing 2b, and the processing 2c described above in this order. Specifically, in step Sb24, the second calculation unit 6124 sequentially performs the processing from step Sb241 to step Sb245. The processing in step Sb242 corresponds to the above-described processing 2a, the processing in step Sb243 corresponds to the above-described processing 2b, and the processing in step Sb244 corresponds to the above-described processing 2c.

In step Sb241, the second calculation unit 6124 designates one second virtual camera position P12 and a reference image as reference shape information related to the one second virtual camera position P12 among the reference images as reference shape information for each of the plurality of second virtual camera positions P12 generated in step Sb23 as the processing targets of steps Sb242 to Sb244.

In step Sb242, for example, the second calculation unit 6124 detects a deviation amount in the direction of the two-dimensional shape of the contour between the edge image as the real shape information and the reference image as the reference shape information using the RIPOC method. Here, for example, the second calculation unit 6124 detects the deviation amount y2 in the rotation direction in which the matching degree of the contour can be the highest between the collation target region set in step Sb21 in the edge image as the real shape information and the reference image. The deviation amount γ2 corresponds to the roll angle γ at which the matching degree between the reference image as the reference shape information and the edge image as the real shape information can be further increased.

In step Sb243, for example, the second calculation unit 6124 rotates the edge image as the real shape information so as to correct the deviation amount γ2 detected in step Sb242. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 so as to correct the deviation amount y2 detected in step Sb242. As a result, the rotated edge image is generated, and the orientation is matched between the two-dimensional shape of the contour in the collation target region constituting the real shape information and the two-dimensional shape of the contour in the reference image as the reference shape information.

In step Sb244, for example, the second calculation unit 6124 performs template matching using the reference image as the reference shape information on the rotated edge image related to the real shape information generated in step Sb243. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the component to be searched in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the second virtual camera position P12. Here, the numerical value indicating the matching degree may be, for example, the known matching score indicating the matching degree described above.

In step Sb245, the second calculation unit 6124 determines whether or not there are the second virtual camera position P12 and reference shape information related to the second virtual camera position P12 that have not yet been designated as the processing targets of steps Sb242 to Sb244, among the reference shape information for each of the plurality of second virtual camera positions P12 acquired in step Sb23. Here, if there are the second virtual camera position P12 and reference shape information related to the second virtual camera position P12 that have not yet been designated as the processing targets of steps Sb242 to Sb244, the processing returns to step Sb241, and the second calculation unit 6124 designates, as the processing targets of steps Sb242 to Sb244, the next one second virtual camera position P12 and reference shape information related to the next one second virtual camera position P12 among the reference shape information for each of the plurality of second virtual camera positions P12 generated in step Sb23. On the other hand, if there is no second virtual camera position P12 and reference shape information related to the second virtual camera position P12 that have not yet been designated as the processing targets of step Sb242 to step Sb244, the processing proceeds from step Sb245 to step Sb25.

In other words, the second calculation unit 6124 repeats the processing from steps Sb241 to Sb245 until there is no second virtual camera position P12 and reference shape information related to the second virtual camera position P12 that have not yet been designated as the processing targets of steps Sb242 to Sb244, in the reference shape information for each of the plurality of second virtual camera positions P12 acquired in step Sb23. As a result, the second calculation unit 6124 calculates, for each second virtual camera position P12, the numerical value indicating the matching degree between the edge image as the real shape information and the reference image as the reference shape information.

### <<<<Step Sb25>>>>

In step Sb25, the second detection unit 6125 detects the virtual camera position having the highest matching degree between the edge image as the information (real shape information) about the two-dimensional shape of the object captured in the real image obtained in step S14 and the reference image as the reference shape information generated in steps Sb12 and Sb23, among the virtual camera position with high matching degree P11m detected in step Sb14 and the above-described M2×T2 second virtual camera positions P12. The edge image as the real shape information is the edge image as the real shape information acquired in step Sa4. The virtual camera position detected here is the first reference virtual camera position Ps1, which is the virtual camera position detected first by the second detection unit 6125.

Here, for example, the matching score calculated for the virtual camera position with high matching degree P11m in step Sb13 and the matching score calculated for each of the M2×T2 second virtual camera positions P12 in step Sb24 are compared. Then, for example, among the virtual camera position with high matching degree P11m and the M2×T2 second virtual camera positions P12, the virtual camera position at which the matching score calculated between the edge image as the information (real shape information) on the two-dimensional shape of the object captured in the real image obtained in step S14 and the reference image as the reference shape information becomes the highest is detected.

### <<<<Step Sb31>>>>

In step Sb31, the search processing unit 61 performs the above-described first A processing. Here, the divided surface generation unit 6122 generates the first M3×T3 virtual divided surfaces St3.

### <<<<Step Sb32>>>>

In step Sb32, the search processing unit 61 performs the above-described first B processing. Here, the second shape information generation unit 6123 generates a reference image as reference shape information for each of the first M3×T3 third virtual camera positions P13 set in the first M3×T3 virtual divided surfaces St3 generated in step Sb31. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the third virtual camera position P13.

### <<<<Step Sb33>>>>

In step Sb33, the search processing unit 61 performs the above-described first C processing. Here, the second calculation unit 6124 calculates, for each of the first M3×T3 third virtual camera positions P13 virtually set in step Sb32, a numerical value indicating the matching degree between the edge image as the information (real shape information) on the two-dimensional shape of the object captured in the real image obtained in step S14 and the reference image as the reference shape information generated in step Sb32.

Here, when the numerical value indicating the matching degree between the edge image as the real shape information and the reference image as the reference shape information is calculated for each of the third virtual camera positions P13, the second calculation unit 6124 performs, for example, the processing 2a1, the processing 2b1, and the processing 2c1 described above in this order. Specifically, in step Sb33, the second calculation unit 6124 sequentially performs the processing from step Sb331 to step Sb335. The processing in step Sb332 corresponds to the above-described processing 2a1, the processing in step Sb333 corresponds to the above-described processing 2b1, and the processing in step Sb334 corresponds to the above-described processing 2c1.

In step Sb331, the second calculation unit 6124 designates one third virtual camera position P13 and a reference image as reference shape information related to the one third virtual camera position P13 among the reference images as the reference shape information for each of the first M3×T3 third virtual camera positions P13 generated in step Sb32 as the processing targets of steps Sb332 to Sb334.

In step Sb332, for example, the second calculation unit 6124 detects a deviation amount in the direction of the two-dimensional shape of the contour between the edge image as the real shape information and the reference image as the reference shape information using the RIPOC method. Here, the second calculation unit 6124 detects the deviation amount γ21 in the rotation direction in which the matching degree of the contour can be the highest between the collation target region set in step Sb21 in the edge image as the real shape information and the reference image. The deviation amount γ21 corresponds to the roll angle γ at which the matching degree between the reference image as the reference shape information and the edge image as the real shape information can be further increased.

In step Sb333, for example, the second calculation unit 6124 rotates the edge image as the real shape information so as to correct the deviation amount γ21 detected in step Sb332. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 in the edge image as the real shape information so as to correct the deviation amount γ21 detected in step Sb332. As a result, the rotated edge image is generated, and the orientation is matched between the two-dimensional shape of the contour in the collation target region constituting the real shape information and the two-dimensional shape of the contour in the reference image as the reference shape information.

In step Sb334, for example, the second calculation unit 6124 performs template matching using the reference image as the reference shape information on the rotated edge image related to the real shape information generated in step Sb333. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the component to be searched in the reference image becomes maximum is detected. Here, when the template matching is performed, the numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the third virtual camera position P13. Here, the numerical value indicating the matching degree may be, for example, the known matching score indicating the matching degree described above.

In step Sb335, the second calculation unit 6124 determines whether or not there are the third virtual camera position P13 and reference shape information related to the third virtual camera position P13 that have not yet been designated as the processing targets of steps Sb332 to Sb334 among the reference shape information for each of the first M3×T3 third virtual camera positions P13 generated in step Sb32. Here, if there are the third virtual camera position P13 and reference shape information related to the third virtual camera position P13 that have not yet been designated as the processing targets of steps Sb332 to Sb334, the processing returns to step Sb331, and the second calculation unit 6124 designates, as the processing targets of steps Sb332 to Sb334, the next one third virtual camera position P13 and reference shape information related to the next one third virtual camera position P13 among the reference shape information for each of the first M3×T3 third virtual camera positions P13 generated in step Sb32. On the other hand, if there is no third virtual camera position P13 and reference shape information related to the third virtual camera position P13 that have not yet been designated as the processing targets of step Sb332 to step Sb334, the processing proceeds from step Sb335 to step Sb34.

In other words, the second calculation unit 6124 repeats the processing from steps Sb331 to Sb335 until there is no third virtual camera position P13 and reference shape information related to the third virtual camera position P13 that have not yet been designated as the processing targets of steps Sb332 to Sb334 in the reference shape information for each of the first M3 ×T3 third virtual camera positions P13 generated in step Sb32. As a result, the second calculation unit 6124 calculates the numerical value indicating the matching degree between the edge image as the real shape information and the reference image as the reference shape information for each of the first M3×T3 third virtual camera positions P13.

### <<<<Step Sb34>>>>

In step Sb34, the search processing unit 61 performs the above-described first D processing. Here, the second detection unit 6125 detects a second reference virtual camera position Ps2, which is a virtual camera position having the highest matching degree between the edge image as the information (real shape information) about the two-dimensional shape of the object captured in the real image obtained in step S14 and the reference image as the reference shape information generated in step Sb12 or step Sb23 and step Sb32, among the first reference virtual camera position Ps1, which is the virtual camera position detected in step Sb25, and the first M3×T3 third virtual camera positions P13 virtually set in step Sb32.

Here, for example, the matching score calculated for the first reference virtual camera position Ps1 in step Sb13 or step Sb24 and the matching score calculated for each of the first M3×T3 third virtual camera positions P13 in step Sb33 are compared. Then, for example, among the first reference virtual camera position Ps1 and the first M3×T3 third virtual camera positions P13, the virtual camera position at which the matching score calculated between the edge image as the information (real shape information) on the two-dimensional shape of the object captured in the real image obtained in step S14 and the reference image as the reference shape information becomes the highest is detected.

### <<<<Step Sb41>>>>

In step Sb41, the search processing unit 61 sets the variable n to 2, which is an initial value.

### <<<<Step Sb42>>>>

In step Sb42, the search processing unit 61 performs the above-described n-th A processing. Here, the divided surface generation unit 6122 generates n-th M3×T3 virtual divided surfaces.

### <<<<Step Sb43>>>>

In step Sb43, the search processing unit 61 performs the above-described n-th B processing. Here, the second shape information generation unit 6123 generates a reference image as reference shape information for each of the n-th M3×T3 third virtual camera positions set by setting one virtual camera position on each of the n-th M3×T3 virtual divided surfaces generated in step Sb42. Here, the reference shape information is information generated based on the three-dimensional design information regarding the component to be searched, and is information regarding the two-dimensional shape of the 3D model 3dm of the component to be searched in the virtual image that can be acquired by imaging the 3D model 3dm of the component to be searched from the third virtual camera position.

### <<<<Step Sb44>>>>

In step Sb44, the search processing unit 61 performs the above-described n-th C processing. Here, the second calculation unit 6124 calculates, for each of the n-th M3×T3 third virtual camera positions virtually set in step Sb43, a numerical value indicating the matching degree between the edge image as the information (real shape information) on the two-dimensional shape of the object captured in the real image obtained in step S14 and the reference image as the reference shape information generated in step Sb43.

Here, when the numerical value indicating the matching degree between the edge image as the real shape information and the reference image as the reference shape information is calculated for each third virtual camera position, the second calculation unit 6124 performs, for example, the processing 2an, the processing 2bn, and the processing 2cn described above in this order. Specifically, in step Sb44, the second calculation unit 6124 sequentially performs the processing from step Sb441 to step Sb445. The processing in step Sb442 corresponds to the above-described processing 2an, the processing in step Sb443 corresponds to the above-described processing 2bn, and the processing in step Sb444 corresponds to the above-described processing 2cn.

In step Sb441, the second calculation unit 6124 designates one third virtual camera position and a reference image as reference shape information related to the one third virtual camera position among the reference images as reference shape information for each of the n-th M3×T3 third virtual camera positions generated in step Sb43 as the processing targets of steps Sb442 to Sb444.

In step Sb442, for example, the second calculation unit 6124 detects a deviation amount in the direction of the two-dimensional shape of the contour between the edge image as the real shape information and the reference image as the reference shape information using the RIPOC method. Here, the second calculation unit 6124 detects the deviation amount γ2n in the rotation direction in which the matching degree of the contour can be the highest between the collation target region set in step Sb21 in the edge image as the real shape information and the reference image. The deviation amount y2n corresponds to the roll angle γ at which the matching degree between the reference image as the reference shape information and the edge image as the real shape information can be further increased.

In step Sb443, for example, the second calculation unit 6124 rotates the edge image as the real shape information so as to correct the deviation amount γ2n detected in step Sb442. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 in the edge image as the real shape information so as to correct the deviation amount y2n detected in step Sb442. As a result, the rotated edge image is generated, and the orientation is matched between the two-dimensional shape of the contour in the collation target region constituting the real shape information and the two-dimensional shape of the contour in the reference image as the reference shape information.

In step Sb444, for example, the second calculation unit 6124 performs template matching using the reference image as the reference shape information on the rotated edge image related to the real shape information generated in step Sb443. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the component to be searched in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the third virtual camera position. Here, the numerical value indicating the matching degree may be, for example, the known matching score indicating the matching degree described above.

In step Sb445, the second calculation unit 6124 determines whether or not there are the third virtual camera position and reference shape information related to the third virtual camera position that have not yet been designated as the processing targets of steps Sb442 to Sb444 among the reference shape information for each of the n-th M3×T3 third virtual camera positions generated in step Sb43. Here, if there are the third virtual camera position and reference shape information related to the third virtual camera position that have not yet been designated as the processing targets of steps Sb442 to Sb444, the processing returns to step Sb441, and the second calculation unit 6124 designates the next one third virtual camera position and the reference shape information related to the one third virtual camera position among the reference shape information for each of the n-th M3×T3 third virtual camera positions generated in step Sb43 as the processing targets of steps Sb442 to Sb444. On the other hand, if there is no third virtual camera position and reference shape information related to the third virtual camera position that have not yet been designated as the processing targets of step Sb442 to step Sb444, the processing proceeds from step Sb445 to step Sb45.

In other words, the second calculation unit 6124 repeats the processing from steps Sb441 to Sb445 until there is no third virtual camera position and reference shape information related to the third virtual camera position that have not yet been designated as the processing targets of steps Sb442 to Sb444 in the reference shape information for each of the n-th M3×T3 third virtual camera positions generated in step Sb43. As a result, the second calculation unit 6124 calculates, for each of the n-th M3×T3 third virtual camera positions, the numerical value indicating the matching degree between the edge image as the real shape information and the reference image as the reference shape information.

### <<<<Step Sb45>>>>

In step Sb45, the search processing unit 61 performs the above-described n-th D processing. Here, the second detection unit 6125 detects a virtual camera position having the highest matching degree between the edge image as the information (real shape information) on the two-dimensional shape of the object captured in the real image and the reference image as the reference shape information, among the n-th reference virtual camera position which is the virtual camera position detected in step Sb34 or (n-1)-th step Sb45, and the n-th M3×T3 third virtual camera positions virtually set in step Sb43.

Here, for example, the matching score calculated for the n-th reference virtual camera position in step Sb13, step Sb24, step Sb33, or (n-1)-th step Sb44 and the matching score calculated for each of the n-th M3×T3 third virtual camera positions calculated in step Sb44 are compared. Then, for example, among the n-th reference virtual camera position and the n-th M3×T3 third virtual camera positions, the virtual camera position at which the matching score calculated between the edge image as the information (real shape information) on the two-dimensional shape of the object captured in the real image obtained in step S14 and the reference image as the reference shape information becomes the highest is detected.

### <<<<Steps Sb46, Sb47>>>>

In step Sb46, the search processing unit 61 determines whether or not a condition for ending the second search processing (also referred to as an end condition) is satisfied. Here, if the end condition is not satisfied, in step Sb47, the search processing unit 61 adds 1 to the variable n, and the processing returns from step Sb47 to step Sb42. On the other hand, if the end condition is satisfied, the processing proceeds from step Sb46 to step Sb48. In other words, the processing from step Sb42 to step Sb47 is repeatedly performed until the end condition is satisfied.

Here, the end condition may be, for example, that one reference virtual camera position among from the first reference virtual camera position Ps1 to the n-th reference virtual camera positions has been continuously detected by the second detection unit 6125 a first predetermined number of times set in advance. Furthermore, the end condition may be, for example, that the n-th unit processing has been executed a second predetermined number of times set in advance in the second search processing. In other words, the end condition may be, for example, that n-1 times, which is the number of times the n-th unit processing has been performed in the second search processing, have reached the second predetermined number of times.

### <<<<Step Sb48>>>>

In step Sb48, the search processing unit 61 recognizes the result of the search processing. Specifically, the search processing unit 61 detects, as the virtual camera position with the maximum matching degree, a virtual camera position having the highest matching degree between the real shape information and the reference shape information detected by the second detection unit 6125 in the last step Sb45 in the second search processing. In other words, the virtual camera position having the highest matching degree between the real shape information and the reference shape information detected by the second detection unit 6125 in the last step Sb45 in the second search processing is the virtual camera position with the maximum matching degree. Then, the search processing unit 61 acquires, as a result of the search processing, the latitude α, the longitude β, and the distance D that define the virtual camera position with the maximum matching degree, and the roll angle γ corresponding to the deviation amount (the deviation amount γ1, the deviation amount γ2, the deviation amount γ21 or the deviation amount γ2n) calculated by the first calculation unit 6113 or the second calculation unit 6124 for the virtual camera position with the maximum matching degree. As a result, the posture of the component to be searched captured in the real image can be recognized. Here, the search processing unit 61 may recognize, as the information regarding the posture of the component to be searched, for example, the latitude α, the longitude β, and the distance D that define the virtual camera position with the maximum matching degree, and the roll angle γ corresponding to the deviation amount (the deviation amount γ1, the deviation amount γ2, the deviation amount γ21 or the deviation amount γ2n) calculated by the first calculation unit 6113 or the second calculation unit 6124 for the virtual camera position with the maximum matching degree as a result of the search processing.

Furthermore, here, the search processing unit 61 may acquire, as part of the result of the search processing, a matching candidate position (final matching position) at which the matching degree (similarity) with the reference image as the reference shape information in the edge image as the real shape information becomes maximum, detected in step Sb13, step Sb24, step Sb33, or step Sb44 for the virtual camera position with the maximum matching degree.

### <<Step S16>>

In step S16, if the matching degree between the reference shape information and the real shape information calculated in step S15 for the virtual camera position with the maximum matching degree detected in step S15 (specifically, step Sb48) is lower than a predetermined matching degree set in advance, the abnormality detection unit 63 detects an abnormality of the component to be searched. Here, for example, in a case where the matching score as the numerical value indicating the matching degree (similarity) increases as the matching degree increases, the fact that the matching degree between the reference shape information and the real shape information for the virtual camera position with the maximum matching degree is lower than the predetermined matching degree may mean that the matching score as the numerical value indicating the matching degree between the reference shape information and the real shape information for the virtual camera position with the maximum matching degree is lower than the predetermined matching score set in advance. Furthermore, for example, in a case where the matching score as the numerical value indicating the matching degree (similarity) decreases as the matching degree increases, the fact that the matching degree between the reference shape information and the real shape information for the virtual camera position with the maximum matching degree is lower than the predetermined matching degree may mean that the matching score as the numerical value indicating the matching degree between the reference shape information and the real shape information for the virtual camera position with the maximum matching degree is higher than the predetermined matching score set in advance. The predetermined matching score may be set for each target component.

### <<Step S17>>

In step S17, the abnormality detection unit 63 determines whether or not an abnormality has been detected for the component to be searched in step S16. Here, if no abnormality is detected for the component to be searched in step S16, the processing returns from step S17 to step S12. On the other hand, if an abnormality has been detected for the component to be searched in step S17, the processing proceeds from step S17 to step S18.

### <<Step S18>>

In step S18, the abnormality detection unit 63 causes the notification unit 49 to perform notification operation. As a result, the abnormality detection unit 63 causes the notification unit 49 to perform the notification operation in response to the detection of the abnormality of the component to be searched. Here, for example, the notification unit 49 may make a notification of not only occurrence of the abnormality but also one or more pieces of information among the information specifying the component to be searched as the target component in which the abnormality has been detected and position information of the component to be searched as the target component in which the abnormality has been detected.

### <<Step S19>>

In step S19, for example, the operator stops operation of the substrate processing apparatus 1 in response to the notification by the notification unit 49. As a result, in the substrate processing apparatus 1, it is possible to avoid a problem that processing is sequentially performed on the plurality of substrates W in a state where an abnormality exists. As a result, occurrence of defective processing on the substrate W can be avoided. If the processing in step S19 is performed, the operation related to the processing of detecting an abnormality in the substrate processing apparatus 1 indicated in FIG. 38 ends.

### <<Step S20>>

In step S20, the operation control unit 51 determines whether or not the processing on one or more substrates W in the substrate processing apparatus 1 has been completed. Here, for example, it is determined whether or not the operation related to the processing on one or more substrates W in the substrate processing apparatus 1 indicated in FIG. 37 has been completed. Here, if the operation related to the processing on one or more substrates W in the substrate processing apparatus 1 has not been completed, the processing returns from step S20 to step S12. Thus, as long as the operation related to the processing on one or more substrates W in the substrate processing apparatus 1 is performed, the processing from step S12 to step S17 is repeatedly performed. Then, if the operation related to the processing on one or more substrates W in the substrate processing apparatus 1 has been completed, the operation related to the processing of detecting an abnormality in the substrate processing apparatus 1 indicated in FIG. 38 is ended.

Note that, in the substrate processing apparatus 1, for example, various kinds of processing related to the information such as storage of information, acquisition of image information, and image processing are performed in the processing in step S11 corresponding to a storage step, the processing in step S13 corresponding to an imaging step, and the processing in step S15 corresponding to a search step. Thus, in the first embodiment, it can be said that an information processing method in the substrate processing apparatus 1 including one or more target components includes the storage step, the imaging step, and the search step. Further, step S15 corresponding to the search step includes step Sb12 corresponding to a first shape information acquisition step, step Sb13 corresponding to a first calculation step, and step Sb14 corresponding to a first detection step.

### <5. Conclusion>

As described above, in the substrate processing apparatus 1 according to the first embodiment, for example, the search processing of searching for the virtual camera position with the maximum matching degree having the highest matching degree between the reference shape information and the real shape information among the plurality of virtual camera positions is executed based on the reference shape information on the two-dimensional shape of the 3D model 3dm of the component to be searched in each of the plurality of virtual images that can be acquired by imaging the 3D model 3dm of the component to be searched from the plurality of virtual camera positions and the real shape information on the two-dimensional shape of the object captured in the real image capturing the component to be searched. The reference shape information is generated, for each of the plurality of virtual camera positions, for example, based on the three-dimensional design information regarding the component to be searched that is any one target component among one or more target components. When this search processing is performed, the reference shape information on the two-dimensional shape of the 3D model 3dm of the component to be searched generated for each of the plurality of first virtual camera positions P11 assuming a case where the 3D model 3dm of the component to be searched is imaged from each of the plurality of first virtual camera positions P11 located along the plurality of virtual spherical surfaces Sv1 surrounding the 3D model 3dm centered around the reference point Po of the 3D model 3dm of the component to be searched and corresponding to one or more initial setting ranges for the component to be searched, based on the three-dimensional design information regarding the component to be searched and the setting range information 58 defining one or more initial setting ranges related to the virtual camera position with respect to the target component, is acquired. Next, for each of the plurality of first virtual camera positions P11, the numerical value indicating the matching degree between the real shape information on the two-dimensional shape of the object in the real image capturing the component to be searched and the reference shape information is calculated. Next, the virtual camera position with high matching degree P11m, which is the first virtual camera position P11 having the highest matching degree between the real shape information and the reference shape information among the plurality of first virtual camera positions P11, is detected. Then, the virtual camera position with the maximum matching degree is searched based on the virtual camera position with high matching degree P1 1m.

By adopting the above configuration, in a case where the range of the position and the posture of the component to be searched is limited, the range in which the plurality of first virtual camera positions P11 is set is limited, so that the amount of calculation of the search processing for searching for the virtual camera position with the maximum matching degree can be reduced. As a result, the amount of calculation for recognizing the posture of the component to be searched captured in the real image can be reduced. Thus, the substrate processing apparatus 1 can efficiently recognize the posture of the component to be searched.

### <6. Modification>

The present invention is not limited to the above-described first embodiment, and various modifications and improvements can be made without departing from the gist of the present invention.
(1) In the first embodiment described above, the search processing unit 61 sequentially performs the following [processing i], the following [processing ii], and the following [processing iii] at the timing when the component to be searched is located at the first position by the moving mechanism, and the abnormality detection unit 63 detects the abnormality of the component to be searched if the matching degree between the reference shape information and the real shape information for the virtual camera position with the maximum matching degree calculated by the search processing unit 61 is lower than the predetermined matching degree set in advance, but the present invention is not limited thereto.

### [Processing i]

The search processing unit 61 acquires, by the first shape information acquisition unit 6112, the reference shape information generated for each of the plurality of first virtual camera positions P11 corresponding to the first initial setting range assuming a case where the 3D model 3dm of the component to be searched is imaged from each of the plurality of first virtual camera positions P11 corresponding to the first initial setting range for the component to be searched based on the three-dimensional design information regarding the component to be searched and the setting range information 58 stored in the storage unit 45b, or the like.

### [Processing ii]

The search processing unit 61 calculates, by the first calculation unit 6113, for each of the plurality of first virtual camera positions P11 corresponding to the first initial setting range for the component to be searched, the numerical value indicating the matching degree between the reference shape information and the information (real shape information) on the two-dimensional shape of the object captured in the real image captured by the camera CM at the timing when the component to be searched is located at the first position by the moving mechanism.

### [Processing iii]

The search processing unit 61 detects, by the first detection unit 6114, the virtual camera position with high matching degree P11m, which is the first virtual camera position P11 having the highest matching degree between the information (real shape information) on the two-dimensional shape of the object captured in the real image obtained by imaging by the camera CM at the timing when the component to be searched is located at the first position by the moving mechanism and the reference shape information, among the plurality of first virtual camera positions P11 corresponding to the first initial setting range for the component to be searched, based on the calculation result by the first calculation unit 6113.

For example, at the timing at which the component to be searched is located at the first position by the moving mechanism, the search processing unit 61 may sequentially perform the following [processing iv], the following [processing v], and the following [processing vi], and if the virtual camera position with the maximum matching degree detected by the search processing unit 61 is a position belonging to the second initial setting range, the abnormality detection unit 63 may detect an abnormality of the component to be searched. Here, the plurality of first virtual camera positions P11 corresponding to both the first initial setting range and the second initial setting range for the component to be searched may be a plurality of first virtual camera positions P11 virtually set within a range over both the first initial setting range and the second initial setting range for the component to be searched. Here, both the first initial setting range and the second initial setting range correspond to at least one initial setting range of one or more initial setting ranges for the component to be searched described above. In other words, at least one initial setting range of the one or more initial setting ranges for the component to be searched described above is both the first initial setting range and the second initial setting range.

### [Processing iv]

The search processing unit 61 acquires, by the first shape information acquisition unit 6112, the reference shape information generated for each of the plurality of first virtual camera positions P11 corresponding to both the first initial setting range and the second initial setting range assuming a case where the 3D model 3dm of the component to be searched is imaged from each of the plurality of first virtual camera positions P11 corresponding to both the first initial setting range and the second initial setting range for the component to be searched based on the three-dimensional design information regarding the component to be searched and the setting range information 58 stored in the storage unit 45b, or the like.

### [Processing v]

The search processing unit 61 calculates, by the first calculation unit 6113, for each of the plurality of first virtual camera positions P11 corresponding to both the first initial setting range and the second initial setting range, the numerical value indicating the matching degree between the reference shape information and the information (real shape information) on the two-dimensional shape of the object captured in the real image obtained by imaging by the camera CM at the timing when the component to be searched is located at the first position by the moving mechanism.

### [Processing vi]

The search processing unit 61 detects, by the first detection unit 6114, the virtual camera position with high matching degree P11m, which is the first virtual camera position P11 having the highest matching degree between the information (real shape information) on the two-dimensional shape of the object captured in the real image obtained by imaging by the camera CM at the timing when the component to be searched is located at the first position by the moving mechanism and the reference shape information, among the plurality of first virtual camera positions P11 corresponding to both the first initial setting range and the second initial setting range, based on the calculation result by the first calculation unit 6113.

If such a configuration is adopted, in a case where the component to be searched moves between the first position and the second position, an abnormality that the component to be searched is located at the second position at a timing when the component to be searched is located at the first position can be easily detected. Here, the information that the component to be searched in which the abnormality has been detected is located at the second position is obtained, and thus, the abnormality detection unit 63 may cause the notification unit 49 to notify the operator, or the like, that the component to be searched in which the abnormality has been detected is located at the second position together with occurrence of the abnormality and the information for specifying the component to be searched in which the abnormality has been detected. A notification of the fact that the component to be searched in which the abnormality has been detected is located at the second position may be made by, for example, a character string or a speech indicating a name, a symbol, or the like, for specifying the position.

For example, if the chuck 9 as the component to be searched is located at the closed position as the second position (more specifically, the second A position) at the timing when the chuck 9 as the component to be searched is located at the open position as the first position (more specifically, the first A position), the operator, or the like, may be notified of occurrence of the abnormality that the chuck 9 as the component to be searched is located at the closed position by the notification unit 49. For example, if the guard 23 as the component to be searched is located at the raised position as the second position (more specifically, the second B position) at the timing when the guard 23 as the component to be searched is located at the lowered position as the first position (more specifically, the first B position), the operator, or the like, may be notified of occurrence of the abnormality that the guard 23 as the component to be searched is located at the raised position by the notification unit 49. For example, if the nozzle 33 as the component to be searched is located at the discharge position as the second position (more specifically, the second C position) at the timing when the nozzle 33 as the component to be searched is located at the standby position as the first position (more specifically, the first C position), the operator, or the like, may be notified of the occurrence of the abnormality that the nozzle 33 as the component to be searched is located at the discharge position by the notification unit 49.

Here, for example, the first position and the second position may be reversed.

For example, in a case where the target component is the chuck 9, the first A position as the first position may be the closed position, and the second A position as the second position may be the open position. In this case, for example, if the chuck 9 as the component to be searched is located at the open position as the second position (more specifically, the second A position) at the timing when the chuck 9 as the component to be searched is located at the closed position as the first position (more specifically, the first A position), the operator, or the like, may be notified of occurrence of the abnormality that the chuck 9 as the component to be searched is located at the open position by the notification unit 49.

For example, in a case where the target component is the guard 23, the first B position as the first position may be the raised position, and the second B position as the second position may be the lowered position. In this case, for example, if the guard 23 as the component to be searched is located at the lowered position as the second position (more specifically, the second B position) at the timing when the guard 23 as the component to be searched is located at the raised position as the first position (more specifically, the first B position), the operator, or the like, may be notified of occurrence of the abnormality that the guard 23 as the component to be searched is located at the lowered position by the notification unit 49.

For example, in a case where the target component is the nozzle 33, the first C position as the first position may be the discharge position, and the second C position as the second position may be the standby position. In this case, for example, if the nozzle 33 as the component to be searched is located at the standby position as the second position (more specifically, the second C position) at the timing when the nozzle 33 as the component to be searched is located at the discharge position as the first position (more specifically, the first C position), the operator, or the like, may be notified of occurrence of the abnormality that the nozzle 33 as the component to be searched is located at the standby position by the notification unit 49.

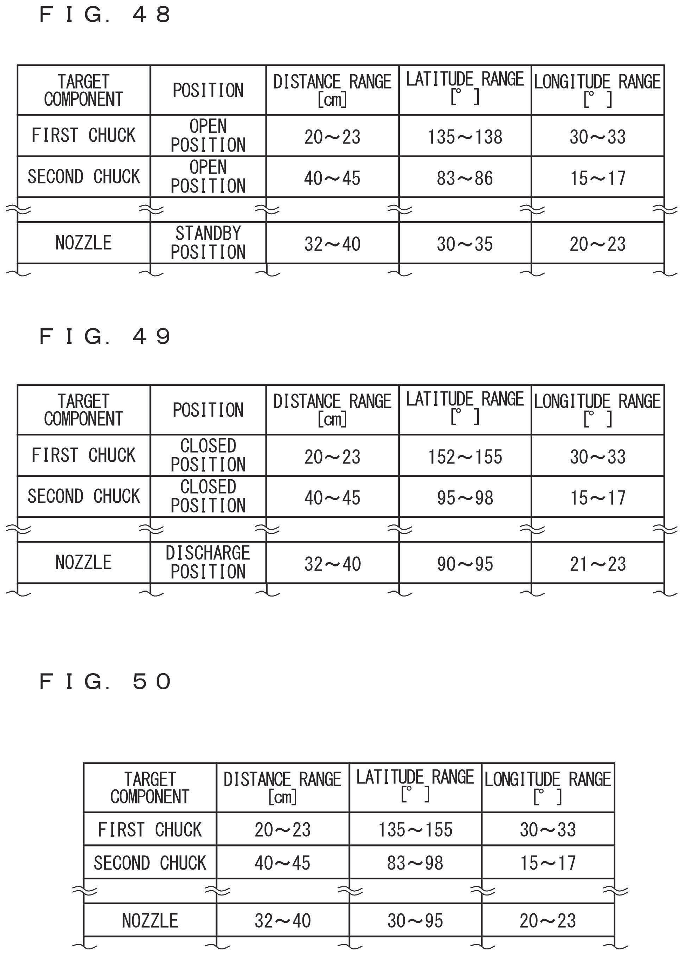

(2) In the first embodiment described above, the one or more initial setting ranges for the target component defined by the setting range information 58 include the first initial setting range for the first position and the second initial setting range for the second position, but the present invention is not limited thereto. For example, one or more initial setting ranges for the target component defined by the setting range information 58 may be one of the first initial setting range for the first position and the second initial setting range for the second position. In other words, one or more initial setting ranges for the target component defined by the setting range information 58 may be, for example, a first initial setting range for the first position as indicated in FIG. 48, or may be, for example, a second initial setting range for the second position as indicated in FIG. 49. For example, if the timing at which the target component is located at the second position is not the confirmation required timing, one or more initial setting ranges for the target component do not have to include the second initial setting range for the second position. For example, if the timing at which the target component is located at the first position is not the confirmation required timing, one or more initial setting ranges for the target component do not have to include the first initial setting range for the first position.

(3) In the first embodiment described above, each initial setting range defined by the setting range information 58 may be, for example, a numerical range corresponding to a movement range of the target component in the substrate processing apparatus 1. In this case, for example, as indicated in FIG. 50, one or more initial setting ranges for the target component defined by the setting range information 58 do not have to include the first initial setting range for the first position and the second initial setting range for the second position, and may include one initial setting range for each target component. Also here, each initial setting range can also be set based on, for example, the three-dimensional design information related to components constituting the substrate processing apparatus 1 included in the design information 57. More specifically, for example, each initial setting range may be set based on a relationship such as all relative positions and postures between the 3D model of the target component and the camera CM that may occur when the target component moves between the first position and the second position.

(4) In the first embodiment described above, for example, the search processing unit 61 may recognize information (also referred to as reality information) regarding the posture of the component to be searched based on the virtual camera position with the maximum matching degree detected using the real image by the search processing. For example, the search processing unit 61 may recognize, as the reality information regarding the posture of the component to be searched, the latitude α, the longitude β, and the distance D that define the virtual camera position with the maximum matching degree, and the roll angle γ corresponding to the deviation amount (the deviation amount γ1, the deviation amount γ2, the deviation amount γ21 or the deviation amount γ2n) calculated by the first calculation unit 6113 or the second calculation unit 6124 for the virtual camera position with the maximum matching degree as a result of the search processing. This reality information is based on a real image capturing the component to be searched, and is information indicating a state in which the component to be searched is actually located in the substrate processing apparatus 1 at the confirmation required timing. The search processing unit 61 may output the reality information to the abnormality detection unit 63.

Moreover, for example, the abnormality detection unit 63 may detect the abnormality of the component to be searched by comparing the reality information regarding the posture of the component to be searched recognized based on the virtual camera position with the maximum matching degree detected by the search processing unit 61 with information (also referred to as normal information) regarding the posture of the component to be searched based on the three-dimensional design information in a case where the state of the component to be searched is normal. More specifically, for example, the abnormality detection unit 63 may detect an abnormality of the component to be searched in a case where the reality information does not match the normal information as a result of comparison between the reality information and the normal information for the component to be searched. Here, for example, each of the reality information regarding the posture of the component to be searched and the normal information regarding the posture of the component to be searched may be information regarding the latitude α, the longitude β, the distance D, and the roll angle γ. In the first embodiment, the amount of calculation of the search processing of searching for the virtual camera position with the maximum matching degree can be reduced, and thus, the posture of the component to be searched captured in the real image can be efficiently recognized. As a result, an abnormality of the component to be searched can be efficiently detected.

Here, the normal information regarding the posture of the component to be searched can be set based on, for example, the three-dimensional design information regarding the component to be searched and the camera CM. The normal information regarding the posture of the component to be searched may be information regarding the posture of the component to be searched in a case where the component to be searched is located at a position where the component to be searched should be originally located at the confirmation required timing. The normal information regarding the posture of the component to be searched may include, for example, information regarding the posture of the component to be searched in a case where the component to be searched is located within an allowable range. The allowable range indicates a range that is allowable even if the component to be searched deviates from the original position in a case where the component to be searched normally operates at the confirmation required timing. This allowable range may be, for example, a range that is related to deviation of the component to be searched and is allowable as the processing on the substrate W even if the component to be searched as the target component at the confirmation required timing deviates from the position and the angle intended as design based on the processing on the substrate W. Information of the allowable range for each of the one or more target components may be included in the parameter information 55, for example. The allowable range may be arbitrarily set, for example, by the operator operating the instruction unit 47. In a case where the normal information regarding the posture of the component to be searched includes the information of the allowable range, the fact that the reality information matches the normal information includes that the information regarding any posture of the component to be searched within the allowable range of the normal information matches the information regarding the posture of the component to be searched in the reality information. Furthermore, here, the normal information regarding the component to be searched does not have to include information regarding the posture of the component to be searched in a case where the posture is within the allowable range. In other words, the normal information regarding the target component may be set based on one piece of three-dimensional design information indicating that the target component is normal.

(5) In the first embodiment described above, the chuck 9, the guard 23, and the nozzle 33 have been described as examples of one or more target components. However, the present invention is not limited to such a configuration. For example, as in the first embodiment described above, the one or more target components may be two or more target components, or may be one target component. For example, the component to be searched that is a component to be subjected to the search processing may be one or more target components of the chuck 9, the guard 23, and the nozzle 33, or may be another one or more target components that perform various kinds of movement such as rotational movement or parallel movement among the components constituting the substrate processing apparatus 1. Furthermore, in a case where the one or more target components are one target component, the setting range information 58 may define one or more initial setting ranges related to the virtual camera position for the one target component as at least one target component among the one target components as the one or more target components.

(6) In the first embodiment described above, the virtual camera position is defined by a plurality of parameters such as the latitude α, the longitude β, and the distance D, but the present invention is not limited thereto. For example, the virtual camera position may be defined by a plurality of parameters according to other rules, such as a spherical coordinate system. In this case, the initial setting range may also be defined by a plurality of parameters according to other rules.

(7) In the first embodiment, the substrate processing apparatus 1 includes one camera CM, but the present invention is not limited thereto. For example, the substrate processing apparatus 1 may include two or more cameras CM. In other words, the substrate processing apparatus 1 may include one or more cameras CM that obtain, by imaging, a real image capturing the component to be searched that is any one target component among the one or more target components. Here, for example, the substrate processing apparatus 1 may include a dedicated camera CM for each target component.

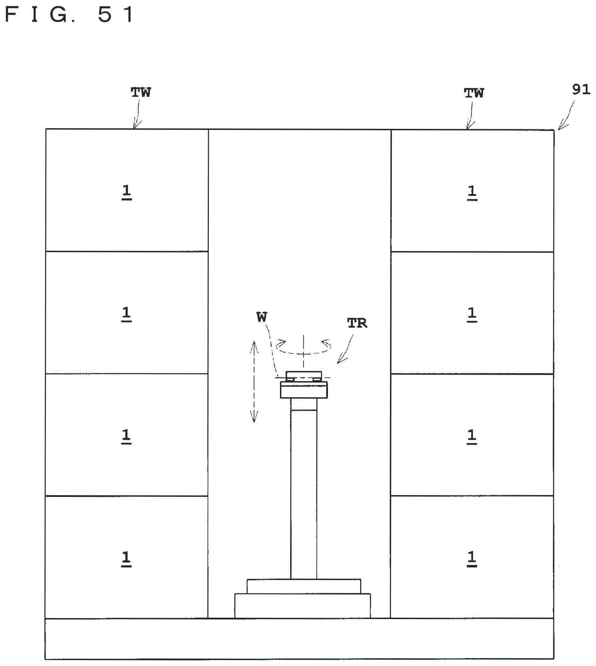

(8) In the first embodiment described above, a single substrate processing apparatus 1 has been described, but a substrate processing system 91 including a plurality of substrate processing apparatuses 1 may be employed. FIG. 51 is a view schematically illustrating an example of a schematic configuration of the substrate processing system 91. The substrate processing system 91 includes, for example, a plurality of stacked substrate processing apparatuses 1. The substrate processing system 91 includes, for example, a plurality of towers TW each formed by stacking four substrate processing apparatuses 1. In the substrate processing system 91, the plurality of towers TW is located in a state of being separated from each other and facing each other. The substrate processing system 91 includes a transportation robot TR located between the plurality of towers TW. The transportation robot TR is configured to be movable up and down in a height direction. The transportation robot TR has a configuration capable of advancing and retracting an arm (not illustrated) with respect to the substrate processing apparatus 1. The transportation robot TR can carry in and out the substrate W to and from each of the plurality of substrate processing apparatuses 1. Also in the substrate processing system 91 having the above-described configuration, each substrate processing apparatus 1 exhibits the above-described effects.

(9) In the first embodiment described above, the edge image extracted from the real image has been described as an example of the real shape information on the two-dimensional shape of the object in the real image. Then, as an example of the reference shape information on the two-dimensional shape of the 3D model 3dm of the component to be searched in the virtual image, the reference image indicating the contour as the two-dimensional shape of the 3D model 3dm of the component to be searched in the virtual image that can be acquired by imaging the 3D model 3dm of the component to be searched from the virtual camera position has been described. However, the present invention is not limited thereto. The real shape information on the two-dimensional shape of the object in the real image may be, for example, information indicating a feature of the two-dimensional shape of the object in the real image. Further, the reference shape information about the two-dimensional shape of the 3D model 3dm of the component to be searched in the virtual image may be, for example, information indicating a feature of the two-dimensional shape of the 3D model 3dm of the component to be searched in the virtual image. For example, as described above in the first embodiment, if the contour of the object in the real image is adopted as an example of the feature of the two-dimensional shape of the object in the real image, an example of the real shape information may be an edge image indicating the two-dimensional shape of the object in the real image. The edge image can be acquired from the real image by, for example, processing of extracting the contour of the object in the real image by the image processing unit 59. In addition, for example, as described above in the first embodiment, if the contour as the two-dimensional shape of the 3D model 3dm of the component to be searched in the virtual image is adopted as an example of the feature of the two-dimensional shape of the 3D model 3dm of the component to be searched in the virtual image, an example of the reference shape information may be a reference image indicating the two-dimensional shape of the 3D model 3dm in the virtual image. The reference image may be, for example, an image indicating the contour as the two-dimensional shape of the 3D model 3dm in the virtual image generated by projecting the 3D model 3dm on a virtual plane by processing such as rendering. Meanwhile, the real shape information on the two-dimensional shape of the object in the real image may be, for example, an image (also referred to as a real feature point image) including a plurality of feature points obtained by extracting a plurality of feature points such as a plurality of corners that characterize the two-dimensional shape of the object in the real image from the real image. In other words, for example, if a plurality of feature points such as a plurality of corners of the two-dimensional shape of the object in the real image is adopted as an example of the feature of the two-dimensional shape of the object in the real image, an example of the real shape information may be a real feature point image including a plurality of feature points. A plurality of feature points such as a plurality of corners of the two-dimensional shape of the object in the real image can be detected, for example, in the edge image acquired from the real image by the image processing unit 59. For example, in a case where the real shape information is the above-described real feature point image, the reference shape information may be an image (also referred to as a reference feature point image) that specifies the positions of a plurality of feature points such as a plurality of corners that characterize the two-dimensional shape of the 3D model 3dm of the component to be searched in the virtual image that can be acquired by imaging the 3D model 3dm of the component to be searched from the virtual camera position. In other words, for example, if a plurality of feature points such as a plurality of corners of the two-dimensional shape of the 3D model 3dm of the component to be searched in the virtual image is adopted as an example of the feature of the two-dimensional shape of the 3D model 3dm of the component to be searched in the virtual image, an example of the reference shape information may be a reference feature point image specifying the positions of the plurality of feature points. The plurality of feature points such as the plurality of corners of the two-dimensional shape of the 3D model 3dm of the component to be searched in the virtual image can be detected in the reference image, for example. Here, for example, in a case where the real shape information is a real feature point image and the reference shape information is a reference feature point image, the matching score as the numerical value indicating the matching degree (similarity) between the real feature point image as the real shape information and the reference feature point image as the reference shape information may be, for example, the number of matching feature points in a case where the number of matching feature points is the highest when the reference feature point image is scanned in the rotated real feature point image. Furthermore, in this case, if the matching score is high, the matching degree (similarity) between the real feature point image as the real shape information and the reference feature point image as the reference shape information is high.

(10) In the first embodiment described above, if each virtual surface St1 is a triangle, the virtual surface with high matching degree St1m is divided into the three virtual divided surfaces St2 by three line segments connecting three vertices and the virtual camera position with high matching degree P11m, respectively, but the present invention is not limited thereto. The virtual surface with high matching degree St1m may be divided into a plurality of virtual divided surfaces St2 by other rules, for example. For example, the virtual surface with high matching degree Stlm may be divided into four virtual divided surfaces St2 by three line segments respectively connecting midpoints of respective sides. Here, the midpoint of each side may be, for example, a point slightly shifted from the midpoint of each side. In this case, each of the T2 virtual surfaces St1 may be divided into a plurality of virtual divided surfaces St2 according to other rules, similarly to the virtual surface with high matching degree St1m.

(11) In the first embodiment described above, in the first A processing, if each of the first T3 virtual divided surfaces is a triangle, each of the first T3 virtual divided surfaces is divided into the three virtual divided surfaces which are the M3 virtual divided surfaces by three line segments connecting the three vertices and the center point of the triangle, respectively, but the present invention is not limited thereto. Each of the first T3 virtual divided surfaces may be divided into a plurality of M3 virtual divided surfaces according to another rule, for example. For example, each of the first T3 virtual divided surfaces may be divided into four virtual divided surfaces which are M3 virtual divided surfaces by three line segments respectively connecting midpoints of respective sides. As a result, the first M3×T3 virtual divided surfaces as the M3×T3 virtual divided surfaces may be generated. Here, the midpoint of each side may be, for example, a point slightly shifted from the midpoint of each side.

(12) In the first embodiment described above, in the n-th A processing, if each of the n-th T3 virtual divided surfaces is a triangle, each of the n-th T3 virtual divided surfaces is divided into three virtual divided surfaces that are the n-th M3 virtual divided surfaces by three line segments connecting three vertices and the center point of the triangle, respectively, but the present invention is not limited thereto. Each of the n-th T3 virtual divided surfaces may be divided into a plurality of M3 virtual divided surfaces according to another rule, for example. For example, each of the n-th T3 virtual divided surfaces may be divided into four virtual divided surfaces which are the n-th M3 virtual divided surfaces by three line segments respectively connecting midpoints of respective sides. As a result, the n-th M3×T3 virtual divided surfaces may be generated. Here, the midpoint of each side may be, for example, a point slightly shifted from the midpoint of each side.

(13) In the first embodiment described above, each of the plurality of virtual surfaces St1 constituting the surface aggregation As1 may be, for example, a curved surface. In this case, for example, the surface aggregation As1 may be a spherical body. If the surface aggregation As1 is a spherical body, the plurality of virtual surfaces St1 may be curved surfaces constituting part of the spherical surface. In this case, the plurality of virtual surfaces St1 may be, for example, a plurality of virtual surfaces generated by dividing the spherical surface for each first predetermined angle in a latitude direction and for each second predetermined angle in a longitude direction. For example, an angle of about several degrees to 10 degrees may be adopted as the first predetermined angle and the second predetermined angle. Then, the virtual surface with high matching degree Stlm may be divided into a plurality of virtual divided surfaces St2, for example, by being divided into two in each of the longitude direction and the latitude direction. Furthermore, the rule for dividing the virtual divided surface may be defined by an angle in each of the longitude direction and the latitude direction.

(14) In the first embodiment described above, the search processing unit 61 does not have to perform the n-th unit processing. In this case, the search processing unit 61 may detect, as the virtual camera position with the maximum matching degree, a virtual camera position having the highest matching degree between the real shape information and the reference shape information detected by the second detection unit 6125 in the first D processing in the first unit processing. In other words, the virtual camera position having the highest matching degree between the real shape information and the reference shape information detected by the second detection unit 6125 in the first D processing in the first unit processing may be the virtual camera position with the maximum matching degree. Then, for example, the search processing unit 61 may acquire, as a result of the search processing, the latitude α, the longitude β, and the distance D that define the virtual camera position with the maximum matching degree, and the roll angle γ corresponding to the deviation amount (the deviation amount γ1, the deviation amount γ2, or the deviation amount γ21) calculated by the first calculation unit 6113 or the second calculation unit 6124 for the virtual camera position with the maximum matching degree.

(15) In the first embodiment described above, the search processing unit 61 does not have to perform the first unit processing and the n-th unit processing. In this case, the search processing unit 61 may detect the virtual camera position detected by the second detection unit 6125 as the virtual camera position with the maximum matching degree. In other words, the virtual camera position detected by the second detection unit 6125 may be the virtual camera position with the maximum matching degree. More specifically, the virtual camera position detected first by the second detection unit 6125 may be the virtual camera position with the maximum matching degree. Then, for example, the search processing unit 61 may acquire, as a result of the search processing, the latitude α, the longitude β, and the distance D that define the virtual camera position with the maximum matching degree, and the roll angle γ corresponding to the deviation amount (the deviation amount γ1 or the deviation amount y2) calculated by the first calculation unit 6113 or the second calculation unit 6124 for the virtual camera position with the maximum matching degree.

(16) In the first embodiment described above, the search processing unit 61 may detect the virtual camera position with high matching degree P11m detected by the first detection unit 6114 as the virtual camera position with the maximum matching degree. In other words, the virtual camera position with high matching degree P11m detected by the first detection unit 6114 may be the virtual camera position with the maximum matching degree. Then, for example, the search processing unit 61 may acquire, as a result of the search processing, the latitude α, the longitude β, and the distance D that define the virtual camera position with the maximum matching degree, and the roll angle γ corresponding to the deviation amount γ1 calculated by the first calculation unit 6113 for the virtual camera position with the maximum matching degree.

(17) In the first embodiment described above, the M1×T1 first virtual camera positions P11 as the plurality of first virtual camera positions P11 are a plurality of virtual camera positions set by virtually setting one virtual camera position for each of the M1 virtual surfaces St1 in each of the T1 surface aggregations As1 in a case where the T1 surface aggregations As1 having mutually different distances from the reference point Po of the 3D model 3dm of the component to be searched are virtually set, but the present invention is not limited thereto. For example, instead of the T1 surface aggregations As1 being virtually set, the plurality of first virtual camera positions P11 may be located along the plurality of virtual spherical surfaces Sv1 surrounding the 3D model 3dm of the component to be searched centered around the reference point Po of the 3D model 3dm of the component to be searched, and may be a plurality of virtual camera positions corresponding to at least one initial setting range of one or more initial setting ranges for the component to be searched defined by the setting range information 58.

Here, for example, the search processing unit 61 may detect the virtual camera position with high matching degree P11m detected by the first detection unit 6114 of the first search processing unit 611 as the virtual camera position with the maximum matching degree. In other words, for example, in the search step, the search processing unit 61 may detect the virtual camera position with high matching degree P11m detected by the first detection unit 6114 as the virtual camera position with the maximum matching degree. In other words, the virtual camera position with high matching degree P11m detected by the first detection unit 6114 may be the virtual camera position with the maximum matching degree. From another point of view, in the search step, the virtual camera position with high matching degree P11m detected in the first detection step may be the virtual camera position with the maximum matching degree.

Furthermore, here, for example, the search processing unit 61 may further search for the virtual camera position with the maximum matching degree based on the virtual camera position with high matching degree P11m detected by the first detection unit 6114 of the first search processing unit 611. In this case, for example, instead of the M2×T2 second virtual camera positions P12 as the plurality of second virtual camera positions P12, a plurality of second virtual camera positions P12 located along the plurality of virtual spherical surfaces Sv1 surrounding the 3D model 3dm of the component to be searched centered around the reference point Po of the 3D model 3dm of the component to be searched and located near the virtual camera position with high matching degree P11m may be set. Here, for example, the search processing unit 61 may detect, as the virtual camera position with the maximum matching degree, the second virtual camera position P12 having the highest matching degree between the real shape information and the reference shape information among the plurality of second virtual camera positions P12 by the second detection unit 6125 of the second search processing unit 612. In other words, for example, in the search step, the search processing unit 61 may detect the second virtual camera position P12 detected by the second detection unit 6125 of the second search processing unit 612 as the virtual camera position with the maximum matching degree. In other words, the second virtual camera position P12 detected by the second detection unit 6125 of the second search processing unit 612 may be the virtual camera position with the maximum matching degree.

Furthermore, here, for example, the search processing unit 61 may further search for the virtual camera position with the maximum matching degree based on the second virtual camera position P12 detected by the second detection unit 6125 of the second search processing unit 612. In this case, for example, instead of the M3×T3 third virtual camera positions P13 as the plurality of third virtual camera positions P13, a plurality of third virtual camera positions P13 located along the plurality of virtual spherical surfaces Sv1 surrounding the 3D model 3dm of the component to be searched centered around the reference point Po of the 3D model 3dm of the component to be searched and located near the second virtual camera position P12 detected by the second detection unit 6125 may be set. Here, for example, the search processing unit 61 may detect, as the virtual camera position with the maximum matching degree, the third virtual camera position P13 having the highest matching degree between the real shape information and the reference shape information among the plurality of third virtual camera positions P13 by the second detection unit 6125 of the second search processing unit 612. In other words, for example, in the search step, the search processing unit 61 may detect the third virtual camera position P13 detected by the second detection unit 6125 of the second search processing unit 612 as the virtual camera position with the maximum matching degree. In other words, the third virtual camera position P13 detected by the second detection unit 6125 of the second search processing unit 612 may be the virtual camera position with the maximum matching degree. Here, for example, the search processing unit 61 may further search for the virtual camera position with the maximum matching degree based on the third virtual camera position P13 detected by the second detection unit 6125 of the second search processing unit 612.

(18) In the first embodiment described above, as a specific example of the setting range information 58, the setting range information 58 in a table format as indicated in FIG. 4 has been described, but the setting range information 58 is not limited to information in a table format as indicated in FIG. 4. For example, the setting range information 58 may be information having a file (also referred to as a parameter file) in which an initial setting range is described for each position of each target component or for each target component. In this case, the setting range information 58 may include, for example, a parameter file describing an initial setting range for the open position of the first chuck, a parameter file describing an initial setting range for the closed position of the first chuck, a parameter file describing an initial setting range for the open position of the second chuck, a parameter file describing an initial setting range for the closed position of the second chuck, and the like. Furthermore, the setting range information 58 may include, for example, a parameter file describing an initial setting range for the lowered position of the guard 23, a parameter file describing an initial setting range for the raised position of the guard 23, and the like. The setting range information 58 may include, for example, a parameter file describing an initial setting range for the standby position of the nozzle 33, a parameter file describing an initial setting range for the discharge position of the nozzle 33, and the like. The parameter file may include, for example, the first numerical range that is the range of the distance, the second numerical range that is the range of the latitude, and the third numerical range that is the range of the longitude. Furthermore, for example, the setting range information 58 may be information describing an initial setting range for each position of each target component or for each target component in the form of a relational database (RDB) that can be defined and operated by a database language such as structured query language (SQL).

(19) In the first embodiment described above, the first shape information acquisition unit 6112 acquires the reference shape information by generating the reference shape information for each of the plurality of first virtual camera positions P11 based on the three-dimensional design information regarding the target component stored in the storage unit 45b, or the like, but the present invention is not limited thereto. For example, the first shape information acquisition unit 6112 may read and acquire the reference shape information for each of the plurality of first virtual camera positions P11 generated in advance and stored in the storage unit 45b, or the like.

(20) In the first embodiment described above, for example, the first search processing unit 611 includes the congestion degree determination unit 6111, but the present invention is not limited thereto. For example, the first search processing unit 611 does not have to include the congestion degree determination unit 6111. In this case, for example, in the first calculation unit 6113 and the second calculation unit 6124, the entire edge image as the real shape information may be a calculation target for calculating the numerical value indicating the matching degree.

(21) In the first embodiment described above, for example, the second search processing unit 612 includes the collation target region setting unit 6121, but the present invention is not limited thereto. For example, the second search processing unit 612 does not have to include the collation target region setting unit 6121. In this case, for example, the comparison target region Re1 detected in the processing 1a may be set as the collation target region Re2.

(22) In the first embodiment described above, some or all of the functional processing units implemented by the arithmetic unit 45a may be configured by hardware such as a dedicated electronic circuit, for example.

(23) In the first embodiment described above, the substrate processing apparatus 1 is not limited to a substrate cleaning apparatus, and may be a substrate processing apparatus that processes the substrate W, such as a heat treatment apparatus, an exposure apparatus, an application and development apparatus, a measurement apparatus, or an inspection apparatus. In a case where the substrate processing apparatus 1 is a substrate cleaning apparatus, the substrate processing apparatus 1 may be a batch type substrate cleaning apparatus that collectively cleans a plurality of substrates W.

Note that it goes without saying that all or some of the components of the first embodiment and the various modifications can be combined as appropriate within a consistent range.

### EXPLANATION OF REFERENCE SIGNS

1: substrate processing apparatus
17: chuck moving mechanism
23: guard
25: guard moving mechanism
33, 33A, 33B: nozzle
35: nozzle moving mechanism
3dm: three-dimensional model (3D model)
45: control unit
45a: arithmetic unit
45b: storage unit
57: design information
58: setting range information
61: search processing unit
611: first search processing unit
6112: first shape information acquisition unit
6113: first calculation unit
6114: first detection unit
612: second search processing unit
6122: divided surface generation unit
6123: second shape information generation unit
6124: second calculation unit
6125: second detection unit
63: abnormality detection unit
9: chuck
As1: surface aggregation
CM: camera
Dr11: first direction
Dr12: second direction
Dr13: third direction
Ir1: real image
Ir3, Ir4: edge image
Iv1: reference image
Ln1, Ln11, Ln12, Ln13: line
P1: virtual camera position
P11: first virtual camera position
P11m: virtual camera position with high matching degree
P12: second virtual camera position
P13, P13a: third virtual camera position
Po: reference point
Ps1: first reference virtual camera position
Ps2: second reference virtual camera position
Ss1: first reference virtual divided surface
Ss2: second reference virtual divided surface
Stl: virtual surface
St1m: virtual surface with high matching degree
St2, St3, St3a: virtual divided surface
Sv1, Sv11, Sv12, Sv1T1: virtual spherical surface
W: substrate

## Claims

1. A substrate processing apparatus that processes a substrate, said substrate processing apparatus comprising:
one or more target components;
one or more imaging units that obtain, by imaging, a real image capturing a component to be searched that is one of said one or more target components;
a search processing unit that executes search processing of searching for a virtual camera position with a maximum matching degree having a highest matching degree between reference shape information and real shape information among a plurality of virtual camera positions, based on said reference shape information regarding a two-dimensional shape of a three-dimensional model in each of a plurality of virtual images that can be acquired by imaging said three-dimensional model of said component to be searched from said plurality of virtual camera positions, and said real shape information regarding a two-dimensional shape of an object in said real image, said reference shape information being generated based on three-dimensional design information regarding said component to be searched; and,
a storage unit that stores setting range information defining one or more initial setting ranges related to a virtual camera position set in advance for each of at least one target component among said one or more target components,
wherein
said search processing unit includes:
a first shape information acquisition unit that acquires said reference shape information generated, based on said three-dimensional design information and said setting range information, for each of a plurality of first virtual camera positions assuming a case where said three-dimensional model is imaged from each of said plurality of first virtual camera positions located along a plurality of virtual spherical surfaces surrounding said three-dimensional model centered around a reference point of said three-dimensional model and corresponding to at least one initial setting range of said one or more initial setting ranges for said component to be searched defined by said setting range information;
a first calculation unit that calculates, for each of said plurality of first virtual camera positions, a numerical value indicating a matching degree between said real shape information and said reference shape information; and
a first detection unit that detects a virtual camera position with high matching degree having a highest matching degree between said real shape information and said reference shape information among said plurality of first virtual camera positions based on a calculation result by said first calculation unit, and
said search processing unit searches for said virtual camera position with the maximum matching degree based on said virtual camera position with high matching degree detected by said first detection unit, or said virtual camera position with high matching degree is said virtual camera position with the maximum matching degree.

2. The substrate processing apparatus according to claim 1, wherein each of said one or more initial setting ranges includes a first numerical range that is a range of a distance from said reference point, a second numerical range that is a range of a latitude of a virtual spherical surface surrounding said three-dimensional model centered around said reference point, and a third numerical range that is a range of a longitude of the virtual spherical surface.

3. The substrate processing apparatus according to claim 2, wherein
said first shape information acquisition unit, assuming a case where said three-dimensional model is imaged from each of M1 ×T1 first virtual camera positions that are said plurality of first virtual camera positions set by virtually setting T1 (T1 is a natural number equal to or greater than 2) surface aggregations each including a plurality of virtual surfaces located along a virtual spherical surface surrounding said three-dimensional model centered around said reference point and having mutually different distances from said reference point according to said first numerical range in said at least one initial setting range and virtually setting one virtual camera position for each of M1 (M1 is a natural number equal to or greater than 2) virtual surfaces in each of said T1 surface aggregations corresponding to both of said second numerical range and said third numerical range in said at least one initial setting range, acquires said reference shape information generated for each of said M1×T1 first virtual camera positions based on said three-dimensional design information and said setting range information,
said first calculation unit calculates a numerical value indicating the matching degree between said real shape information and said reference shape information for each of said M1×T1 first virtual camera positions,
said first detection unit detects said virtual camera position with high matching degree that is a first virtual camera position having the highest matching degree between said real shape information and said reference shape information among said M1xT1 first virtual camera positions based on a calculation result by said first calculation unit,
said search processing unit includes:
a divided surface generation unit that divides, according to a same rule, each of T2 (T2 is a natural number equal to or greater than 2) virtual surfaces including a virtual surface with high matching degree which is a virtual surface in which said virtual camera position with high matching degree is virtually set and intersecting a line passing through said reference point and said virtual camera position with high matching degree on a side of said virtual camera position with high matching degree with respect to said reference point and having mutually different distances from said reference point, among said M1 virtual surfaces in each of said T1 surface aggregations to generate M2 (M2 is a natural number equal to or greater than 2) virtual divided surfaces for each of said T2 virtual surfaces, thereby generating M2×T2 virtual divided surfaces;
a second shape information generation unit that generates said reference shape information for each of M2×T2 second virtual camera positions assuming a case where said three-dimensional model is imaged from each of said M2×T2 second virtual camera positions that are M2×T2 virtual camera positions set by virtually setting one virtual camera position for each of said M2×T2 virtual divided surfaces based on said three-dimensional design information;
a second calculation unit that calculates a numerical value indicating a matching degree between said real shape information and said reference shape information for each of said M2×T2 second virtual camera positions; and
a second detection unit that detects a virtual camera position having a highest matching degree between said real shape information and said reference shape information among said virtual camera position with high matching degree and said M2×T2 second virtual camera positions, and
said search processing unit searches for said virtual camera position with the maximum matching degree based on said virtual camera position detected by said second detection unit, or said virtual camera position detected by said second detection unit is said virtual camera position with the maximum matching degree.

4. The substrate processing apparatus according to claim 3, wherein
said search processing unit executes one or more times of n-th unit processing (n is a natural number equal to or greater than 2) after executing first unit processing for said component to be searched,
said search processing unit sequentially performs first A processing, first B processing, first C processing, and first D processing in said first unit processing,
said first A processing is processing in which said divided surface generation unit divides, according to a same rule, each of first T3 virtual divided surfaces which are a plurality of virtual divided surfaces generated by dividing each of said T2 virtual surfaces, and which are T3 (T3 is a natural number equal to or greater than 2) virtual divided surfaces including a virtual divided surface including a first reference virtual camera position which is a virtual camera position detected first by said second detection unit, intersecting a line passing through said reference point and said first reference virtual camera position on a side of said first reference virtual camera position with respect to said reference point, and having mutually different distances from said reference point to generate first M3 virtual divided surfaces which are M3 (M3 is a natural number equal to or greater than 2) virtual divided surfaces for each of said first T3 virtual divided surfaces, thereby generating first M3×T3 virtual divided surfaces that are M3×T3 virtual divided surfaces,
said first B processing is processing in which said second shape information generation unit generates said reference shape information for each of first M3×T3 third virtual camera positions assuming a case where said three-dimensional model is imaged from each of said first M3×T3 third virtual camera positions that are M3×T3 virtual camera positions set by virtually setting one virtual camera position for each of said first M3×T3 virtual divided surfaces based on said three-dimensional design information,
said first C processing is processing in which said second calculation unit calculates a numerical value indicating a matching degree between said real shape information and said reference shape information for each of said first M3×T3 third virtual camera positions,
said first D processing is processing in which said second detection unit detects a second reference virtual camera position that is a virtual camera position having a highest matching degree between said real shape information and said reference shape information among said first reference virtual camera position and said first M3×T3 third virtual camera positions,
said search processing unit sequentially performs n-th A processing, n-th B processing, n-th C processing, and n-th D processing in each of said one or more times of the n-th unit processing,
said n-th A processing is processing in which said divided surface generation unit divides, according to a same rule, each of n-th T3 virtual divided surfaces which are a plurality of virtual divided surfaces generated by dividing each of (n-1)-th T3 virtual divided surfaces and which are T3 virtual divided surfaces including a virtual divided surface including an n-th reference virtual camera position which is a virtual camera position detected n-th by said second detection unit, intersecting a line passing through said reference point and said n-th reference virtual camera position on a side of said n-th reference virtual camera position with respect to said reference point, and having mutually different distances from said reference point to generate n-th M3 virtual divided surfaces which are M3 virtual divided surfaces for each of said n-th T3 virtual divided surfaces, thereby generating n-th M3×T3 virtual divided surfaces which are M3×T3 virtual divided surfaces,
said n-th B processing is processing in which said second shape information generation unit generates said reference shape information for each of n-th M3×T3 third virtual camera positions assuming a case where said three-dimensional model is imaged from each of said n-th M3×T3 third virtual camera positions which are M3×T3 virtual camera positions set by virtually setting one virtual camera position for each of said n-th M3×T3 virtual divided surfaces based on said three-dimensional design information,
said n-th C processing is processing in which said second calculation unit calculates a numerical value indicating a matching degree between said real shape information and said reference shape information for each of said n-th M3×T3 third virtual camera positions,
said n-th D processing is processing in which said second detection unit detects a virtual camera position having the highest matching degree between said real shape information and said reference shape information among said n-th reference virtual camera position and said n-th M3×T3 third virtual camera positions, and
a virtual camera position detected by said second detection unit in the last n-th D processing in said one or more times of the n-th unit processing is said virtual camera position with the maximum matching degree.

5. The substrate processing apparatus according to claim 4, wherein said search processing unit ends execution of said one or more times of the n-th unit processing in response to said second detection unit continuously detecting one reference virtual camera position among said first reference virtual camera position to said n-th reference virtual camera position a first predetermined number of times set in advance.

6. The substrate processing apparatus according to claim 4, wherein said search processing unit ends execution of said one or more times of the n-th unit processing in response to the n-th unit processing in said one or more times of the n-th unit processing being executed a second predetermined number of times set in advance.

7. The substrate processing apparatus according to any one of claims 3 to 6, wherein said same rule includes a rule of dividing a division target surface into a plurality of surfaces by a plurality of line segments respectively connecting a center point of said division target surface to be divided and all vertices of the division target surface.

8. The substrate processing apparatus according to any one of claims 3 to 6, wherein
each of said plurality of virtual surfaces is a triangular surface, and
each of said T1 surface aggregations is a polyhedron constituted with a plurality of triangular surfaces.

9. The substrate processing apparatus according to claim 8, wherein said divided surface generation unit divides said virtual surface with high matching degree into three virtual divided surfaces as said M2 virtual divided surfaces by three line segments connecting each of three vertices in said virtual surface with high matching degree and said virtual camera position with high matching degree.

10. The substrate processing apparatus according to any one of claims 1 to 6, further comprising a moving mechanism that moves said component to be searched between a first position and a second position,
wherein
said one or more initial setting ranges include a first initial setting range for said first position, and
said search processing unit, at a timing when said component to be searched is located at said first position by said moving mechanism,
acquires, by said first shape information acquisition unit, said reference shape information generated for each of said plurality of first virtual camera positions corresponding to said first initial setting range assuming a case where said three-dimensional model is imaged from each of said plurality of first virtual camera positions corresponding to said first initial setting range that is said at least one initial setting range based on said three-dimensional design information and said setting range information,
calculates, by said first calculation unit, for each of said plurality of first virtual camera positions corresponding to said first initial setting range, a numerical value indicating a matching degree between said reference shape information and said real shape information related to said real image obtained by imaging by said one or more imaging units at a timing when said component to be searched is located at said first position by said moving mechanism, and
detects, by said first detection unit, said virtual camera position with high matching degree having the highest matching degree between said real shape information and said reference shape information among said plurality of first virtual camera positions corresponding to said first initial setting range based on a calculation result by said first calculation unit.

11. The substrate processing apparatus according to claim 10, wherein
said one or more initial setting ranges further include a second initial setting range for said second position, and
said search processing unit, at a timing when said component to be searched is located at said second position by said moving mechanism,
acquires, by said first shape information acquisition unit, said reference shape information generated for each of said plurality of first virtual camera positions corresponding to said second initial setting range assuming a case where said three-dimensional model is imaged from each of said plurality of first virtual camera positions corresponding to said second initial setting range that is said at least one initial setting range based on said three-dimensional design information and said setting range information,
calculates, by said first calculation unit, for each of said plurality of first virtual camera positions corresponding to said second initial setting range, a numerical value indicating a matching degree between said reference shape information and said real shape information related to said real image obtained by imaging by said one or more imaging units at a timing when said component to be searched is located at said second position by said moving mechanism, and
detects, by said first detection unit, said virtual camera position with high matching degree having the highest matching degree between said real shape information and said reference shape information among said plurality of first virtual camera positions corresponding to said second initial setting range based on a calculation result by said first calculation unit.

12. The substrate processing apparatus according to claim 10, further comprising an abnormality detection unit that detects an abnormality of said component to be searched if a matching degree between said reference shape information and said real shape information for said virtual camera position with the maximum matching degree detected by said search processing unit is lower than a predetermined matching degree set in advance.

13. The substrate processing apparatus according to claim 10, wherein
said one or more initial setting ranges further include a second initial setting range for said second position,
said search processing unit, at a timing when said component to be searched is located at said first position by said moving mechanism,
acquires, by said first shape information acquisition unit, said reference shape information generated for each of said plurality of first virtual camera positions corresponding to both said first initial setting range and said second initial setting range assuming a case where said three-dimensional model is imaged from each of said plurality of first virtual camera positions corresponding to both said first initial setting range and said second initial setting range that are said at least one initial setting range based on said three-dimensional design information and said setting range information,
calculates, by said first calculation unit, for each of said plurality of first virtual camera positions corresponding to both said first initial setting range and said second initial setting range, a numerical value indicating a matching degree between said reference shape information and said real shape information related to said real image obtained by imaging by said one or more imaging units at a timing when said component to be searched is located at said first position by said moving mechanism, and
detects, by said first detection unit, said virtual camera position with high matching degree having the highest matching degree between said real shape information and said reference shape information among said plurality of first virtual camera positions corresponding to both said first initial setting range and said second initial setting range based on a calculation result by said first calculation unit, and
said substrate processing apparatus further comprises an abnormality detection unit that detects, at a timing when said component to be searched is located at said first position by said moving mechanism, an abnormality of said component to be searched if said virtual camera position with the maximum matching degree is a position belonging to said second initial setting range.

14. The substrate processing apparatus according to any one of claims 1 to 6, further comprising an abnormality detection unit that detects an abnormality of said component to be searched by comparing reality information related to a posture of said component to be searched recognized based on said virtual camera position with the maximum matching degree and normal information related to a posture of said component to be searched based on said three-dimensional design information in a case where a state of said component to be searched is normal.

15. The substrate processing apparatus according to any one of claims 1 to 6, wherein
said one or more target components include two or more target components, and
said at least one target component includes said two or more target components.

16. An information processing method in a substrate processing apparatus including one or more target components, the information processing method comprising:
a storage step of storing setting range information defining one or more initial setting ranges related to a virtual camera position set in advance for each of at least one target component among said one or more target components in a storage unit;
an imaging step of obtaining a real image capturing a component to be searched that is any one target component among said one or more target components by imaging by an imaging unit; and
a search step of executing search processing of, based on reference shape information regarding a two-dimensional shape of a three-dimensional model in each of a plurality of virtual images that can be acquired by imaging said three-dimensional model of said component to be searched from a plurality of virtual camera positions, and real shape information regarding a two-dimensional shape of an object in said real image obtained in said imaging step, said reference shape information being generated based on three-dimensional design information regarding said component to be searched, searching for a virtual camera position with a maximum matching degree having a highest matching degree between said reference shape information and said real shape information among said plurality of virtual camera positions by an arithmetic unit,
wherein
said search step includes:
a first shape information acquisition step of acquiring said reference shape information generated for each of a plurality of first virtual camera positions assuming a case where said three-dimensional model is imaged from each of said plurality of first virtual camera positions located along a plurality of virtual spherical surfaces surrounding said three-dimensional model centered around a reference point of said three-dimensional model and corresponding to at least one initial setting range among said one or more initial setting ranges for said component to be searched defined by said setting range information based on said three-dimensional design information and said setting range information;
a first calculation step of calculating a numerical value indicating a matching degree between said real shape information and said reference shape information acquired for each of said plurality of first virtual camera positions in said first shape information acquisition step; and
a first detection step of detecting a virtual camera position with high matching degree having a highest matching degree between said real shape information and said reference shape information among said plurality of first virtual camera positions based on a calculation result in said first calculation step, and
in said search step, said virtual camera position with the maximum matching degree is searched for based on said virtual camera position with high matching degree detected in said first detection step, or said virtual camera position with high matching degree is said virtual camera position with the maximum matching degree.
